# EUROPEAN PATENT APPLICATION

(11) **EP 4 362 266 A1**
(43) Date of publication of application: **01.05.2024**
(21) Application number: 22848651.0
(22) Date of filing: 28.07.2022
(51) Int. Cl.: H02J 7/00, H01L 23/02, H05K 1/18

(54) **CHARGING PROTECTION CIRCUIT, DRIVING METHOD, CHIP, ENCAPSULATION STRUCTURE AND ELECTRONIC DEVICE**

(30) Priority: 29.07.2021 CN 202110867195
(71) Applicant: Huawei Technologies Co., Ltd., Longgang Shenzhen, Guangdong 518129 (CN)
(72) Inventor: ZHANG, Dongliang, Shenzhen, Guangdong 518129 (CN); ZHU, Jianyun, Shenzhen, Guangdong 518129 (CN); WANG, Hang, Shenzhen, Guangdong 518129 (CN); JIANG, Mingwei, Shenzhen, Guangdong 518129 (CN)
(74) Representative: Pfenning, Meinig & Partner mbB
(86) International application number: PCT/CN2022/108745
(87) International publication number: WO 2023/006046

(57) **Abstract**

Embodiments of this application relate to the field of power supply system technologies, and provide a charging protection circuit, a driving method, a chip, a package structure, and an electronic device, to provide a charging protection circuit with stable bi-directional protection effect. The charging protection circuit includes a first switching transistor and a pull-up circuit. For example, the first switching transistor is a bi-directional HEMTs device, and includes a first drain electrode, a second drain electrode, a first gate electrode, and a substrate electrode. The first drain electrode is configured to receive a signal from the second drain electrode, the second drain electrode is configured to receive a signal from the first drain electrode, and the first gate electrode is configured to control the first switching transistor to be turned on or turned off. The pull-up circuit is configured to: when the first switching transistor is turned on, adjust a potential of the substrate electrode to a high potential, to ensure that a turn-on characteristic of the first switching transistor is not affected.

## Description

This application claims priority to Chinese Patent Application No. 202110867195.X, filed with the China National Intellectual Property Administration on July 29, 2021 and entitled "CHARGING PROTECTION CIRCUIT, DRIVING METHOD, CHIP, PACKAGE STRUCTURE, AND ELECTRONIC DEVICE", which is incorporated herein by reference in its entirety.

### TECHNICAL FIELD

This application relates to the field of power supply system technologies, and in particular, to a charging protection circuit, a driving method, a chip, a package structure, and an electronic device.

### BACKGROUND

With continuous development of electronic technologies, a charging technology of an electronic device is also continuously innovated. A charging circuit is used as an example. To meet different requirements, an existing charging circuit can implement both wired power supply and wireless charging, and support both uni-directional charging and bi-directional charging. Therefore, a charging protection circuit in the charging circuit is required to be a power device with a bi-directional blocking function, so as to perform bi-directional protection (over voltage protection, OVP) in two different directions on a device coupled to a load end or a device coupled to a power supply end.

For example, during wired charging, when a voltage of the power supply end is unstable, over-voltage protection can be performed on the device coupled to the load end. During wireless charging, current backflow on a port coupled to the power supply end is prevented. Alternatively, for example, during forward charging, when a voltage of the power supply end is unstable, over-voltage protection can be performed on the device coupled to the load end. During reverse discharging, when a voltage of the load end is relatively high, over-voltage protection can be performed on the device coupled to the power supply end.

Therefore, how to perform stable bi-directional protection on the device coupled to the load end or the device coupled to the power supply end in a charging process becomes a key problem of research by persons skilled in the art.

### SUMMARY

Embodiments of this application provide a charging protection circuit, a driving method, a chip, a package structure, and an electronic device, to provide a charging protection circuit with stable bi-directional protection effect.

To achieve the foregoing objective, the following technical solutions are used in this application.

According to a first aspect of embodiments of this application, a charging protection circuit is provided. The charging protection circuit herein may be understood as a bi-directional protection circuit. When being applied to an upper-end charging circuit, the charging protection circuit may perform over-voltage protection on devices coupled to a power supply end and a load end of the charging circuit. The charging protection circuit includes a first switching transistor and a pull-up circuit. The first switching transistor includes a first drain electrode, a second drain electrode, a first gate electrode, and a substrate electrode. The first gate electrode is configured to control the first switching transistor to be turned on or off, the first drain electrode is configured to receive a signal from the second drain electrode, and the second drain electrode is configured to receive a signal from the first drain electrode. In other words, the first switching transistor is a bi-directional switching transistor. The pull-up circuit is coupled to the first gate electrode and the substrate electrode, and is configured to: when the first switching transistor is turned on, adjust a potential of the substrate electrode to a threshold (for example, the threshold is any potential between a half potential of the first drain electrode and a potential of the first gate electrode), to ensure a turn-on characteristic of the first switching transistor.

When the first switching transistor is turned on, if the potential of the substrate electrode is low relative to the first drain electrode and the second drain electrode, back-gate effect causes an increase of a turn-on resistance of the first switching transistor, and consequently performance of the first switching transistor is degraded. Therefore, according to the charging protection circuit provided in this embodiment of this application, the pull-up circuit is disposed between the first gate electrode and the substrate electrode. When the first switching transistor is turned on, a voltage bias between the first gate electrode and the substrate electrode is an expected potential, so that the potential of the substrate electrode is adjusted to the threshold (for example, equal to or approximately equal to potentials of the first drain electrode and the second drain electrode). This can avoid a phenomenon that the turn-on resistance is increased due to the back-gate effect caused by charge storage of the substrate electrode, and ensure that the turn-on characteristic of the first switching transistor is not affected. In addition, the first switching transistor in this example is a single-gate bi-directional conduction device, and has a small cell size. The single-gate bi-directional conduction device has a smaller characteristic resistance compared with a dual-gate bi-directional conduction device.

In some embodiments, the charging protection circuit further includes a pull-down circuit. The pull-down circuit is coupled to the substrate electrode and a fixed signal end, and is configured to: when the first switching transistor is turned off, adjust the potential of the substrate electrode to a potential of the fixed signal end or a potential between the first gate electrode and the fixed signal end. In other words, when the first switching transistor is turned off, the pull-down circuit adjusts the potential of the substrate electrode to a low potential. The potential of the fixed signal end is less than or equal to a lower potential of the first drain electrode and the second drain electrode during turn-off of the first switching transistor.

When the first switching transistor is turned off, if the potential of the substrate electrode is high relative to the first drain electrode and the second drain electrode, for example, VSub - VD2 > 0 V, the substrate electrode induces a positive charge, which causes a narrower width of a depletion region at a channel. As a result, channel punch-through easily occurs in the first switching transistor at a low voltage, and consequently a breakdown voltage capability is insufficient. Therefore, according to the charging protection circuit provided in this embodiment of this application, the pull-down circuit is disposed between the substrate electrode and the fixed signal end. When the first switching transistor is turned off, on one hand, a voltage of the first gate electrode gradually decreases, and the potential of the substrate electrode decreases with the potential of the first gate electrode. On the other hand, the pull-up circuit enables the first gate electrode to be approximately open-circuited to the substrate electrode, and the pull-down circuit enables the substrate electrode to be approximately short-circuited to the fixed signal end, to adjust the potential of the substrate electrode to be approximately equal to the potential of the fixed signal end (for example, a reference ground end) or the potential between the first gate electrode and the fixed signal end, so that a breakdown characteristic of the first switching transistor is not affected at all, and it is ensured that a breakdown voltage characteristic of the first switching transistor is not affected.

In some embodiments, the pull-up circuit includes a first resistor. A first end of the first resistor is coupled to the first gate electrode, and a second end of the first resistor is coupled to the substrate electrode. By using a voltage division principle of the resistor, when the first switching transistor is turned on, a voltage bias between the first gate electrode and the substrate electrode is an expected potential. The structure is simple, is easy to implement, and has low costs.

In some embodiments, the pull-up circuit includes a clamping diode. A first end of the clamping diode is coupled to the first gate electrode, and a second end of the clamping diode is coupled to the substrate electrode. By using a clamping voltage drop during turn-on of the clamping diode, when the first switching transistor is turned on, a voltage bias between the first gate electrode and the substrate electrode is an expected potential, which is easy to implement and low in costs.

In some embodiments, the first end of the clamping diode is an anode, and the second end of the clamping diode is a cathode. The clamping diode is a PN diode, a Schottky barrier diode, or an equivalent diode formed by short-circuiting a source electrode and a gate electrode in a transistor.

In some embodiments, the first end of the clamping diode is a cathode, the second end of the clamping diode is an anode, and the clamping diode is a Zener diode.

In some embodiments, the pull-up circuit includes multiple clamping diodes connected in series. In this way, a clamping voltage of the clamping diode may be adjusted by adjusting a structure of the clamping diode, or a clamping voltage of the clamping diode may be adjusted by adjusting a quantity of clamping diodes, to meet various application requirements.

In some embodiments, the pull-up circuit further includes a second switching transistor. A second gate electrode of the second switching transistor is coupled to the first gate electrode, a first electrode of the second switching transistor is coupled to the second end of the first resistor or the second end of the clamping diode, and a second electrode of the second switching transistor is coupled to the substrate electrode. The second switching transistor is disposed in the pull-up circuit, and when the first switching transistor is turned off, the second switching transistor is also turned off. In this case, when the second switching transistor is turned off, an impedance of the second switching transistor is far greater than an impedance of the pull-down circuit 23, and the potential of the substrate electrode may be adjusted to the potential of the fixed signal end (which is far less than the lower potential of the first drain electrode and the second drain electrode). This may ensure that the breakdown characteristic and the breakdown voltage characteristic of the first switching transistor are not affected.

In some embodiments, the pull-down circuit includes a second resistor. A first end of the second resistor is coupled to the substrate electrode, and a second end of the second resistor is coupled to the fixed signal end. By using a voltage division principle of the resistor, when the first switching transistor is turned off, the substrate electrode is approximately short-circuited to the fixed signal end. The structure is simple, easy to implement, and low in costs.

In some embodiments, the first switching transistor is a high electron mobility transistor. The high electron mobility transistor has a larger band gap width, a higher breakdown field strength and a higher electron saturation rate.

In some embodiments, the first switching transistor is a metal oxide semiconductor transistor. The metal oxide semiconductor transistor is simple in structure.

In some embodiments, the second switching transistor is a high electron mobility transistor. The high electron mobility transistor has a larger band gap width, a higher breakdown field strength and a higher electron saturation rate.

In some embodiments, the second switching transistor is a metal oxide semiconductor transistor. The metal oxide semiconductor transistor is simple in structure.

In some embodiments, the first switching transistor and the second switching transistor share the same substrate electrode. In this way, integration of the charging protection circuit may be improved.

In some embodiments, the first resistor is integrated onto the substrate electrode. In this way, integration of the charging protection circuit may be improved.

In some embodiments, the second resistor is integrated onto the substrate electrode. In this way, integration of the charging protection circuit may be improved.

According to a second aspect of embodiments of this application, a method for driving a charging protection circuit is provided. The charging protection circuit includes a first switching transistor and a pull-up circuit. The first switching transistor includes a first drain electrode, a second drain electrode, a first gate electrode, and a substrate electrode. The pull-up circuit is coupled to the first gate electrode and the substrate electrode. The method for driving the charging protection circuit includes: The first switching transistor is turned on under control of the first gate electrode, and the first drain electrode receives a signal from the second drain electrode, or the second drain electrode receives a signal from the first drain electrode; and after the first switching transistor is turned on, the pull-up circuit adjusts a potential of the substrate electrode to a threshold. The threshold is any potential between a half potential of the first drain electrode and a potential of the first gate electrode.

When the first switching transistor is turned on, if the potential of the substrate electrode is low relative to the first drain electrode and the second drain electrode, back-gate effect causes an increase of a turn-on resistance of the first switching transistor, and consequently performance of the first switching transistor is degraded. Therefore, according to the charging protection circuit provided in this embodiment of this application, the pull-up circuit is disposed between the first gate electrode and the substrate electrode. When the first switching transistor is turned on, the potential of the substrate electrode is adjusted to the threshold (for example, equal to or approximately equal to potentials of the first drain electrode and the second drain electrode). This can avoid a phenomenon that the turn-on resistance is increased due to the back-gate effect caused by charge storage of the substrate electrode, and ensure that a turn-on characteristic of the first switching transistor is not affected.

In some embodiments, the charging protection circuit further includes a pull-down circuit. The pull-down circuit is coupled to the substrate electrode and a fixed signal end. The method for driving the charging protection circuit further includes: The first switching transistor is turned off under control of the first gate electrode, and after the first switching transistor is turned off, the pull-down circuit adjusts the potential of the substrate electrode to a potential of the fixed signal end or a potential between the first gate electrode and the fixed signal end. The potential of the fixed signal end is less than or equal to a lower potential of the first drain electrode and the second drain electrode during turn-off of the first switching transistor.

When the first switching transistor is turned off, if the potential of the substrate electrode is high relative to the first drain electrode and the second drain electrode, for example, VSub - VD2 > 0 V, the substrate electrode induces a positive charge, which causes a narrower width of a depletion region at a channel. As a result, channel punch-through easily occurs in the first switching transistor at a low voltage, and consequently a breakdown voltage capability is insufficient. Therefore, according to the charging protection circuit provided in this embodiment of this application, the pull-down circuit is disposed between the substrate electrode and the fixed signal end. When the first switching transistor is turned off, on one hand, a voltage of the first gate electrode gradually decreases, and the potential of the substrate electrode decreases with the potential of the first gate electrode. On the other hand, the pull-up circuit enables the first gate electrode to be approximately open-circuited to the substrate electrode, and the pull-down circuit enables the substrate electrode to be approximately short-circuited to the fixed signal end, to adjust the potential of the substrate electrode to be approximately equal to the potential of the fixed signal end (for example, a reference ground end) or the potential between the first gate electrode and the fixed signal end, so that a breakdown characteristic of the first switching transistor is not affected at all, and it is ensured that a breakdown voltage characteristic of the first switching transistor is not affected.

In some embodiments, the pull-up circuit includes a first resistor, and the pull-down circuit includes a second resistor. That the pull-up circuit adjusts a potential of the substrate electrode to a threshold includes: The first gate electrode controls the first switching transistor to be turned on (in this case, the potential of the first gate electrode is a potential for controlling the switching transistor to be turned on), and the potential of the substrate electrode is adjusted to the threshold by the voltage division action of the first resistor and the second resistor. That the pull-down circuit adjusts the potential of the substrate electrode to a potential between the first gate electrode and the fixed signal end includes: The first gate electrode controls the first switching transistor to be turned off (in this case, the potential of the first gate electrode is a potential for controlling the switching transistor to be turned off), and the potential of the substrate electrode is adjusted to the potential between the first gate electrode and the fixed signal end by the voltage division action of the first resistor and the second resistor.

In some embodiments, the pull-up circuit includes a first resistor and a second switching transistor, and the pull-down circuit includes a second resistor. That the pull-up circuit adjusts a potential of the substrate electrode to a threshold includes: The first gate electrode controls the first switching transistor to be turned on (in this case, the potential of the first gate electrode is a potential for controlling the switching transistor to be turned on), a second gate electrode controls the second switching transistor to be turned on, and the potential of the substrate electrode is adjusted to the threshold by the voltage division action of the first resistor and the second resistor. That the pull-down circuit adjusts the potential of the substrate electrode to a potential of the fixed signal end includes: The first gate electrode controls the first switching transistor to be turned off (in this case, the potential of the first gate electrode is a potential for controlling the switching transistor to be turned off), the second gate electrode controls the second switching transistor to be turned off, and the potential of the substrate electrode is adjusted to the potential of the fixed signal end by the voltage division action of the first resistor, the second switching transistor, and the second resistor.

In some embodiments, the pull-up circuit includes a clamping diode, and the pull-down circuit includes a second resistor. That the pull-up circuit adjusts a potential of the substrate electrode to a threshold includes: The first gate electrode controls the first switching transistor to be turned on (in this case, the potential of the first gate electrode is a potential for controlling the switching transistor to be turned on), the clamping diode is turned on, and the potential of the substrate electrode is adjusted to the threshold. That the pull-down circuit adjusts the potential of the substrate electrode to a potential between the first gate electrode and the fixed signal end includes: The first gate electrode controls the first switching transistor to be turned off (in this case, the potential of the first gate electrode is a potential for controlling the switching transistor to be turned off), and the potential of the substrate electrode is adjusted to the potential between the first gate electrode and the fixed signal end by the voltage division action of the clamping diode and the second resistor.

In some embodiments, the pull-up circuit includes a clamping diode and a second switching transistor, and the pull-down circuit includes a second resistor. That the pull-up circuit adjusts a potential of the substrate electrode to a threshold includes: The first gate electrode controls the first switching transistor to be turned on (in this case, the potential of the first gate electrode is a potential for controlling the switching transistor to be turned on), a second gate electrode controls the second switching transistor to be turned on, the clamping diode is turned on, and the potential of the substrate electrode is adjusted to the threshold. That the pull-down circuit adjusts the potential of the substrate electrode to a potential of the fixed signal end includes: The first gate electrode controls the first switching transistor to be turned off, the second gate electrode controls the second switching transistor to be turned off, and the potential of the substrate electrode is adjusted to the potential of the fixed signal end by the voltage division action of the clamping diode, the second switching transistor, and the second resistor.

According to a third aspect of embodiments of this application, a charging protection circuit is provided. The charging protection circuit herein may be understood as a bi-directional protection circuit. When being applied to an upper-end charging circuit, the charging protection circuit may perform over-voltage protection on devices coupled to a power supply end and a load end of the charging circuit. The charging protection circuit includes a first switching transistor, which includes a first drain electrode, a second drain electrode, a first gate electrode, and a substrate electrode. The first drain electrode is configured to receive a signal from the second drain electrode, and the second drain electrode is configured to receive a signal from the first drain electrode. In other words, the first switching transistor is a bi-directional switching transistor. The charging protection circuit further includes a bi-directional circuit, coupled to the first drain electrode, the second drain electrode, and the substrate electrode, and configured to: when the first switching transistor is turned on, adjust a potential of the substrate electrode to a potential between the first drain electrode and the second drain electrode; and when the first switching transistor is turned off, adjust the potential of the substrate electrode to a lower potential of the first drain electrode and the second drain electrode.

When the first switching transistor is turned on, if the potential of the substrate electrode is low relative to the first drain electrode and the second drain electrode, back-gate effect causes an increase of a turn-on resistance of the first switching transistor, and consequently performance of the first switching transistor is degraded. When the first switching transistor is turned off, if the potential of the substrate electrode is high relative to the first drain electrode and the second drain electrode, for example, VSub - VD2 > 0 V, the substrate electrode induces a positive charge, which causes a narrower width of a depletion region at a channel. As a result, channel punch-through easily occurs in the first switching transistor at a low voltage, and consequently a breakdown voltage capability is insufficient. Therefore, the charging protection circuit provided in this embodiment of this application includes the bi-directional circuit. The bi-directional circuit is coupled to the substrate electrode. The bi-directional circuit includes a transistor such as a HEMTs device or a MOSFET device, and is configured to adjust the potential of the substrate electrode. When the first switching transistor is turned on, the potential of the substrate electrode is adjusted to be approximately equal to a potential of the first drain electrode. This can avoid a phenomenon that the turn-on resistance is degraded due to the back-gate effect caused by charge storage of the substrate electrode. When the first switching transistor is turned off, the potential of the substrate electrode is adjusted to be approximately equal to the lower potential of the first drain electrode and the second drain electrode, so that a breakdown characteristic of the first switching transistor is not affected at all, and it is ensured that a breakdown voltage characteristic of the first switching transistor is not affected. In addition, the first switching transistor in this example is a single-gate bi-directional conduction device, and has a small cell size. The single-gate bi-directional conduction device has a smaller characteristic resistance compared with a dual-gate bi-directional conduction device.

In some embodiments, the bi-directional circuit includes a third switching transistor and a fourth switching transistor. A third gate electrode of the third switching transistor is configured to control turn-on or turn-off of the third switching transistor. A first electrode of the third switching transistor is coupled to the first drain electrode, and a second electrode of the third switching transistor is coupled to the substrate electrode. A fourth gate electrode of the fourth switching transistor is configured to control turn-on or turn-off of the fourth switching transistor. A first electrode of the fourth switching transistor is coupled to the second drain electrode, and a second electrode of the fourth switching transistor is coupled to the substrate electrode.

The third switching transistor and the fourth switching transistor are used as pull-up and pull-down switches. When the first switching transistor is turned on, resistances of the third switching transistor and the fourth switching transistor are relatively small, and the potential of the substrate electrode can be quickly pulled up to a high potential. When the first switching transistor is turned off, the resistances of the third switching transistor and the fourth switching transistor are equivalent to infinity, which has little impact on a turn-off leakage current, thereby resolving a problem of a turn-off leakage current when resistors are used as a pull-up circuit and a pull-down circuit.

In some embodiments, both the third gate electrode and the fourth gate electrode are coupled to the first gate electrode. Both the third gate electrode and the fourth gate electrode are coupled to the first gate electrode, and the three gate electrodes receive a same control signal, so that a structure of the charging protection circuit may be simplified, and a requirement on a drive circuit used to provide a control signal for the charging protection circuit is reduced.

In some embodiments, the first switching transistor, the third switching transistor, and the fourth switching transistor each are a high electron mobility transistor, and the first switching transistor, the third switching transistor, and the fourth switching transistor share a same substrate. In this way, integration of the first switching transistor, the third switching transistor, and the fourth switching transistor may be improved, so that an area of the charging protection circuit is reduced.

According to a fourth aspect of embodiments of this application, a method for driving a charging protection circuit is provided. The charging protection circuit includes a first switching transistor and a bi-directional circuit. The first switching transistor includes a first drain electrode, a second drain electrode, a first gate electrode, and a substrate electrode. The bi-directional circuit is coupled to the first drain electrode, the second drain electrode, and the substrate electrode. The method for driving the charging protection circuit includes: The first switching transistor is turned on under control of the first gate electrode, and the first drain electrode receives a signal from the second drain electrode, or the second drain electrode receives a signal from the first drain electrode; and after the first switching transistor is turned on, the bi-directional circuit adjusted a potential of the substrate electrode to a potential between the first drain electrode and the second drain electrode; and the first switching transistor is turned off under control of the first gate electrode, and after the first switching transistor is turned off, the bi-directional circuit adjusts the potential of the substrate electrode to a lower potential of the first drain electrode and the second drain electrode.

When the first switching transistor is turned on, if the potential of the substrate electrode is low relative to the first drain electrode and the second drain electrode, back-gate effect causes an increase of a turn-on resistance of the first switching transistor, and consequently performance of the first switching transistor is degraded. When the first switching transistor is turned off, if the potential of the substrate electrode is high relative to the first drain electrode and the second drain electrode, for example, VSub - VD2 > 0 V, the substrate electrode induces a positive charge, which causes a narrower width of a depletion region at a channel. As a result, channel punch-through easily occurs in the first switching transistor at a low voltage, and consequently a breakdown voltage capability is insufficient. Therefore, the charging protection circuit provided in this embodiment of this application includes the bi-directional circuit. The bi-directional circuit is coupled to the substrate electrode. The bi-directional circuit includes a transistor such as a HEMTs device or a MOSFET device, and is configured to adjust the potential of the substrate electrode. When the first switching transistor is turned on, the potential of the substrate electrode is adjusted to be approximately equal to a potential of the first drain electrode. This can avoid a phenomenon that the turn-on resistance is degraded due to the back-gate effect caused by charge storage of the substrate electrode. When the first switching transistor is turned off, the potential of the substrate electrode is adjusted to be approximately equal to the lower potential of the first drain electrode and the second drain electrode, so that a breakdown characteristic of the first switching transistor is not affected at all, and it is ensured that the breakdown voltage characteristic of the first switching transistor is not affected.

In some embodiments, the bi-directional circuit includes a third switching transistor and a fourth switching transistor. That the bi-directional circuit adjusts a potential of the substrate electrode to a potential between the first drain electrode and the second drain electrode includes: The third switching transistor is turned on under control of the third gate electrode, the fourth switching transistor is turned on under control of the fourth gate electrode, and the potential of the substrate electrode is adjusted to the potential between the first drain electrode and the second drain electrode by the voltage division action of the third switching transistor and the fourth switching transistor. That the bi-directional circuit adjusts the potential of the substrate electrode to a potential of the second drain electrode includes: The third switching transistor is turned off under control of the third gate electrode, the fourth switching transistor is turned off under control of the fourth gate electrode, and the potential of the substrate electrode is adjusted to the lower potential of the first drain electrode and the second drain electrode by the voltage division action of the third switching transistor and the fourth switching transistor.

The third switching transistor and the fourth switching transistor are used as pull-up and pull-down switches. When the first switching transistor is turned on, resistances of the third switching transistor and the fourth switching transistor are relatively small, and the potential of the substrate electrode can be quickly pulled up to a high potential. When the first switching transistor is turned off, the resistances of the third switching transistor and the fourth switching transistor are equivalent to infinity, which has little impact on a turn-off leakage current, thereby resolving a problem of a turn-off leakage current when resistors are used as a pull-up circuit and a pull-down circuit.

According to a fifth aspect of embodiments of this application, a charging protection circuit is provided. The charging protection circuit herein may be understood as a bi-directional protection circuit. When being applied to an upper-end charging circuit, the charging protection circuit may perform over-voltage protection on devices coupled to a power supply end and a load end of the charging circuit. The charging protection circuit includes a high electron mobility transistor, which includes a first drain electrode, a second drain electrode, a first gate electrode, and a substrate electrode, where the first drain electrode is configured to receive a signal from the second drain electrode, the second drain electrode is configured to receive a signal from the first drain electrode, and the first gate electrode is configured to control the high electron mobility transistor to be turned on or turned off; a pull-up circuit, where the pull-up circuit includes a fifth switching transistor, a fifth gate electrode of the fifth switching transistor is configured to control turn-on or turn-off of the fifth switching transistor, a first electrode of the fifth switching transistor is coupled to the second drain electrode, and a second electrode of the fifth switching transistor is coupled to the substrate electrode; and a pull-down circuit, coupled to a fixed signal end and the substrate electrode, and configured to pull down a potential of the substrate electrode to a potential of the fixed signal end when the high electron mobility transistor is turned off. The potential of the fixed signal end is less than or equal to a lower potential of the first drain electrode and the second drain electrode. The high electron mobility transistor and the fifth switching transistor share a same substrate.

When the high electron mobility transistor is turned on, if the potential of the substrate electrode is low relative to the first drain electrode and the second drain electrode, back-gate effect causes an increase in a turn-on resistance of the high electron mobility transistor, and consequently performance of the high electron mobility transistor is degraded. When the high electron mobility transistor is turned off, if the potential of the substrate electrode is high relative to the first drain electrode and the second drain electrode, for example, VSub - VD2 > 0 V, the substrate electrode induces a positive charge, which causes a narrower width of a depletion region at a channel. As a result, channel punch-through easily occurs in the high electron mobility transistor at a low voltage, and consequently a breakdown voltage capability is insufficient. Therefore, the charging protection circuit provided in this embodiment of this application includes the pull-up circuit and the pull-down circuit. When the high electron mobility transistor is turned on, the pull-down circuit enables the substrate electrode to be open-circuited to the fixed signal end, and the pull-up circuit enables the first drain electrode and/or the second drain electrode to be approximately short-circuited to the substrate electrode, to adjust the potential of the substrate electrode to be equal to or approximately equal to a potential of the second drain electrode. This can avoid a phenomenon that the turn-on resistance is degraded due to the back-gate effect caused by charge storage of the substrate electrode. The pull-down circuit is coupled to a reference ground end. When the high electron mobility transistor is turned off, the pull-up circuit enables the first drain electrode and/or the second drain electrode to be open-circuited to the substrate electrode, and the pull-down circuit enables the substrate electrode to be approximately short-circuited to the fixed signal end, so that the potential of the substrate electrode may be adjusted to be approximately equal to a potential of the reference ground end, to ensure that the breakdown characteristic of the high electron mobility transistor is not affected at all. In addition, a bi-directional HEMTs device prepared by using GaN, Ga₂O₃, or GaAs is used as a switching transistor. Compared with a bi-directional MOSFET device that is used as a switching transistor, a turn-on impedance of the bi-directional HEMTs device may theoretically be reduced by one order of magnitude with a same breakdown voltage. In an actual low-voltage application (30 V), the turn-on impedance may also be optimized by more than one time. If a 2 mm × 2 mm wafer level chip scale package is used for packaging, the turn-on impedance of the HEMTs device may reach 5 ohms. In addition, the HEMTs device has no parasitic diode, has a simpler structure, and has no parasitic NPN-type triode structure. When the HEMTs device is turned off, a breakdown voltage characteristic may be met without pulling the potential of the substrate electrode down to the potential of the reference ground end.

In some embodiments, the pull-up circuit further includes a sixth switching transistor. Both a sixth gate electrode of the sixth switching transistor and the fifth gate electrode of the fifth switching transistor are coupled to the first gate electrode, a first electrode of the sixth switching transistor is coupled to the first drain electrode, and a second electrode of the sixth switching transistor is coupled to the substrate electrode. The pull-up circuit and the pull-down circuit include both the fifth switching transistor and the sixth switching transistor. The fifth switching transistor and the sixth switching transistor jointly adjust the potential of the substrate electrode, to provide double assurance, so that quality and a service life of the charging protection circuit are improved.

In some embodiments, the pull-down circuit includes a third resistor. The third resistor is separately coupled to the substrate electrode and the fixed signal end. The pull-down circuit in the charging protection circuit includes the third resistor. By using a voltage division principle of the resistor, when the high electron mobility transistor is turned off, the substrate electrode is approximately short-circuited to the fixed signal end. The structure is simple, easy to implement, and low in costs.

In some embodiments, the pull-down circuit includes a seventh switching transistor. A seventh gate electrode of the seventh switching transistor is configured to control turn-on or turn-off of the seventh switching transistor, a first electrode of the seventh switching transistor is coupled to the substrate electrode, and a second electrode of the seventh switching transistor is coupled to the fixed signal end. The pull-down circuit in the charging protection circuit includes the seventh switching transistor. When the pull-up circuit is turned on, the pull-down circuit is cut off. A path from the first drain electrode and the second drain electrode of the high electron mobility transistor to the fixed voltage end is completely pinched off. A leakage current during turn-on of the high electron mobility transistor may be further reduced, and a loss from the substrate electrode to the fixed voltage end during turn-on of the high electron mobility transistor is reduced.

In some embodiments, the pull-down circuit includes an eighth switching transistor. An eighth gate electrode of the eighth switching transistor is configured to control turn-on or turn-off of the eighth switching transistor, a first electrode of the eighth switching transistor is coupled to the substrate electrode, and a second electrode of the eighth switching transistor is coupled to the fixed signal end. The eighth switching transistor and the fifth switching transistor are an N-type switching transistor and a P-type switching transistor of each other. In the pull-up circuit and the pull-down circuit in the charging protection circuit, a MOSFET device may be used as a switching transistor, and the pull-up circuit and the pull-down circuit are disposed separately from the high electron mobility transistor. During preparation of the high electron mobility transistor, isolation between the high electron mobility transistor and the fifth switching transistor and the eighth switching transistor does not need to be considered, so that a preparation process of the high electron mobility transistor may be simplified.

According to a sixth aspect of embodiments of this application, a chip is provided, including the charging protection circuit according to any one of the first aspect, any one of the third aspect, or any one of the fifth aspect.

The chip provided in this embodiment of this application includes the foregoing charging protection circuit, and beneficial effects of the chip are the same as beneficial effects of the charging protection circuit. Refer to the foregoing related descriptions, and details are not described herein again.

According to a seventh aspect of embodiments of this application, a package structure is provided, including the chip in the sixth aspect and a package housing, where the chip is packaged in the package housing.

The package structure provided in this embodiment of this application includes the foregoing charging protection circuit, and beneficial effects of the package structure are the same as beneficial effects of the charging protection circuit. Refer to the foregoing related descriptions, and details are not described herein again.

According to an eighth aspect of embodiments of this application, an electronic device is provided, including the package structure according to the seventh aspect, a printed circuit board, and a load. The package structure is disposed on the printed circuit board and is coupled to the printed circuit board, and the package structure is further coupled to the load.

The electronic device provided in this embodiment of this application includes the foregoing charging protection circuit, and beneficial effects of the electronic device are the same as beneficial effects of the charging protection circuit. Refer to the foregoing related descriptions, and details are not described herein again.

### BRIEF DESCRIPTION OF DRAWINGS

FIG. 1A is a schematic diagram of a framework of an electronic device according to an embodiment of this application;
FIG. 1B is a diagram of an upper-end application scenario of a charging circuit according to an embodiment of this application;
FIG. 1C is a schematic diagram of a structure of a charging circuit included in an upper-end application of the charging circuit according to an embodiment of this application;
FIG. 1D is a schematic diagram of a structure of a drive circuit in a charging circuit according to an embodiment of this application;
FIG. 2A is a schematic diagram of a structure of a charging protection circuit included in an upper-end application of a charging circuit according to an embodiment of this application;
FIG. 2B is a schematic diagram of a structure of a bi-directional high electron mobility transistor according to an embodiment of this application;
FIG. 2C is a simplified schematic diagram of a bi-directional high electron mobility transistor according to an embodiment of this application;
FIG. 2D is a schematic diagram of a structure of a charging protection circuit included in an upper-end application of another charging circuit according to an embodiment of this application;
FIG. 2E is a schematic diagram of a structure of a charging protection circuit included in an upper-end application of still another charging circuit according to an embodiment of this application;
FIG. 3A is a schematic diagram of a circuit structure of a charging circuit according to an embodiment of this application;
FIG. 3B is a schematic diagram of a structure of the charging circuit shown in FIG. 3A according to an embodiment of this application;
FIG. 3C shows a transfer characteristic curve of a high electron mobility transistor;
FIG. 4 is a schematic diagram of a circuit structure of another charging circuit according to an embodiment of this application;
FIG. 4B is a schematic diagram of an equivalent structure of a bi-directional high electron mobility transistor in the charging circuit shown in FIG. 4A according to an embodiment of this application;
FIG. 4C shows a breakdown characteristic curve of a high electron mobility transistor;
FIG. 5 is a schematic diagram of a circuit structure of still another charging circuit according to an embodiment of this application;
FIG. 5B is a schematic diagram of an equivalent structure of a bi-directional high electron mobility transistor in the charging circuit shown in FIG. 5A according to an embodiment of this application;
FIG. 5C is a schematic diagram of an equivalent structure of a bi-directional high electron mobility transistor in the charging circuit shown in FIG. 5A according to an embodiment of this application;
FIG. 6 is a schematic diagram of a structure of a charging protection circuit according to an embodiment of this application;
FIG. 7A is a schematic diagram of a detailed structure of the charging protection circuit shown in FIG. 6 according to an embodiment of this application;

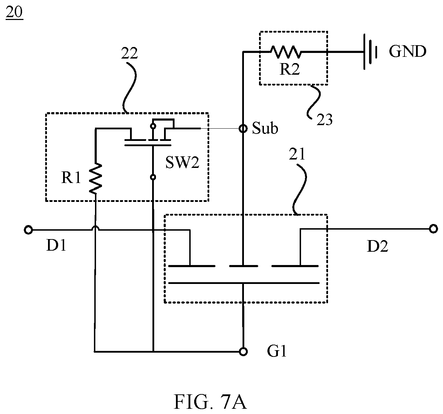

FIG. 7B-1 and FIG. 7B-2 are a schematic diagram of an equivalent structure of the charging protection circuit shown in FIG. 7A according to an embodiment of this application;

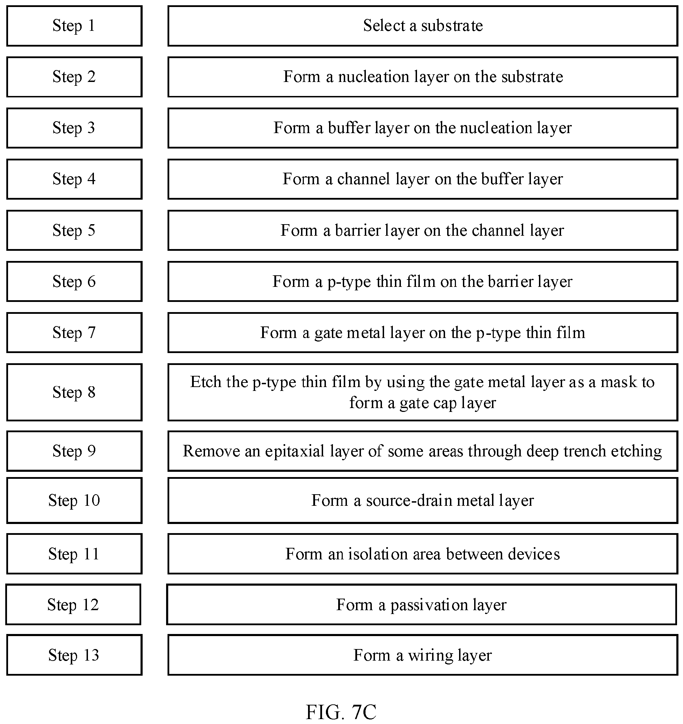

FIG. 7C is a schematic flowchart of preparing the equivalent structure of the charging protection circuit shown in FIG. 7B-1 and FIG. 7B-2 according to an embodiment of this application;

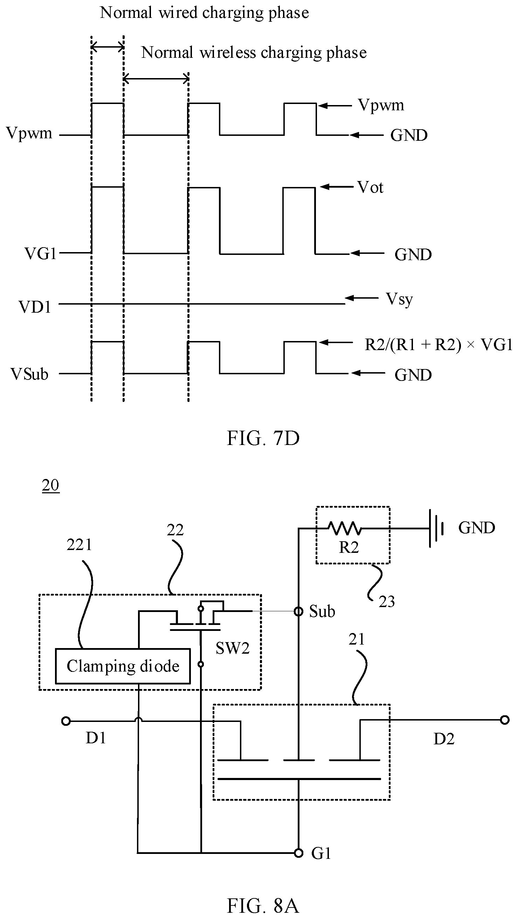

FIG. 7D is a driving time sequence diagram of the charging protection circuit shown in FIG. 7A according to an embodiment of this application;

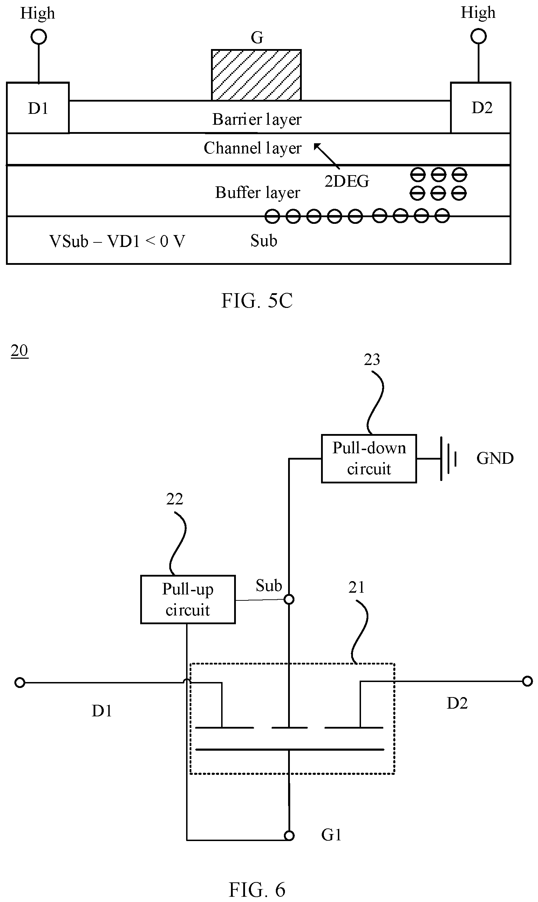

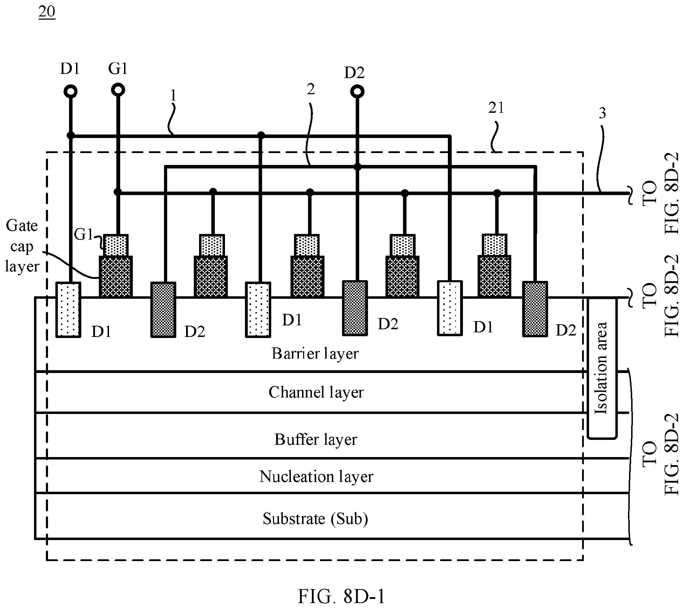

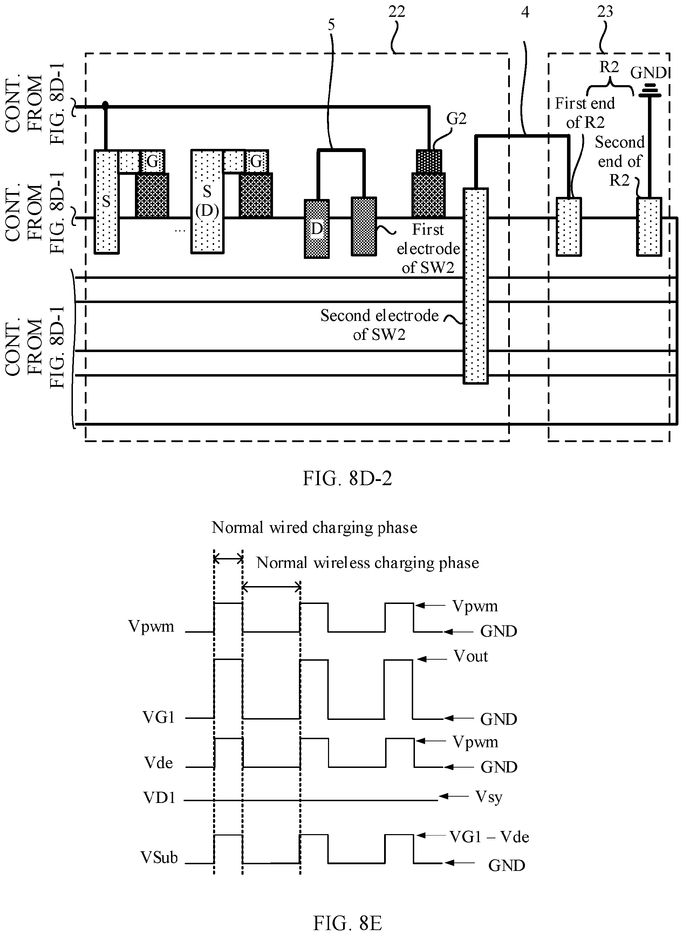

FIG. 8A is another schematic diagram of a detailed structure of the charging protection circuit shown in FIG. 6 according to an embodiment of this application;

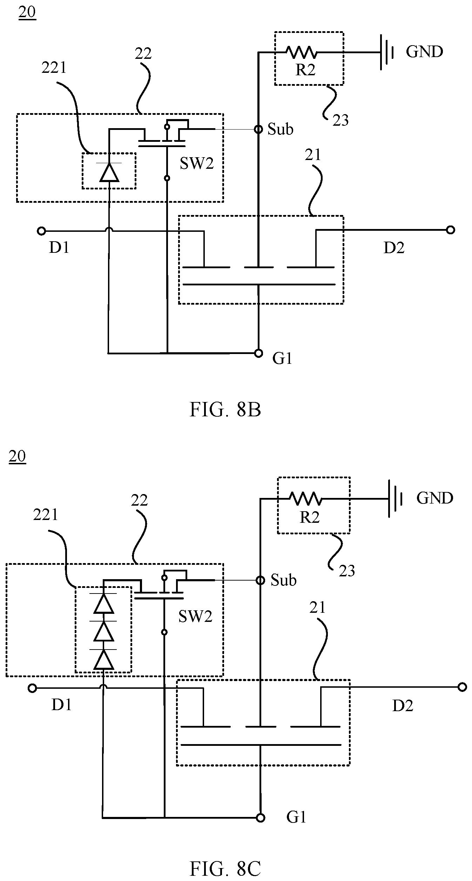

FIG. 8B is a schematic diagram of a detailed structure of the charging protection circuit shown in FIG. 8A according to an embodiment of this application;
FIG. 8C is another schematic diagram of a detailed structure of the charging protection circuit shown in FIG. 8A according to an embodiment of this application;
FIG. 8D-1 and FIG. 8D-2 are a schematic diagram of an equivalent structure of the charging protection circuit shown in FIG. 8C according to an embodiment of this application;
FIG. 8E is a driving time sequence diagram of the charging protection circuit shown in FIG. 8A according to an embodiment of this application;

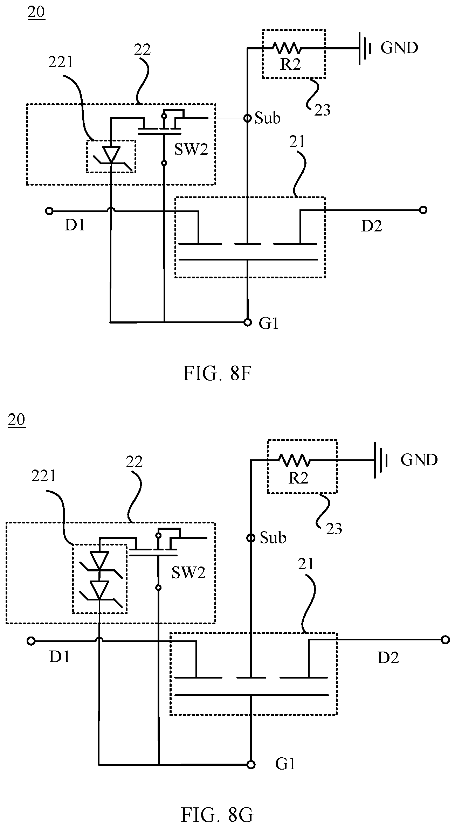

FIG. 8F is still another schematic diagram of a detailed structure of the charging protection circuit shown in FIG. 8A according to an embodiment of this application;
FIG. 8G is yet another schematic diagram of a detailed structure of the charging protection circuit shown in FIG. 8A according to an embodiment of this application;

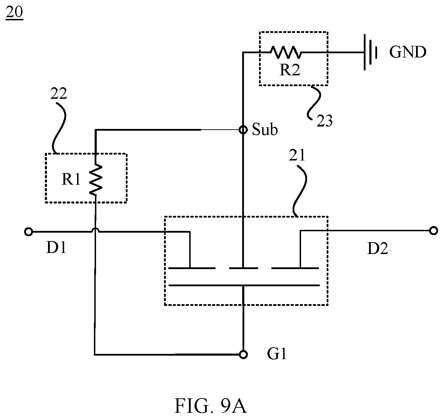

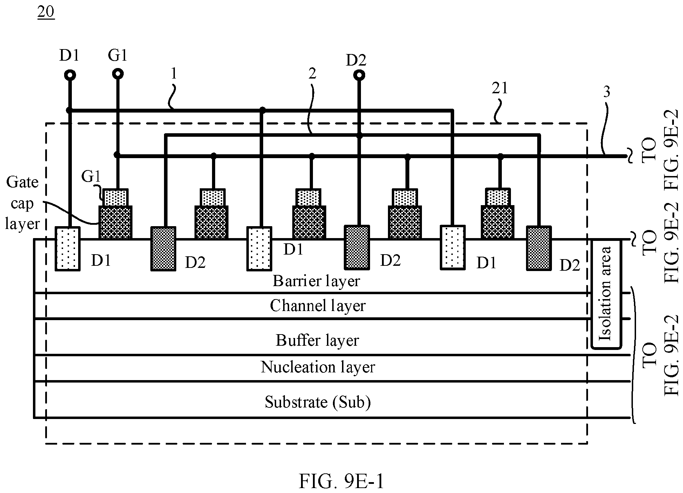

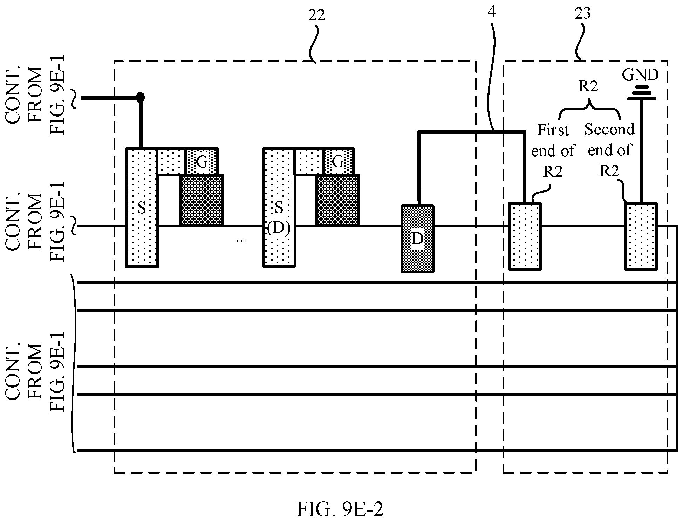

FIG. 9A is still another schematic diagram of a detailed structure of the charging protection circuit shown in FIG. 6 according to an embodiment of this application;

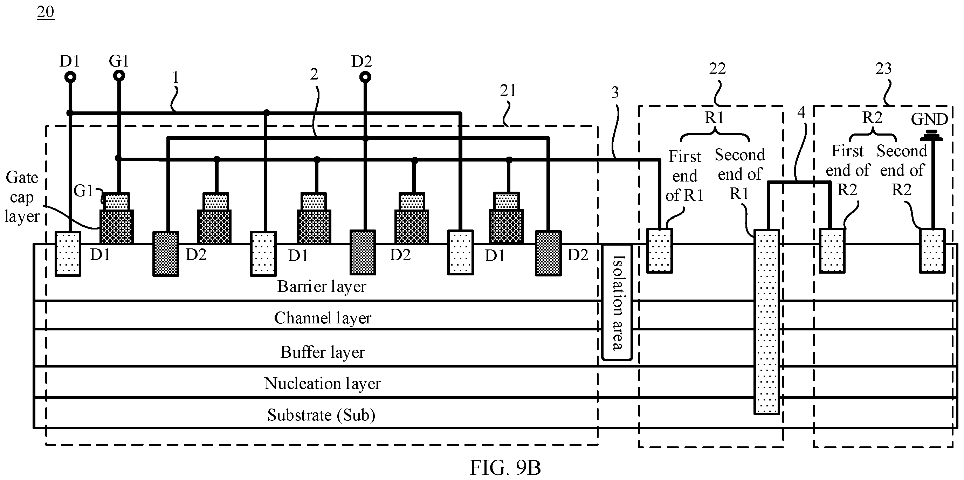

FIG. 9B is a schematic diagram of an equivalent structure of the charging protection circuit shown in FIG. 9A according to an embodiment of this application;

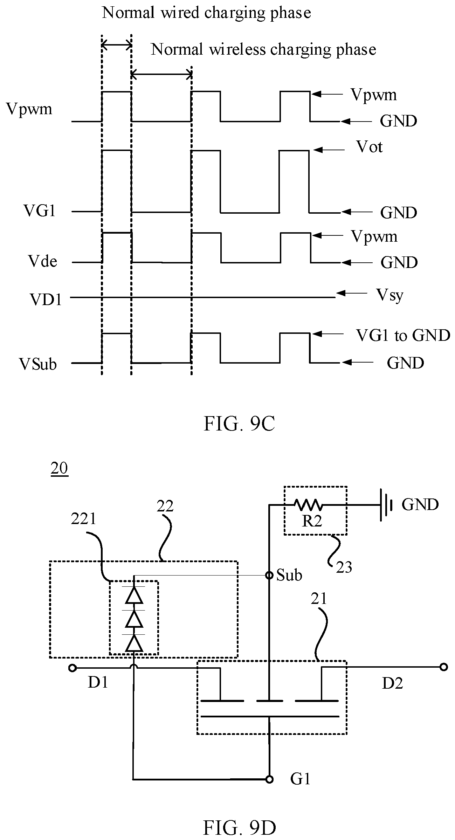

FIG. 9C is a driving time sequence diagram of the charging protection circuit shown in FIG. 9A according to an embodiment of this application;
FIG. 9D is yet another schematic diagram of a detailed structure of the charging protection circuit shown in FIG. 6 according to an embodiment of this application;
FIG. 9E-1 and FIG. 9E-2 are a schematic diagram of an equivalent structure of the charging protection circuit shown in FIG. 9A according to an embodiment of this application;

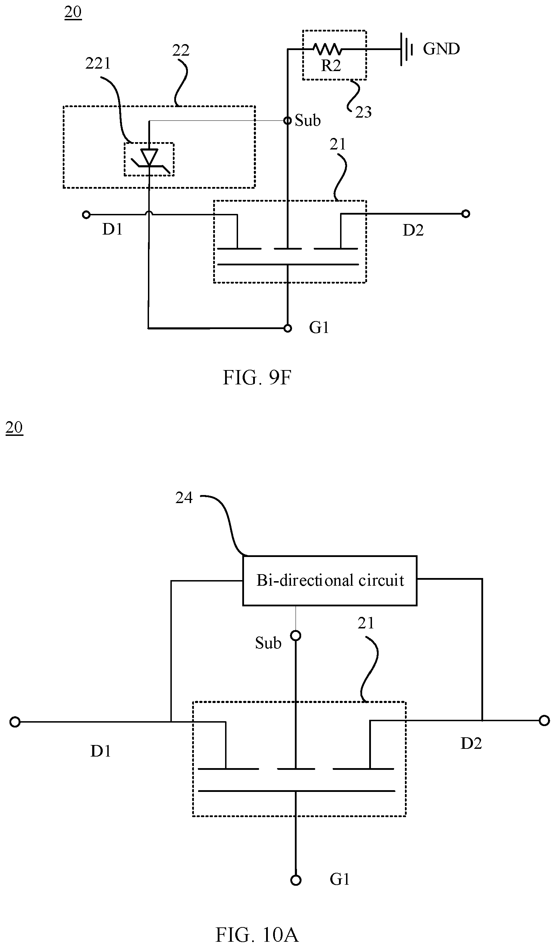

FIG. 9F is still yet another schematic diagram of a detailed structure of the charging protection circuit shown in FIG. 6 according to an embodiment of this application;
FIG. 10A is a schematic diagram of a structure of another charging protection circuit according to an embodiment of this application;

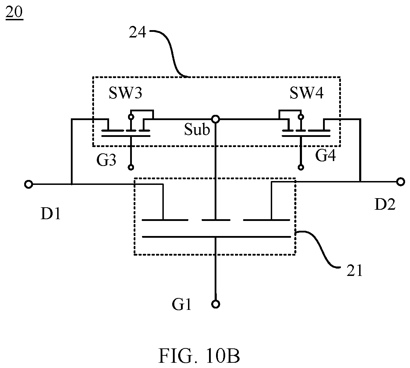

FIG. 10B is a schematic diagram of a detailed structure of the charging protection circuit shown in FIG. 10A according to an embodiment of this application;

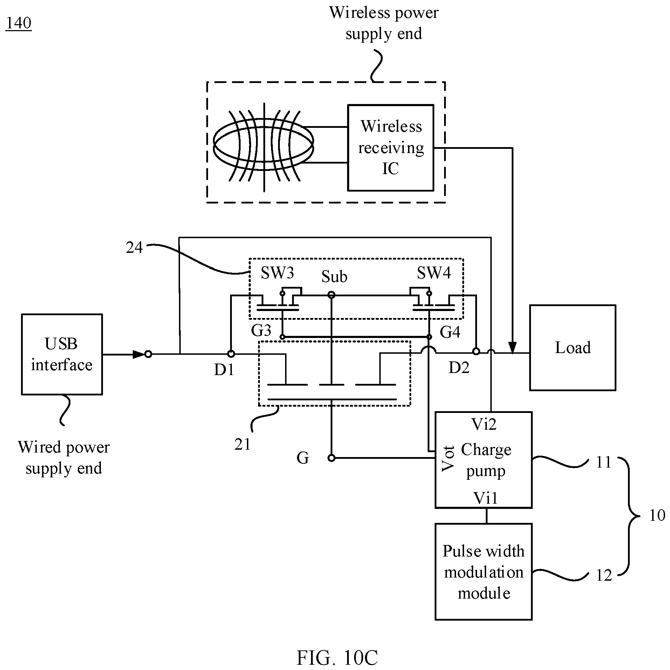

FIG. 10C is a schematic diagram of an upper-end application of the charging protection circuit shown in FIG. 10B according to an embodiment of this application;

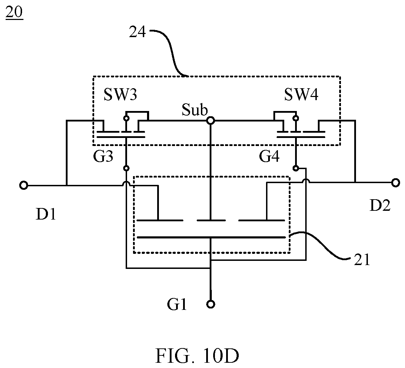

FIG. 10D is another schematic diagram of a detailed structure of the charging protection circuit shown in FIG. 10A according to an embodiment of this application;

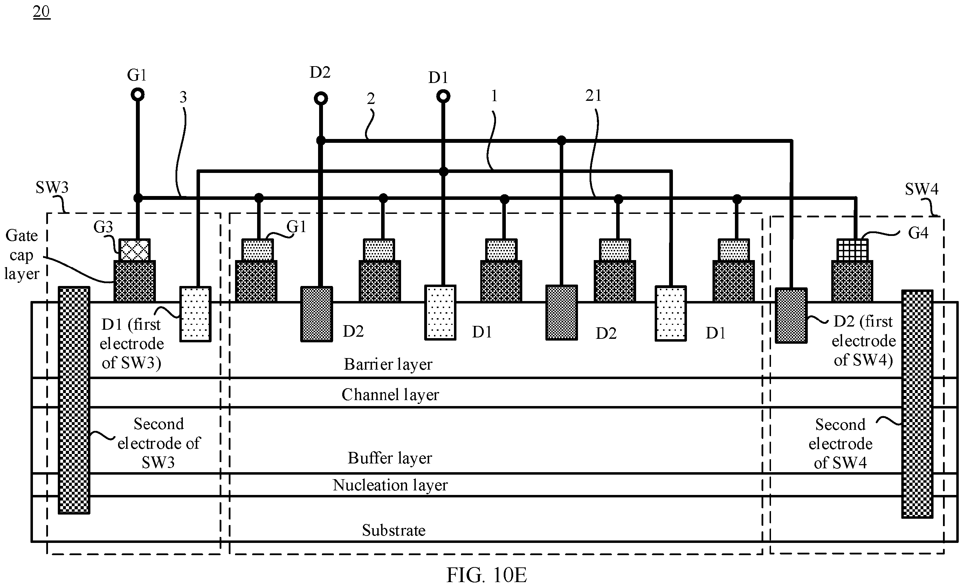

FIG. 10E is a schematic diagram of an equivalent structure of the charging protection circuit shown in FIG. 10D according to an embodiment of this application;

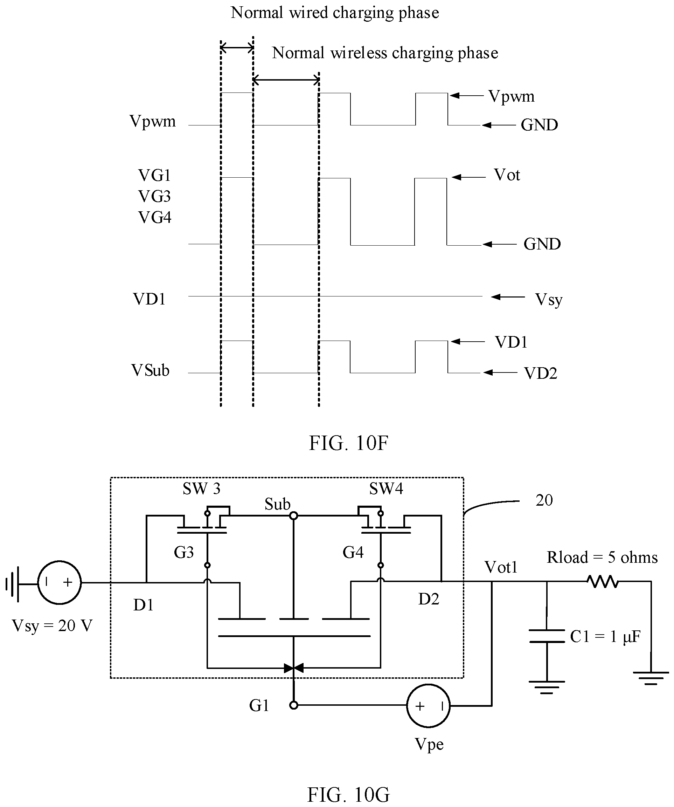

FIG. 10F is a driving time sequence diagram of the charging protection circuit shown in FIG. 10D according to an embodiment of this application;
FIG. 10G is a schematic diagram of an analog application of the charging protection circuit shown in FIG. 10D according to an embodiment of this application;

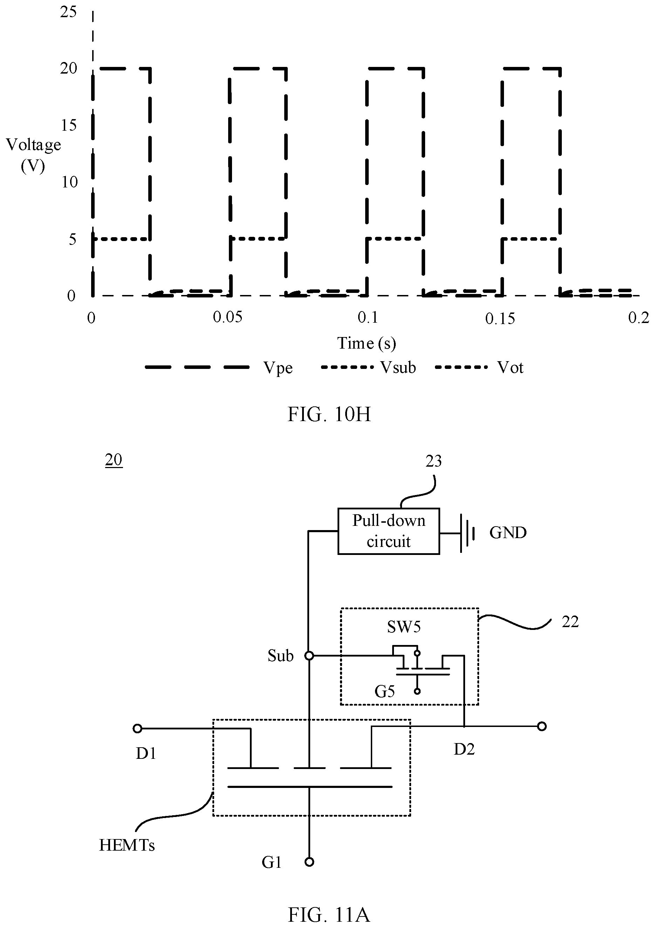

FIG. 10H shows voltage values at points in the analog application of the charging protection circuit shown in FIG. 10G according to an embodiment of this application;
FIG. 11A is a schematic diagram of a structure of still another charging protection circuit according to an embodiment of this application;

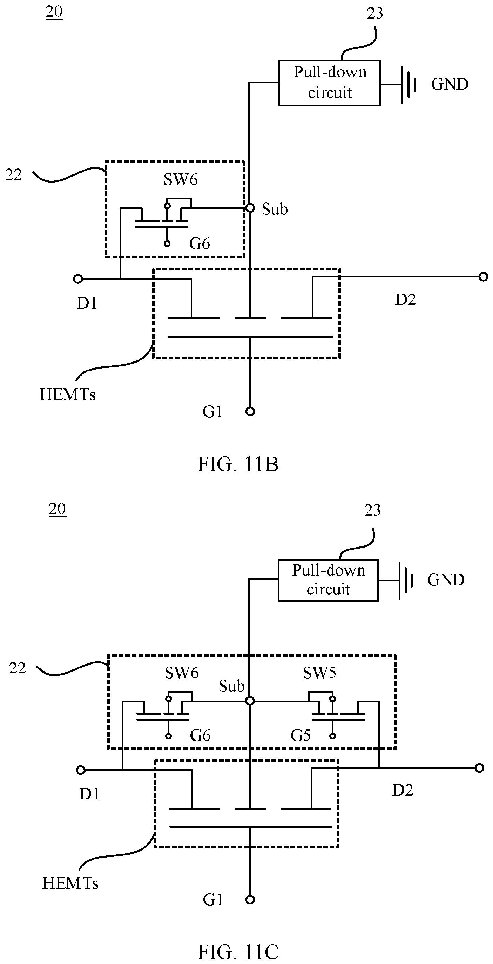

FIG. 11B is a schematic diagram of a structure of yet another charging protection circuit according to an embodiment of this application;
FIG. 11C is a schematic diagram of a structure of still yet another charging protection circuit according to an embodiment of this application;

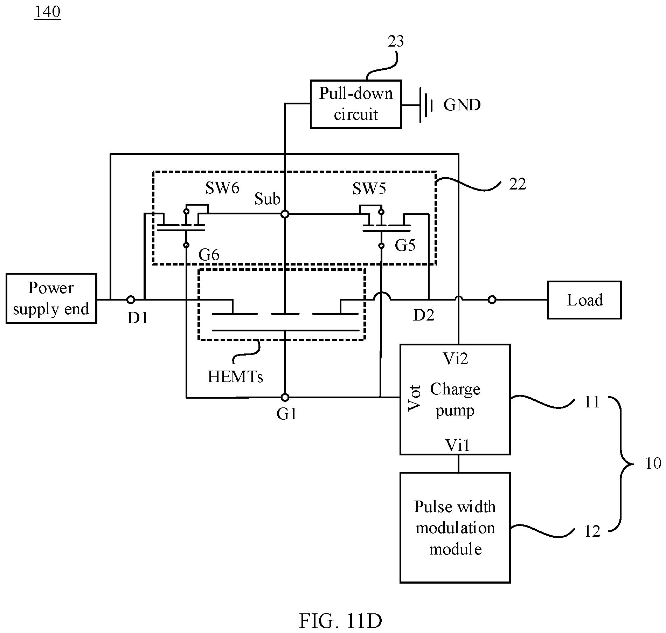

FIG. 11D is a schematic diagram of an upper-end application of the charging protection circuit shown in FIG. 11C according to an embodiment of this application;

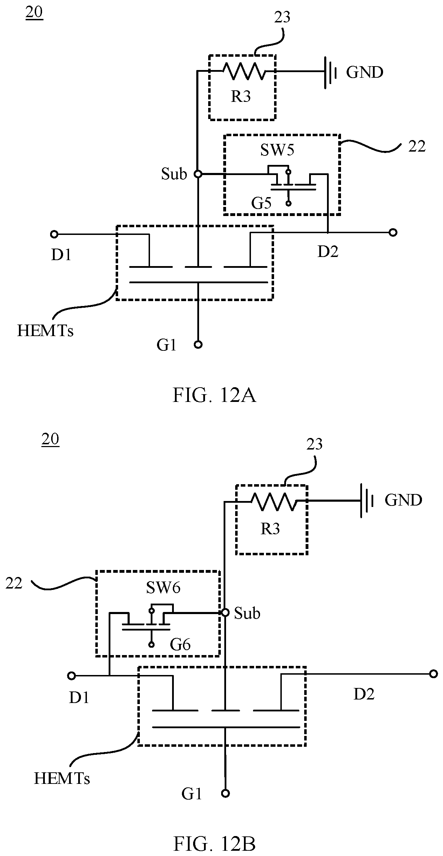

FIG. 12A is a schematic diagram of a detailed structure of the charging protection circuit shown in FIG. 11A according to an embodiment of this application;
FIG. 12B is a schematic diagram of a detailed structure of the charging protection circuit shown in FIG. 11B according to an embodiment of this application;

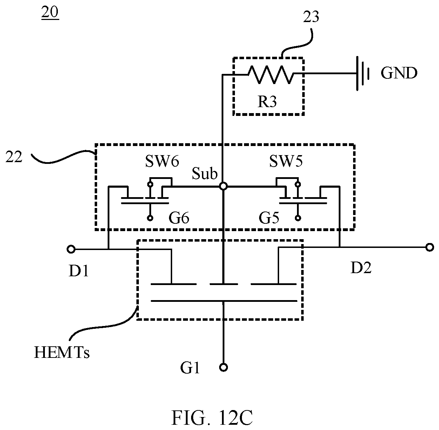

FIG. 12C is a schematic diagram of a detailed structure of the charging protection circuit shown in FIG. 11C according to an embodiment of this application;

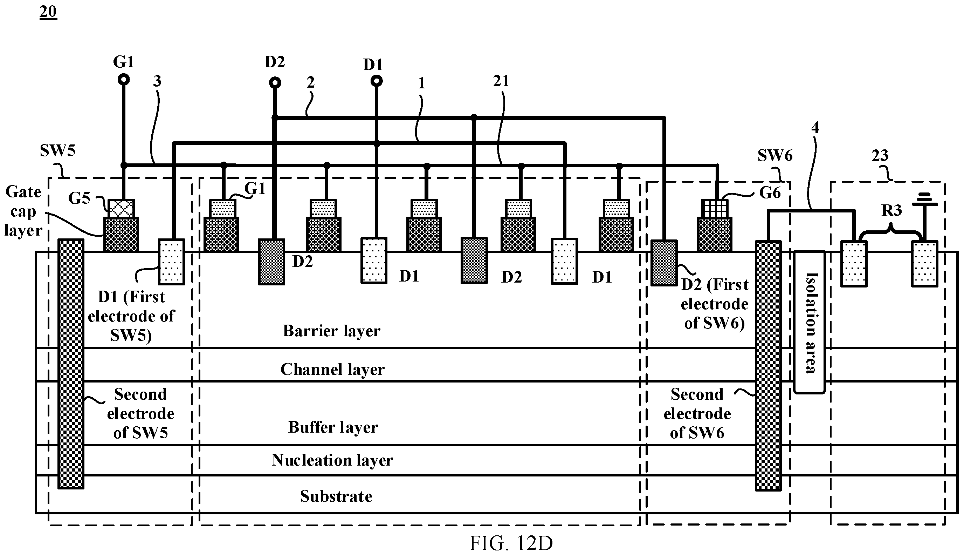

FIG. 12D is a schematic diagram of an equivalent structure of the charging protection circuit shown in FIG. 12C according to an embodiment of this application;

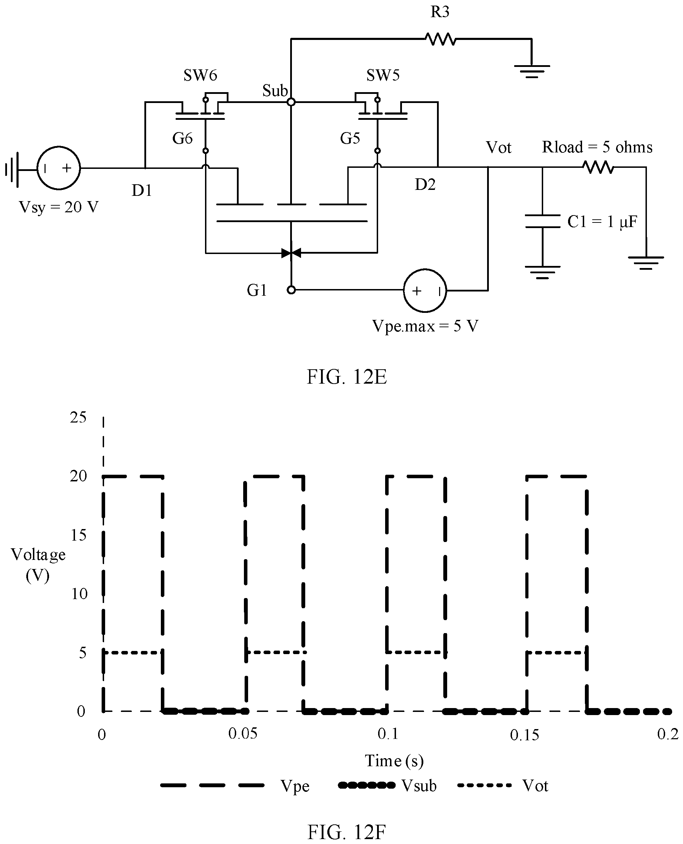

FIG. 12E is a schematic diagram of an analog application of the charging protection circuit shown in FIG. 12C according to an embodiment of this application;
FIG. 12F shows voltage values at points in the analog application of the charging protection circuit shown in FIG. 12E according to an embodiment of this application;

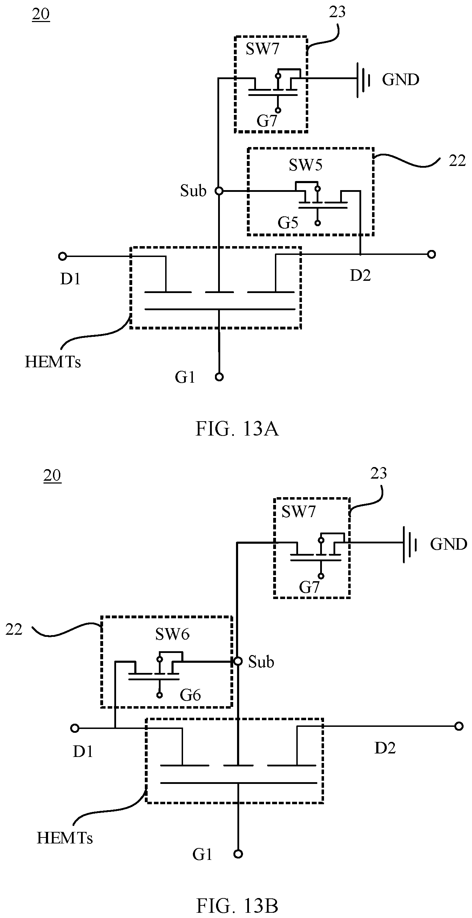

FIG. 13A is another schematic diagram of a detailed structure of the charging protection circuit shown in FIG. 11A according to an embodiment of this application;
FIG. 13B is another schematic diagram of a detailed structure of the charging protection circuit shown in FIG. 11B according to an embodiment of this application;

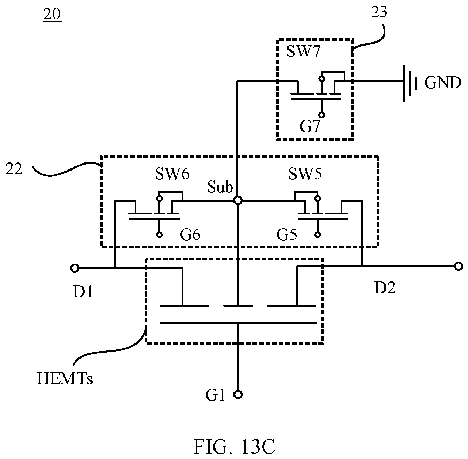

FIG. 13C is another schematic diagram of a detailed structure of the charging protection circuit shown in FIG. 11C according to an embodiment of this application;

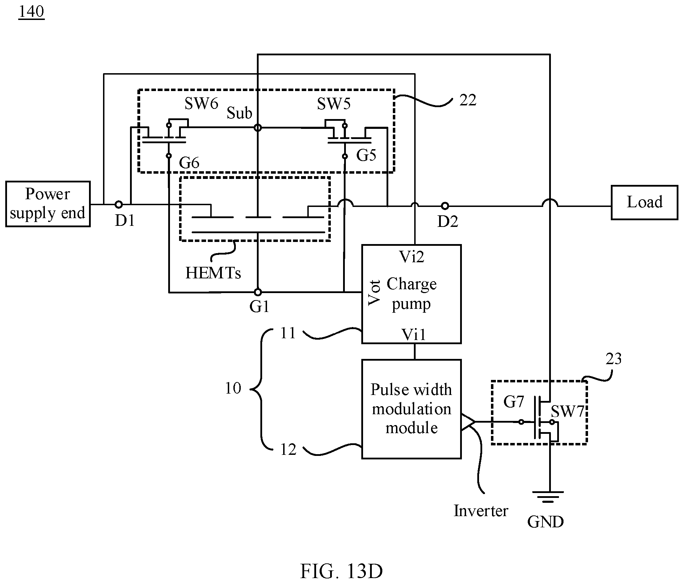

FIG. 13D is a schematic diagram of an upper-end application of the charging protection circuit shown in FIG. 13C according to an embodiment of this application;

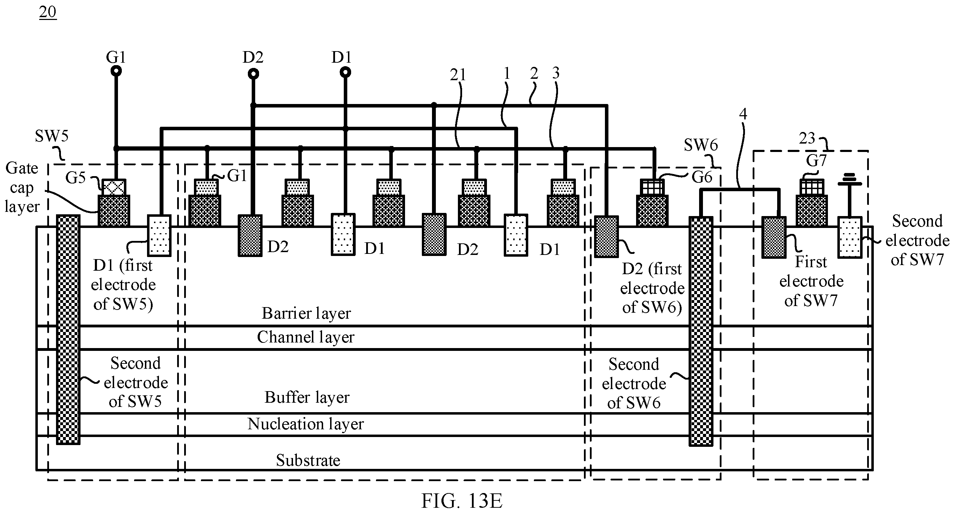

FIG. 13E is a schematic diagram of an equivalent structure of the charging protection circuit shown in FIG. 13C according to an embodiment of this application;

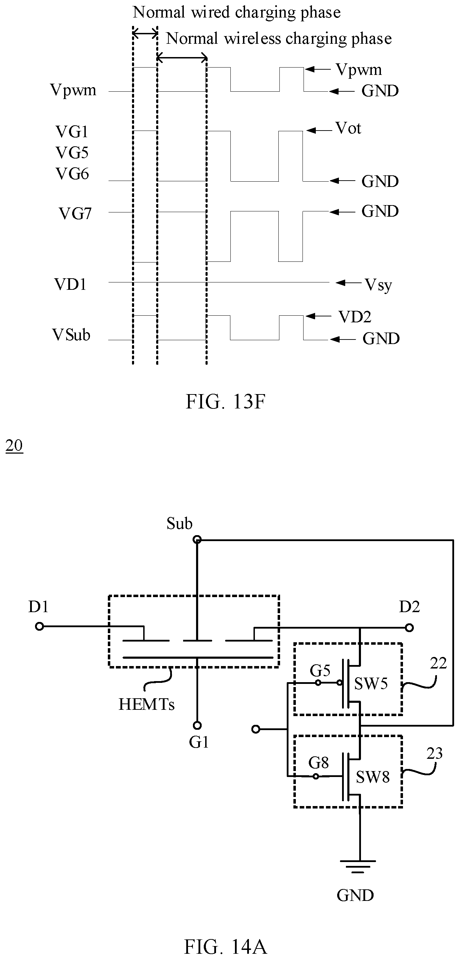

FIG. 13F is a driving time sequence diagram of the charging protection circuit shown in FIG. 13C according to an embodiment of this application;
FIG. 14A is still another schematic diagram of a detailed structure of the charging protection circuit shown in FIG. 11A according to an embodiment of this application;

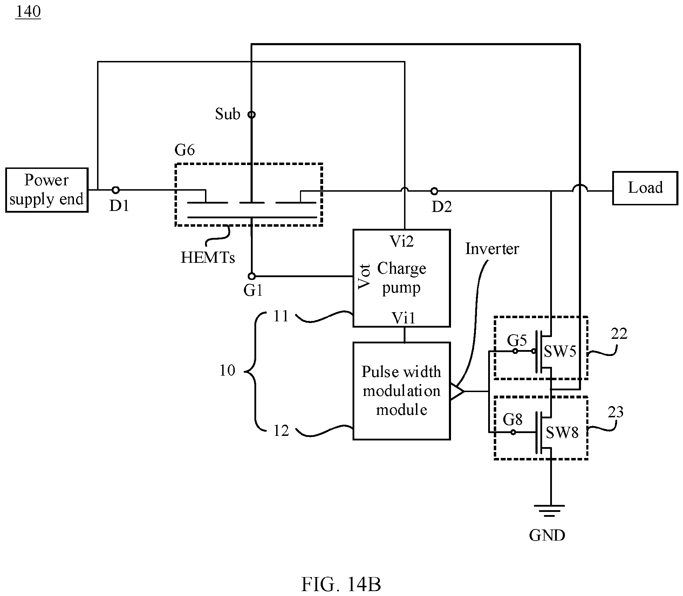

FIG. 14B is a schematic diagram of an upper-end application of the charging protection circuit shown in FIG. 14A according to an embodiment of this application;

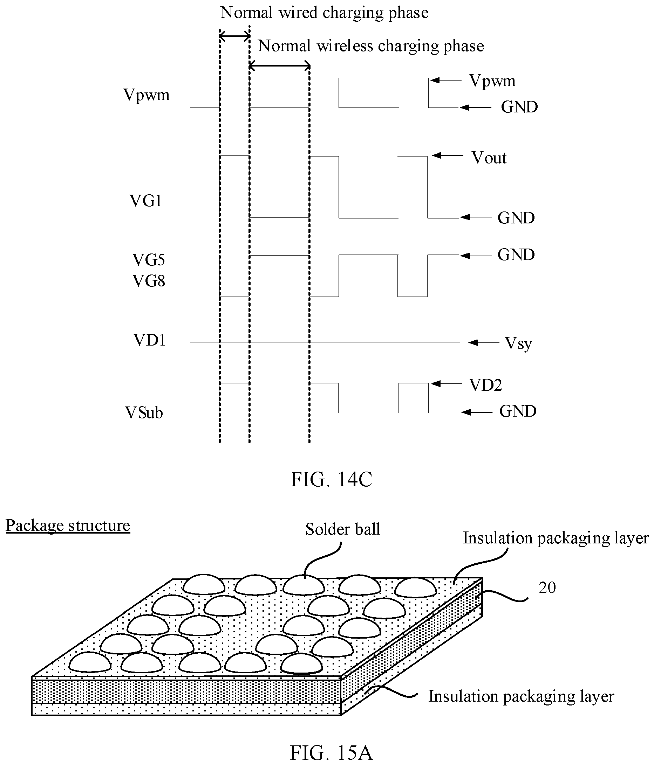

FIG. 14C is a driving time sequence diagram of the charging protection circuit shown in FIG. 14A according to an embodiment of this application;
FIG. 15A is a schematic diagram of packaging of a charging protection circuit according to an embodiment of this application;

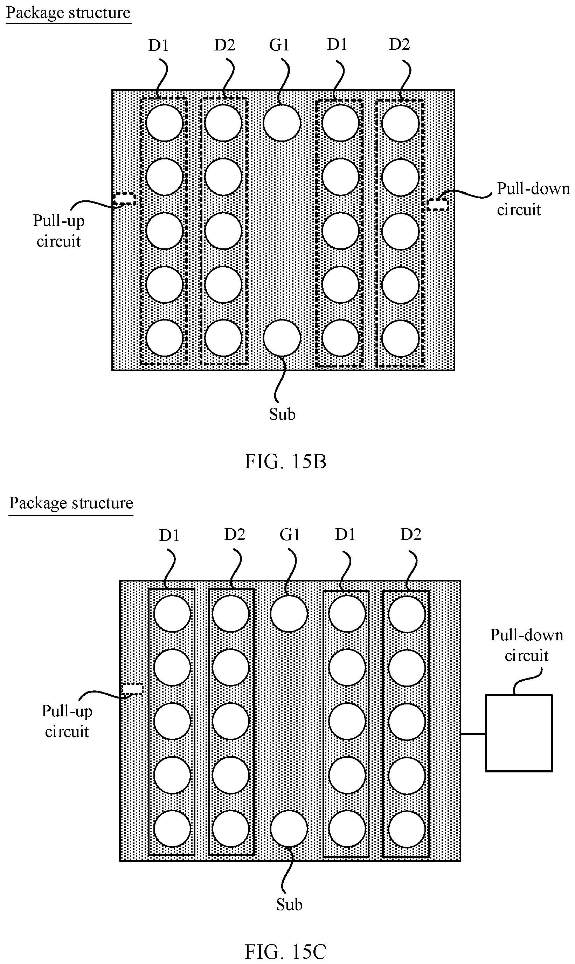

FIG. 15B is a top view of a package structure according to an embodiment of this application;
FIG. 15C is a top view of a package structure according to an embodiment of this application; and

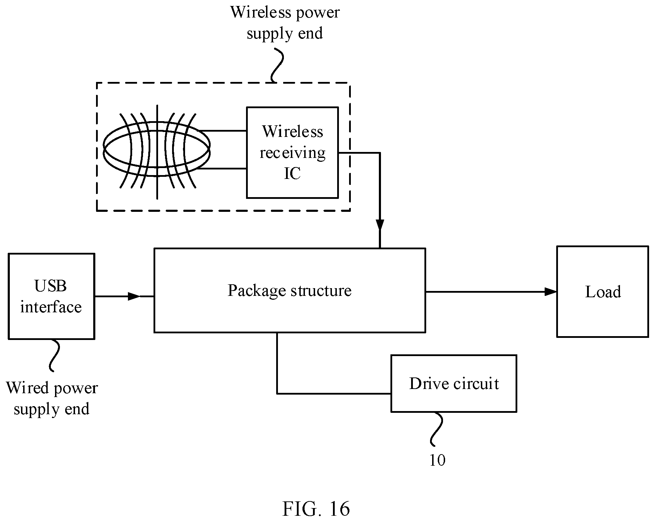

FIG. 16 is a schematic diagram of an application of a packaged charging protection circuit in an electronic device according to an embodiment of this application.

### DESCRIPTION OF EMBODIMENTS

The following describes the technical solutions in embodiments of this application with reference to the accompanying drawings in embodiments of this application. It is clear that the described embodiments are merely some rather than all of embodiments of this application.

The following terms "first", "second" and the like are merely intended for ease of description, and shall not be understood as an indication or implication of relative importance or implicit indication of a quantity of indicated technical features. Therefore, a feature defined by "first" or "second" may explicitly or implicitly include one or more features. In the descriptions of this application, unless otherwise stated, "a plurality of" means two or more than two.

In addition, in embodiments of this application, orientation terms such as "upper", "lower", "left", and "right" may be defined by, but are not limited to, orientations of components schematically placed in the accompanying drawings. It should be understood that these orientation terms may be relative concepts, are used for description and clarification of "relative to", and may be changed correspondingly based on changes in placement orientations of the components in the accompanying drawings.

In embodiments of this application, unless otherwise specified in the context, in the entire specification and claims, the term "include" is interpreted as "open and inclusive", that is, "include, but not limited to". In the descriptions of this specification, terms such as "an embodiment", "some embodiments", "example embodiments", "examples", or "some examples" are intended to indicate that specific features, structures, materials, or features related to embodiments or examples are included in at least one embodiment or example of this disclosure. The foregoing schematic representations of the terms do not necessarily refer to a same embodiment or example. Further, the particular feature, structure, material, or characteristic may be included in any one or more embodiments or examples in any appropriate manner.

When some embodiments are described, expressions of "coupling" and "connection" and their extensions may be used. For example, when some embodiments are described, the term "connection" may be used to indicate that two or more components are in direct physical contact or electrical contact with each other. For another example, when some embodiments are described, the term "coupled" may be used to indicate that two or more components are in direct physical contact or electrical contact. However, the term "coupling" may also mean that two or more components do not directly contact each other, but still collaborate or interact with each other. Embodiments disclosed herein are not necessarily limited to the content of this specification.

In embodiments of this application, the term "and/or" describes an association relationship between associated objects and may indicate three relationships. For example, A and/or B may indicate the following cases: Only A exists, both A and B exist, and only B exists, where A and B may be singular or plural. The character "/" generally indicates an "or" relationship between the associated objects.

Example implementations are described herein with reference to sectional views and/or floor plans and/or equivalent circuit diagrams as idealized exemplary drawings. In the accompanying drawings, for clarity, thicknesses of layers and regions are enlarged. Therefore, a change in the shape of the drawings due to, for example, manufacturing techniques and/or tolerances may be envisaged. Therefore, example implementations should not be construed as being limited to the shape of the region shown herein, but rather include shape deviations due to, for example, manufacturing. For example, an etching region shown as a rectangle will typically have a bending characteristic. Therefore, the regions shown in the accompanying drawings are essentially examples, and their shapes are not intended to show actual shapes of the regions of a device, and are not intended to limit the scope of the example implementations.

In embodiments of this application, that B is approximately equal to A may be understood that, a value of B in a range of A ± 2 (a range from A - 2 to A + 2) is approximately equal to A.

Before embodiments of this application are described, terms that may appear next are defined first.

2DEG (two-dimensional electron gas): Discontinuous energy band structures in a semiconductor heterojunction structure form a potential well on an interface. Electrons are bound to the potential well, so that the electrons move basically along a direction parallel to the interface, and an electron movement along a direction vertical to the interface is limited.

Heterojunction: When two or more different semiconductor materials form a laminated structure, due to a difference between lattice constants and band gap widths of the two materials, an energy band difference exists on an interface of the two materials, and a heterojunction is formed.

Channel punch-through: a phenomenon that depletion regions of a source junction and a drain junction of a field-effect transistor are connected.

Back-gate effect: When a substrate electrode has a negative voltage relative to a gate electrode, a channel carrier concentration decreases when the transistor is turned on, and consequently, a turn-on impedance of the transistor decreases.

Characteristic resistance: a turn-on impedance of a chip per unit area.

Substrate electrode: an electrode formed by a substrate in a switching transistor structure.

Threshold voltage: Generally, an input voltage corresponding to a midpoint of a turning region in which an output current changes sharply with an input voltage in a transmission characteristic curve is referred to as a threshold voltage.

Dynamic resistance: indicates that a turn-on resistance of a HEMTs device changes dynamically when the HEMTs device is in an on/off state.

Channel: a thin conductive semiconductor layer between a source electrode and a drain electrode in a field-effect transistor.

Parasitic diode: For an N-type metal-oxide-semiconductor (N-type metal-oxide-semiconductor, NMOS) structure, a body region under a gate electrode is P-type doped, and is electrically connected to a source electrode normally, and N-type doping is performed between the gate electrode and a drain electrode. In this case, a parasitic pn-junction diode exists between the source electrode and the drain electrode, and the parasitic pn-junction diode is turned on when the source electrode has a high voltage relative to the drain electrode.

An embodiment of this application provides an electronic device. The electronic device is, for example, a mobile phone (mobile phone), a tablet computer (pad), a notebook computer, an e-reader, a personal digital assistant (personal digital assistant, PDA), an intelligent wearable product (for example, a smartwatch or a smart band), a virtual reality (virtual reality, VR) terminal device, an augmented reality (augmented reality, AR) terminal device, an unmanned aerial vehicle, a smart lock, a charging home small appliance (for example, a bean pulp machine or a robot vacuum cleaner), a mobile power supply, an adapter or a robot.

Specifically, the electronic device can be charged, and can also charge an external device. The charging may be in a wired or wireless manner. For example, a smartphone can be charged in a wired or wireless manner, and can also charge an external device (for example, a smartwatch or a smart band) in a reverse charging manner.

An example in which the electronic device is a mobile phone is used below to describe the electronic device provided in this embodiment of this application.

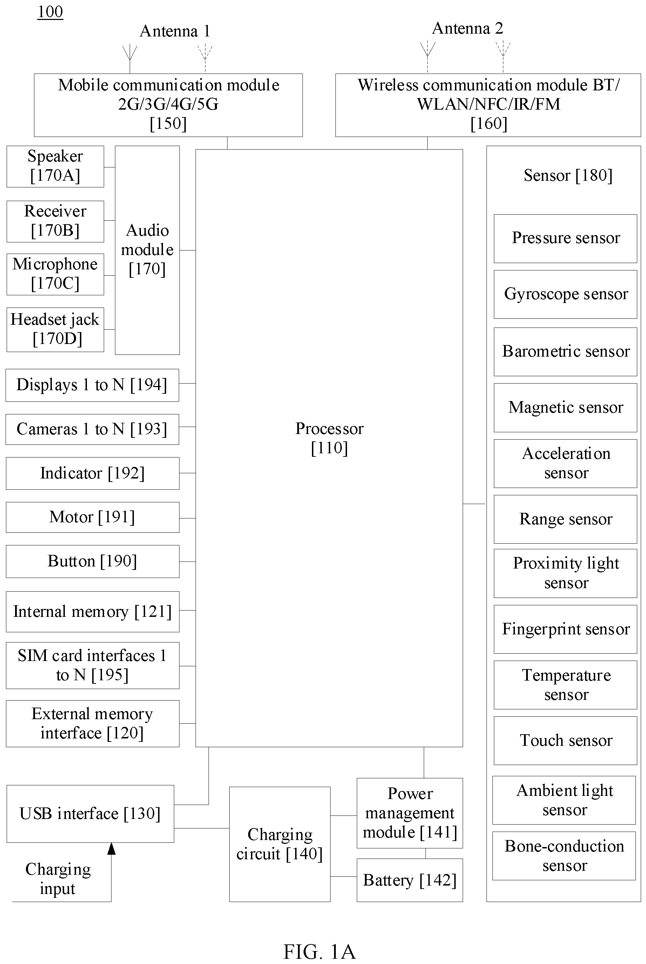

As shown in FIG. 1A, an electronic device 100 may include a processor 110, an external memory interface 120, an internal memory 121, a universal serial bus (universal serial bus, USB) interface 130, a charging circuit 140, a power management module 141, a battery 142, an antenna 1, an antenna 2, a mobile communication module 150, a wireless communication module 160, an audio module 170, a speaker 170A, a receiver 170B, a microphone 170C, a headset jack 170D, a sensor 180, a button 190, a motor 191, an indicator 192, a camera 193, a display 194, a subscriber identification module (subscriber identification module, SIM) card interface 195, and the like.

It may be understood that the structure shown in this embodiment does not constitute a specific limitation on the electronic device 100. In some other embodiments of this application, the electronic device 100 may include more or fewer components than those shown in the figure, or some components may be combined, or some components may be split, or different component arrangements may be used. The components shown in the figure may be implemented by hardware, software, or a combination of software and hardware.

The processor 110 may include one or more processing units.

For example, the processor 110 may include an application processor (application processor, AP), a modem processor, a graphics processing unit (graphics processing unit, GPU), an image signal processor (image signal processor, ISP), a controller, a video codec, a digital signal processor (digital signal processor, DSP), a baseband processor, and/or a neural-network processing unit (neural-network processing unit, NPU). Different processing units may be independent components, or may be integrated into one or more processors.

In some embodiments, the electronic device 100 may also include one or more processors 110. The processor 110 may be a nerve center and a command center of the electronic device 100. The processor 110 may generate an operation control signal based on an instruction operation code and a time sequence signal to complete control of instruction fetching and instruction execution.

A memory may be further disposed in the processor 110, and is configured to store instructions and data.

In some embodiments, the memory in the processor 110 is a cache. The memory may store instructions or data that has been used or cyclically used by the processor 110. If the processor 110 needs to use the instructions or the data again, the processor 110 may directly invoke the instructions or the data from the memory. This avoids repeated access and reduces a waiting time of the processor 110, so that system efficiency of the electronic device 100 is improved.

In some embodiments, the processor 110 may include one or more interfaces. The interface may include an inter-integrated circuit (inter-integrated circuit, I2C) interface, an inter-integrated circuit sound (inter-integrated circuit sound, I2S) interface, a pulse code modulation (pulse code modulation, PCM) interface, a universal asynchronous receiver/transmitter (universal asynchronous receiver/transmitter, UART) interface, a mobile industry processor interface (mobile industry processor interface, MIPI), a general-purpose input/output (general-purpose input/output, GPIO) interface, a subscriber identification module (subscriber identity module, SIM) interface, a universal serial bus (universal serial bus, USB) port, and/or the like.

The USB interface 130 is an interface that conforms to USB standard specifications, and may be specifically a mini USB interface, a micro USB interface, a USB Type-C interface, or the like. The USB interface 130 may be configured to connect to a charger to charge the electronic device 100, may be configured to transmit data between the electronic device 100 and a peripheral device, or may be configured to connect to a headset to play audio by using the headset.

It may be understood that an interface connection relationship between the modules shown in this embodiment of the present invention is merely an example for description, and does not constitute a limitation on a structure of the electronic device 100. In other embodiments of this application, the electronic device 100 may alternatively use an interface connection mode different from that in the foregoing embodiment, or use a combination of multiple interface connection modes.

The charging circuit 140 is configured to receive a charging input from a charger. The charger may be a wireless charger or a wired charger. The charging circuit 140 may further supply power to the electronic device 100 through the power management module 141 while charging the battery 142.

In some embodiments of wired charging, the charging circuit 140 may receive a charging input of a wired charger through the USB interface 130.

In some embodiments of wireless charging, the charging circuit 140 may receive a wireless charging input through a wireless charging coil of the electronic device 100.

The power management module 141 is configured to connect the battery 142, the charging circuit 140, and the processor 110. The power management module 141 receives an input of the battery 142 and/or the charging circuit 140, and supplies power to the processor 110, the internal memory 121, the display 194, the camera 193, the wireless communication module 160, and the like. The power management module 141 may be further configured to monitor parameters such as a battery capacity, a battery cycle count, and a battery health state (a leakage current or an impedance).

In some embodiments, the power management module 141 may alternatively be disposed in the processor 110. In some other embodiments, the power management module 141 and the charging circuit 140 may alternatively be disposed in a same component.

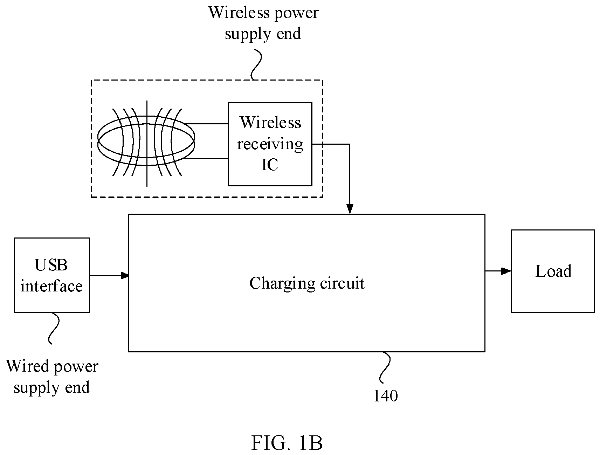

It can be learned from the foregoing description of the electronic device 100 that, as shown in FIG. 1B, a main function of the charging circuit 140 in the electronic device is to charge a load by receiving a charging input transmitted from a power supply end.

For example, the power supply end includes a wired power supply end including a USB interface and a wireless power supply end including a wireless charging coil and a wireless receiving IC (integrated circuit, integrated circuit). Certainly, the foregoing is merely an example of application of the charging circuit 140 in the mobile phone. The charging circuit 140 may be applied to any electronic device that needs to be charged.

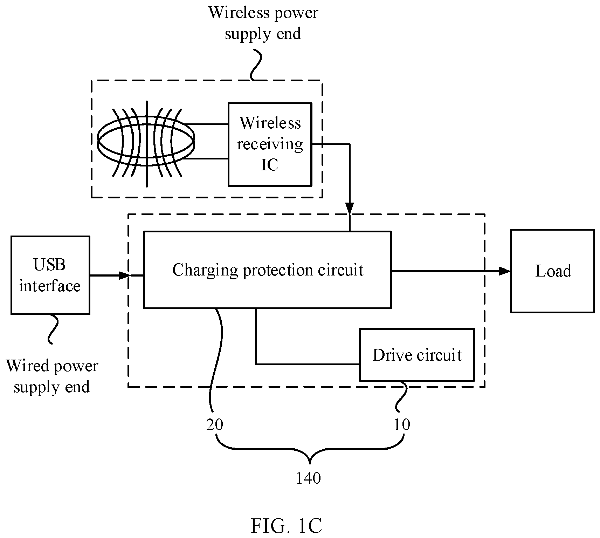

A structure of the charging circuit 140 provided in this embodiment of this application is shown in FIG. 1C. The charging circuit 140 includes a drive circuit (or referred to as a driver chip) 10 and a charging protection circuit 20.

The drive circuit 10 is configured to detect an over-voltage signal, and transmit a control signal to the charging protection circuit 20. The charging protection circuit 20 is configured to perform, under control of the control signal, bi-directional protection on a device coupled to the power supply end and a load coupled to a load end. Therefore, the charging protection circuit 20 is a key structure with which the charging circuit 140 has a bi-directional protection function.

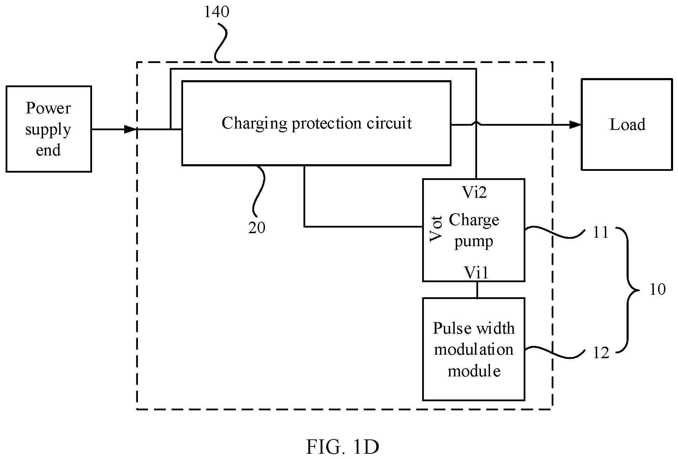

A structure of the drive circuit 10 is shown in FIG. 1D. The drive circuit 10 includes a charge pump (charge pump) 11 and a pulse width modulation (pulse-width modulation, PWM) module 12.

The charge pump 11 includes a first input end Vi1, a second input end V12, and an output end Vot. The first input end Vi1 is coupled to the PWM module 12, and is configured to receive a control logic voltage Vpwm output by the PWM module 12. The second input end Vi2 is coupled to the power supply end (which may be a wired power supply end or a wireless power supply end), and is configured to receive a power supply voltage Vsy input by the power supply end. The output end Vot is coupled to the charging protection circuit 20, and is configured to output a control signal to the charging protection circuit 20.

In other words, the charge pump 11 is configured to: under control of the control logic voltage Vpwm, process the received power supply voltage Vsy to obtain a control signal, and transmit the control signal to the charging protection circuit 20 from the output end Vot of the charge pump 11.

For example, the PWM module 12 is connected to the first input end Vi1 of the charge pump 11, and is configured to output the control logic electrode Vpwm to the first input end Vi1 of the charge pump 11.

When the PWM module 12 outputs a turn-on signal, the charge pump 11 receives the turn-on signal Vpwm, and boosts the voltage by using the second input end Vi2 of the charge pump 11, so that a voltage output by the output end Vot of the charge pump 11 is increased to Vi2 + Vpwm, and Vi2 + Vpwm is output to the charging protection circuit 20 as a control signal. When the PWM module 12 outputs a turn-off signal, for example, Vpwm = GND, after the first input end Vi1 of the charge pump 11 receives the turn-off signal, the control signal output from the output end Vot is also pulled to GND gradually.

In some embodiments, when the control logic voltage Vpwm is at a high potential, the control signal output by the output end Vot has a high voltage. When the control logic voltage Vpwm is at a low potential, the control signal output by the output end Vot has a low voltage.

For example, when the control logic voltage Vpwm is at a high potential, the charge pump 11 adds 5 V to the power supply voltage Vsy that is input from the second input end V12, and then outputs Vsy + 5 V as a control signal from the output end Vot. When the control logic voltage Vpwm is at a low potential, the control signal output by the output end Vot is 0.

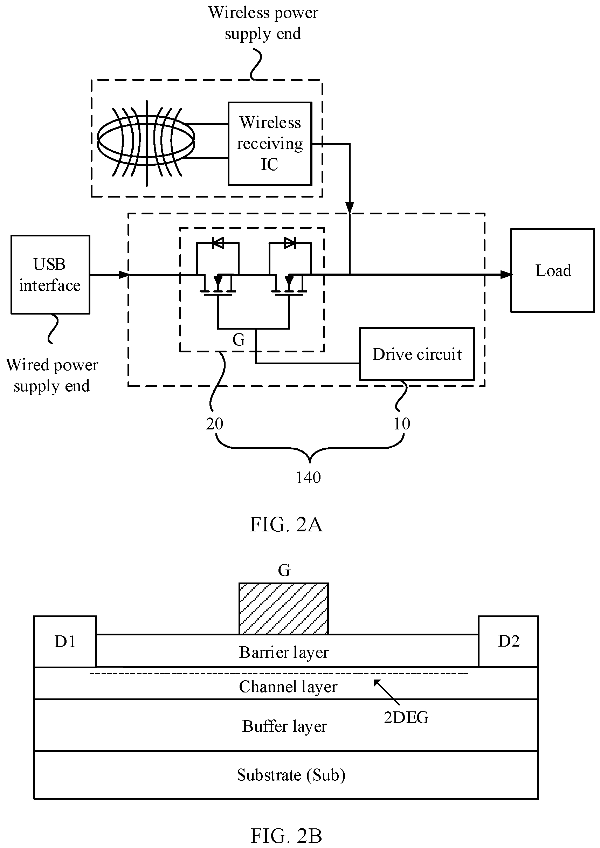

The charging protection circuit 20 is shown in FIG. 2A. In an application scenario of a wired and wireless shared charging circuit 140, in the industry, two silicon (Si) metal oxide semiconductor transistors (metal-oxide-semiconductor field-effect transistor, MOSFET) are usually connected in series in a back-to-back and source-sharing manner to serve as the charging protection circuit 20, to perform bi-directional protection on a device coupled to a power supply end and a load coupled to a load end.

However, if two Si MOSFETs are connected in series to serve as the charging protection circuit 20, a size of the charging protection circuit 20 is large. In addition, performance such as a turn-on impedance of a bi-directional blocking MOSFET prepared based on the Si material has basically reached a physical limit of the Si material. As a result, when the Si MOSFETs are turned on, a turn-on resistance of the charging protection circuit 20 formed by the Si MOSFETs is large, and consequently, a turn-on loss is large, circuit efficiency is low, and heat generation is serious.

However, a wide band gap (wide bandgap, WBG) semiconductor material represented by GaN (gallium nitride) has advantages such as a larger band gap width, a higher breakdown field strength, and a higher electron saturation rate, and becomes a most potential candidate in a new generation of power electronic devices. In addition, a typical GaN-based device is a high electron mobility transistor (high electron mobility transistors, HEMTs) device, where a channel is conducted through two-dimensional electron gas (2-dimensional electron gas, 2DEG), and there is no parasitic diode. Therefore, a conventional HEMTs device has a bi-directional blocking function only by adjusting a position of a gate electrode G.

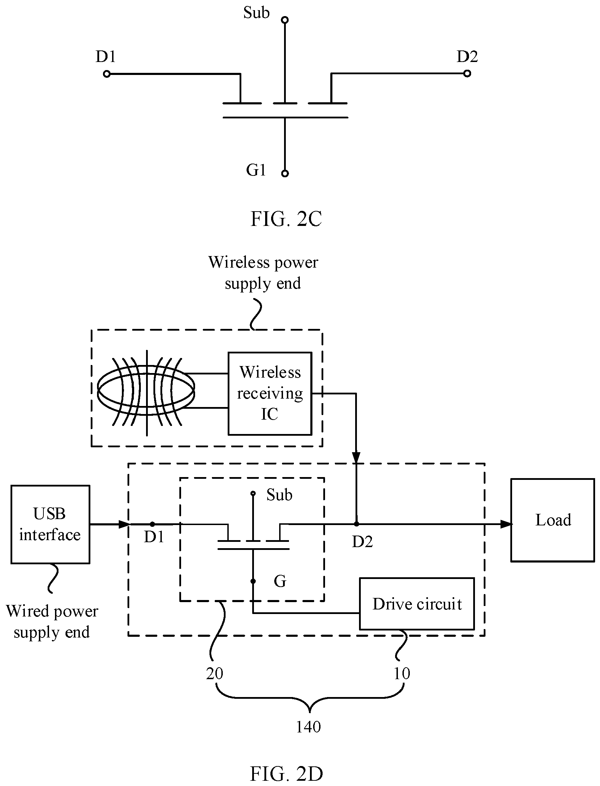

As shown in FIG. 2B, the HEMTs device includes a substrate (Substrate), a buffer layer, a channel layer, a barrier layer, a first drain electrode D1, a second drain electrode D2, and a gate electrode G that are disposed on the substrate. A material of the substrate is usually a conductor or a semiconductor. Therefore, an electrode formed by the substrate is referred to as a substrate electrode Sub. In other words, the HEMTs device includes the first drain electrode D1, the second drain electrode D2, the gate electrode G, and the substrate electrode Sub. As shown in FIG. 2C, under control of the gate electrode G, the first drain electrode D1 and the second drain electrode D2 may be bi-directionally conducted and blocked.

Based on this, as shown in FIG. 2D, the charging protection circuit 20 needs only one HEMTs device, and there is no need to connect two HEMTs devices in series. Therefore, a size of the charging protection circuit 20 is greatly reduced, and a characteristic resistance may be effectively reduced.

It can be learned from the foregoing description that the charging protection circuit 20 is configured to perform, under control of the drive circuit 10, bi-directional protection on the device coupled to the power supply end and the load coupled to the load end.

Therefore, in some embodiments, as shown in FIG. 2D, the charging protection circuit 20 is disposed between a wired power supply end and a load, and is configured to perform bi-directional protection on a device coupled to the wired power supply end and the load coupled to a load end.

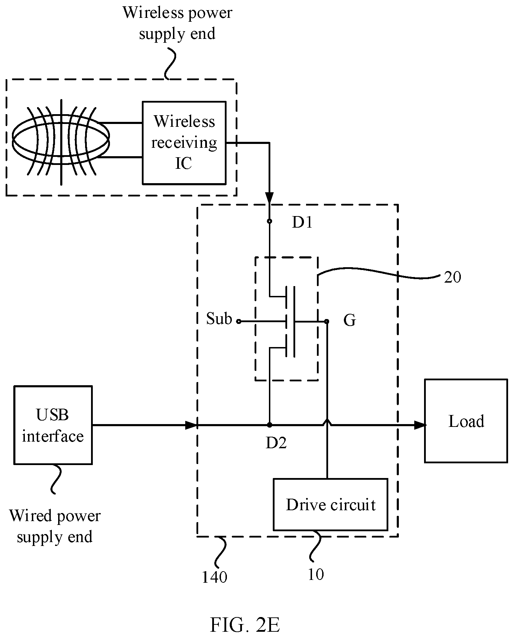

In some other embodiments, as shown in FIG. 2E, the charging protection circuit 20 is disposed between a wireless power supply end and a load, and is configured to perform bi-directional protection on a device coupled to the wireless power supply end and the load coupled to a load end.

It should be understood that a difference between the bi-directional HEMTs device and the conventional HEMTs device (a uni-directional HEMTs device) lies in that: The conventional HEMTs device includes a source electrode (Source), a drain electrode (Drain), a gate electrode (G), and a substrate electrode (Sub), where the substrate electrode is coupled to the source electrode. No matter whether the HEMTs device is turned on or off, a potential of the substrate electrode Sub is usually equal to that of the source electrode. However, the bi-directional HEMTs device includes a first drain electrode D1, a second drain electrode D2, a gate electrode G, and a substrate electrode Sub without a source electrode. To implement effective bi-directional conduction and bi-directional blocking functions, the substrate electrode Sub needs to be separately controlled. In an application process, if the potential of the substrate electrode Sub is not properly processed, problems such as an increase in a turn-on resistance of the HEMTs device and an insufficient breakdown voltage may be caused.

Therefore, to ensure that a function of the charging protection circuit 20 to which the bi-directional HEMTs device is applied is normally implemented, and fully utilize a performance advantage of the HEMTs device, the potential of the substrate electrode Sub of the bi-directional HEMTs device needs to be controlled.

The following shows several common manners of controlling a potential of a substrate electrode Sub.

### Manner 1

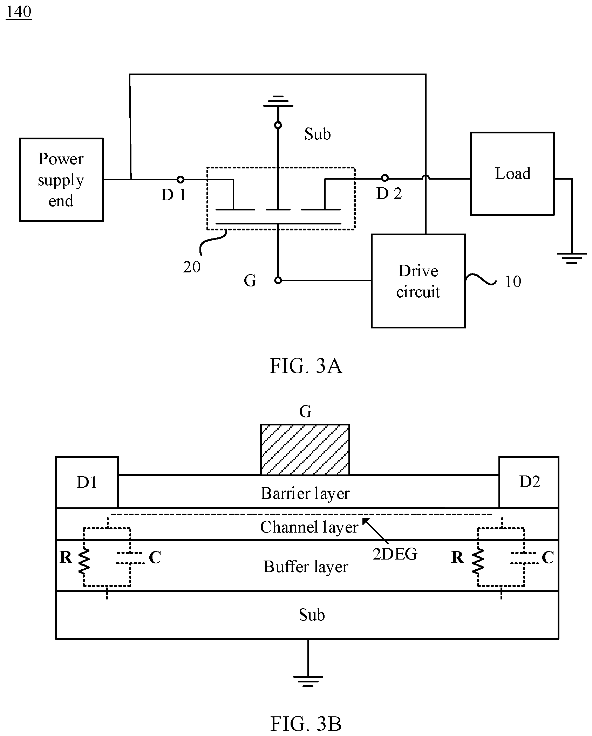

As shown in FIG. 3A, when a bi-directional HEMTs device is applied to the charging protection circuit 20, a substrate electrode Sub of the HEMTs device is directly grounded. In this way, although a potential of the substrate electrode Sub is grounded when the HEMTs device is turned off, a breakdown voltage characteristic of the HEMTs device is not affected. However, when the HEMTs device is turned on, a voltage of a first drain electrode D1 is greater than 0 V. When the substrate electrode Sub is at a low potential relative to both the first drain electrode D1 and a second drain electrode D2, performance of the HEMTs device is degraded due to back-gate effect.

As shown in FIG. 3B, a buffer layer (buffer) and a channel layer (channel) of the HEMTs device have an equivalent effect of a parasitic capacitor C and a parasitic resistor R with a very large resistance value, and the parasitic capacitor C and the parasitic resistor R are connected in parallel. For example, when a voltage of the first drain electrode D1 is VD1 = 25 V, the parasitic capacitor is charged, and a large amount of negative charge is induced inside the substrate electrode Sub (for example, a Si substrate), and a fixed charge with positive charge is induced close to the channel layer and near a heterojunction between the barrier layer and the channel layer, to compensate for channel electrons, which causes broadening of a channel depletion region and a decrease of a 2DEG electron concentration.

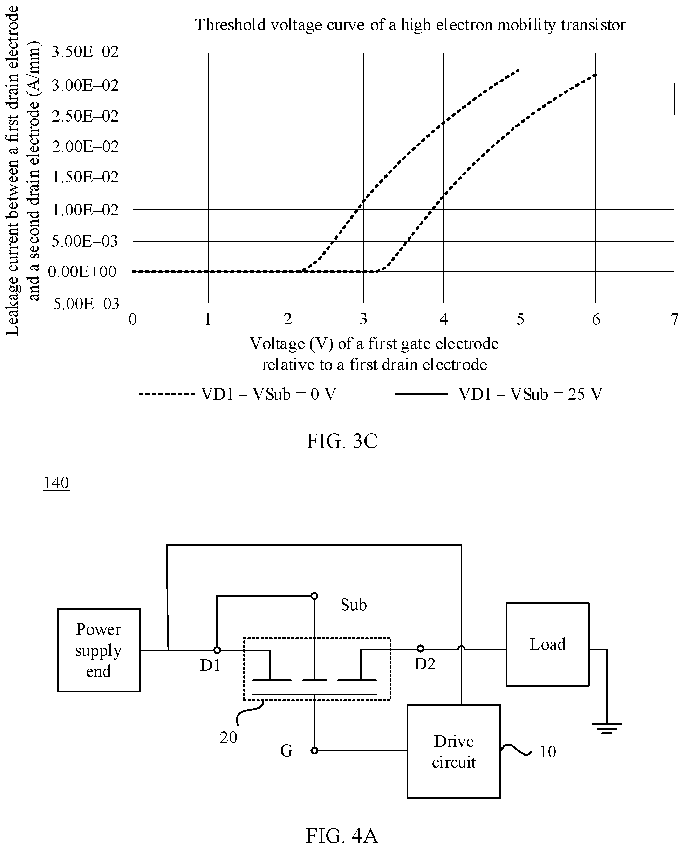

For example, when the buffer layer in the HEMTs device is GaN (gallium nitride) with a thickness of 1 µm, and VD1 - VSub = 25 V, a surface density of the negative charge induced by the Si substrate electrode Sub is approximately Q = C × V = 1.3e12 cm - 2. In the foregoing formula, Q is a charge quantity, and C is a capacitance value of the parasitic capacitor, Visa voltage drop between the substrate electrode Sub and the first drain electrode D1 or the second drain electrode D2. However, the 2DEG concentration of the HEMTs device is normally 8 to 10e12 cm - 2. Consequently, the 2DEG concentration is decreased by approximately more than 20%. As a result, as shown in FIG. 3C, compared with a threshold voltage (Vth) of VD1 - VSub = 0 V (without a bias voltage), a threshold voltage of VD1 - VSub = 25 V (with a bias voltage) is forward drifted, and a turn-on resistance is increased. In addition, a turn-on impedance of a device is increased by more than 20% with a same gate voltage.

### Manner 2

As shown in FIG. 4A, when a bi-directional HEMTs device is applied to the charging protection circuit 20, a substrate electrode Sub of the HEMTs device is directly coupled to a first drain electrode D1 or a second drain electrode D2 (in FIG. 4A, an example in which the substrate electrode Sub is coupled to the first drain electrode D1 is used for illustration).

In this way, when the HEMTs device is turned on, VD1 = VSub ≈ VD2 (if a voltage drop of the HEMTs device is ignored, VD1 = VSub = VD2), which is similar to a working state of a conventional HEMTs device, and direct current characteristics such as a threshold voltage and a turn-on impedance of the HEMTs device are not affected.

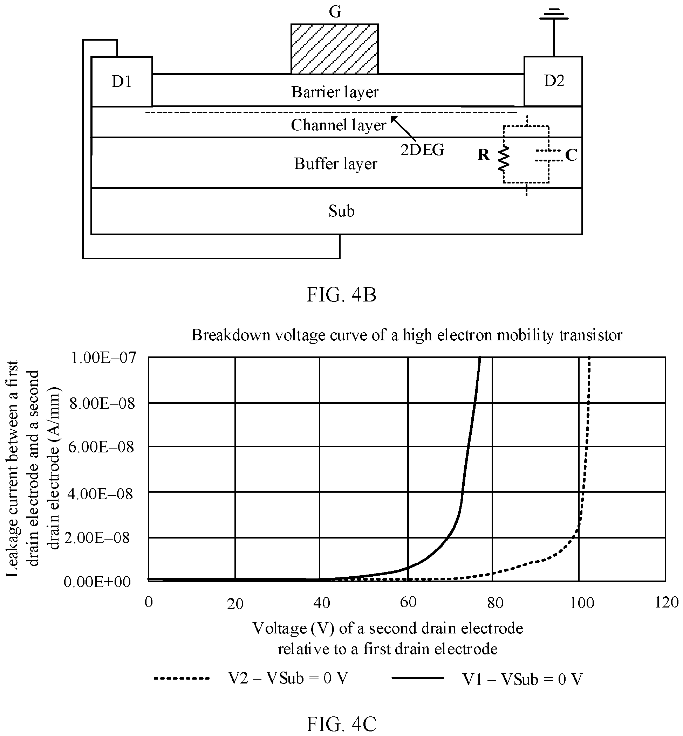

However, as shown in FIG. 4B, when the HEMTs device is turned off, if VD2 is at a high potential (when the load is wirelessly charged by using the wireless power supply end shown in FIG. 2D), the HEMTs device is equivalent to a conventional HEMTs device, and a breakdown characteristic is not affected. However, if VD1 is at a high potential (when a surge occurs in a process in which the wired power supply end shown in FIG. 2D performs wired charging on the load), VD2 is at a low potential, VD1 - VSub = 0 V, and VSub - VD2 > 0 V, the substrate electrode Sub induces a positive charge, which causes a narrower width of a depletion region at a channel. As a result, channel punch-through easily occurs in the HEMTs device at a low voltage, and consequently a breakdown voltage capability is insufficient, which is shown in FIG. 4C.

### Manner 3

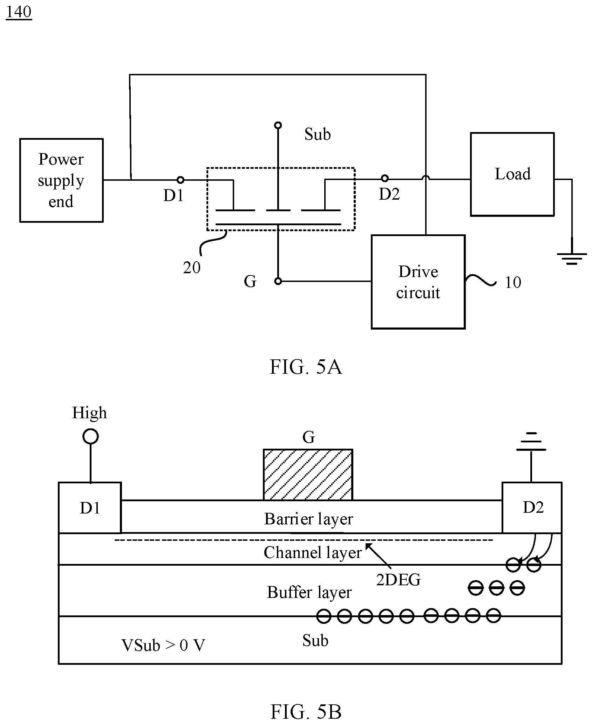

As shown in FIG. 5A, when a bi-directional HEMTs device is applied to the charging protection circuit 20, floating (floating) processing is directly performed on a substrate electrode Sub of the HEMTs device.

As shown in FIG. 5B, when the HEMTs device is turned off, if VD1 is at a high potential, and VD1 is at a low potential, the substrate electrode Sub is floated. In this case, a potential of the substrate electrode Sub is affected by a parasitic capacitor, and VSub > 0 V. Therefore, electrons are injected at a second drain electrode D2. One part of the injected electrons is captured by a defect of an epitaxial layer (for example, a buffer layer), and the other part flows to the substrate electrode Sub and is bound to the epitaxial layer/substrate potential well.

As shown in FIG. 5C, when the HEMTs device is turned on, the electrons captured by the epitaxial layer cannot be released in a timely manner, and the electrons bound to the epitaxial layer/substrate potential well cannot be discharged, which causes charge accumulation. As a result, VSub - VD1 < 0 V. Therefore, similar to Manner 1, when the HEMTs device is turned on, the epitaxial layer and the substrate have a negative charge, which has weakening effect on the channel 2DEG. As a result, a turn-on resistance of the HEMTs device is increased.

With reference to the foregoing description, it can be learned that when the bi-directional HEMTs device is applied to the charging protection circuit 20, if the substrate electrode Sub of the HEMTs device is directly grounded (Manner 1), the threshold voltage of the HEMTs device is forward drifted and the turn-on resistance is increased. If the substrate electrode Sub of the HEMTs device is coupled to the first drain electrode D1 or the second drain electrode D2 (Manner 2), the breakdown voltage capability of the HEMTs device is insufficient. If the substrate electrode Sub of the HEMTs device is floated (Manner 3), the turn-on resistance of the HEMTs device is increased.

To resolve the foregoing problems, an embodiment of this application further provides a charging protection circuit 20, configured to process a substrate electrode Sub of a bi-directional HEMTs device, to ensure a turn-on characteristic during turn-on of the HEMTs device and a breakdown voltage characteristic during turn-off of the HEMTs device.

The following describes the charging protection circuit 20 provided in this embodiment of this application by using several detailed examples.

### Example 1

As shown in FIG. 6, the charging protection circuit 20 includes a first switching transistor 21, a pull-up circuit 22, and a pull-down circuit 23.

The first switching transistor 21 has a characteristic of bi-directional conduction and bi-directional blocking. The first switching transistor 21 includes a first drain electrode D1, a second drain electrode D2, a first gate electrode G1, and a substrate electrode Sub. The first drain electrode D1 is configured to receive a signal from the second drain electrode, the second drain electrode D2 is configured to receive a signal from the first drain electrode, and the first gate electrode G1 is configured to control the first switching transistor 21 to be turned on or turned off.

In this embodiment of this application, the first switching transistor 21 may be a HEMTs device (for example, a GaN-based HEMTs, a Ga₂O₃-based HEMTs, or a GaAs-based HEMTs), or the first switching transistor 21 may be a MOSFET device. Certainly, the first switching transistor 21 may alternatively be another switching device having a bi-directional conduction function. This is not limited in this embodiment of this application. The following uses only an example in which the first switching transistor 21 is an N-type HEMTs device for description.

For example, when the charging protection circuit 20 is applied to the electronic device 100, the first drain electrode D1 is coupled to the power supply end, the second drain electrode D2 is coupled to the load, and the first gate electrode G1 is coupled to the drive circuit 10. The drive circuit 10 is configured to provide a first control signal for the first gate electrode G1. After receiving the first control signal, the first gate electrode G1 controls turn-on or turn-off of the first switching transistor 21 based on a magnitude of the first control signal. When the first gate electrode G1 controls the first switching transistor 21 to be turned on, the first drain electrode D1 is connected to the second drain electrode D2. When the first control signal controls the first switching transistor 21 to be turned off, the first drain electrode D1 is disconnected from the second drain electrode D2.

When the load receives electricity from the power supply end (the electronic device 100 is charged), the first drain electrode D1 is configured to receive a power supply voltage Vsy of the power supply end, and transmit the power supply voltage Vsy to the second drain electrode D2. The second drain electrode D2 transmits the power supply voltage Vsy to the load. In other words, the first drain electrode D1 receives the power supply voltage Vsy provided by the power supply end, and the second drain electrode D2 receives a signal (the power supply voltage Vsy transmitted by the first drain electrode D1) from the first drain electrode D1.

When the load discharges electricity to the power supply end (the electronic device 100 charges an external device), the second drain electrode D2 is configured to receive electricity discharged by the load, and transmit a discharge voltage to the first drain electrode D1. The first drain electrode D1 transmits the discharge voltage to the external device coupled to the power supply end. In other words, the second drain electrode D2 receives the discharge voltage provided by the load, and the first drain electrode D1 receives a signal (the discharge voltage transmitted by the second drain electrode D2) from the second drain electrode D2.

In other words, signals received by the first drain electrode D1 include the power supply voltage Vsy provided by the power supply end and the signal output by the second drain electrode D2, and signals received by the second drain electrode D2 include the discharge voltage provided by the load and the signal output by the first drain electrode D1.

In other words, the first drain electrode D1 may be configured to receive a signal, or may be configured to output a signal. Similarly, the second drain electrode D2 may be configured to receive a signal, or may be configured to output a signal.

It should be noted that when the first switching transistor 21 is turned on, a voltage drop of the first switching transistor 21 is relatively small. In other words, when the first switching transistor 21 is turned on, voltages of the first drain electrode D1 and the second drain electrode D2 are approximately equal, and a difference is very small (the difference is the voltage drop of the first switching transistor 21). Therefore, it should be understood that in this embodiment of this application, if the voltage of the first drain electrode D1 is equal to the voltage of the second drain electrode D2, the voltage drop of the first switching transistor 21 is actually ignored.

The pull-up circuit 22 is coupled to the first gate electrode G1 and the substrate electrode Sub, and is configured to: when the first switching transistor 21 is turned on, adjust a potential of the substrate electrode Sub to a threshold, to ensure that a turn-on characteristic of the first switching transistor 21 is not affected.

The pull-up circuit 22 adjusts the potential of the substrate electrode Sub to the threshold, so as to adjust, when the first switching transistor 21 is turned on, the potential of the substrate electrode Sub to a potential that can ensure the turn-on characteristic of the first switching transistor 21. Therefore, selection of the threshold is not limited in this embodiment of this application, provided that the turn-on characteristic of the first switching transistor 21 can be ensured. The threshold may be adjusted by adjusting a structure of the pull-up circuit 22.

When the first switching transistor 21 is turned on, as long as the potential of the substrate electrode Sub is greater than or equal to a potential in a range from a half potential of the first drain electrode D1 to a potential of the first gate electrode G1, or as long as the potential of the substrate electrode Sub is greater than or equal to a potential in a range from a half potential of the second drain electrode D2 to a potential of the first gate electrode G1, it may be ensured that the turn-on characteristic of the first switching transistor 21 is not affected.

Therefore, the threshold is a potential that ensures that the turn-on characteristic of the first switching transistor 21 is not affected (for example, a turn-on resistance is not increased). For example, the threshold is any potential in the range from the half potential of the first drain electrode D1 to the potential of the first gate electrode G1, or is any potential in the range from the half potential of the second drain electrode D2 to the potential of the first gate electrode G1.

For example, the threshold may be a potential of the first drain electrode D1, a potential of the second drain electrode D2, the potential of the first gate electrode G1, any potential greater than the half potential of the first drain electrode D1, or any potential greater than the half potential of the second drain electrode D2. Alternatively, the threshold may be greater than or equal to a lower potential of the first drain electrode D1 and the second drain electrode D2.

The following first briefly describes the pull-down circuit 23, and then describes structures of the pull-up circuit 22 and the pull-down circuit 23 in detail.

The pull-down circuit 23 is coupled to the substrate electrode Sub and a fixed signal end, and is configured to: when the first switching transistor 21 is turned off, adjust the potential of the substrate electrode Sub to a potential of the fixed signal end, to ensure that a breakdown voltage characteristic of the first switching transistor 21 is not affected.

The pull-down circuit 23 adjusts the potential of the substrate electrode Sub to the potential of the fixed signal end, so as to adjust, when the first switching transistor 21 is turned off, the potential of the substrate electrode Sub to the potential of the fixed signal end that can ensure the breakdown voltage characteristic of the first switching transistor 21. Therefore, in this embodiment of this application, a potential of a signal transmitted by the fixed signal end is not limited, provided that the breakdown voltage characteristic of the first switching transistor 21 can be ensured.

In some embodiments, the potential of the fixed signal end is less than or equal to a lower potential of the first drain electrode D1 and the second drain electrode D2 during turn-off of the first switching transistor 21.

Alternatively, it is understood that the potential of the fixed signal end is less than or equal to the potential of the first drain electrode D1 during turn-off of the first switching transistor 21, and the potential of the fixed signal end is less than or equal to the potential of the second drain electrode D2 during turn-off of the first switching transistor 21. Alternatively, it may be understood that when the first switching transistor 21 is turned off, both the potential of the first drain electrode D1 and the potential of the second drain electrode D2 are greater than the potential of the fixed signal end.

For example, the potential of the fixed signal end is less than or equal to 0. For example, the fixed signal end is a reference ground end (ground, GND). In other words, a potential of a signal transmitted by the fixed signal end is 0. Alternatively, a potential of a signal transmitted by the fixed signal end is a potential less than 0. In the following, an example in which the fixed signal end is the reference ground end GND is used for illustration.

Based on this, a driving process of the charging protection circuit 20 provided in this example includes the following steps.

During normal wired charging (the electronic device is charged), the first switching transistor 21 is turned on under control of the first control signal received by the first gate electrode G1, and the first drain electrode D1 transmits the received power supply voltage Vsy to the second drain electrode D2 for output. At the same time, the pull-up circuit 22 adjusts the potential of the substrate electrode Sub to the threshold.

During normal reverse charging (the electronic device charges an external device), the first switching transistor 21 is turned on under control of the first control signal received by the first gate electrode G1, and the second drain electrode D2 transmits the received discharge voltage to the first drain electrode D1 for output. At the same time, the pull-up circuit 22 adjusts the potential of the substrate electrode Sub to the threshold.

A principle of normal wired charging is the same as that of normal reverse charging. The following uses only normal wired charging as an example for description.

When a surge occurs in wired charging or during wireless charging, the first switching transistor 21 is turned off under control of the first control signal received by the first gate electrode G1, and the pull-down circuit 23 adjusts the potential of the substrate electrode Sub to the potential of the fixed signal end.

With respect to the structures of the pull-up circuit 22 and the pull-down circuit 23, in some embodiments, as shown in FIG. 7A, the pull-up circuit 22 includes a first resistor R1 and a second switching transistor SW2.

A second gate electrode of the second switching transistor SW2 is coupled to the first gate electrode G1, a first electrode of the second switching transistor SW2 is coupled to a second end of the first resistor R1, and a second electrode of the second switching transistor SW2 is coupled to the substrate electrode Sub.

A first end of the first resistor R1 is coupled to the first gate electrode G1, and the second end of the first resistor R1 is coupled to the substrate electrode Sub by using the second switching transistor SW2.

It should be noted that the first switching transistor 21 is a bi-directional switching transistor, and includes the first drain electrode D1, the second drain electrode D2, the first gate electrode G1, and the substrate electrode Sub. The second switching transistor SW2 is a conventional switching transistor, that is, includes three ends: a source electrode, a drain electrode, and a second gate electrode. Therefore, the first electrode and the second electrode of the second switching transistor SW2 are a source electrode and a drain electrode of each other. In this embodiment of this application, unless otherwise specified, the first electrode and the second electrode of the switching transistor are the source electrode and the drain electrode of the switching transistor. Specifically, whether the first electrode is a source electrode or a drain electrode is related to a type of the switching transistor. For example, in Example 1, in FIG. 7A, the first electrode of the second switching transistor SW2 is a drain electrode, and the second electrode of the second switching transistor SW2 is a source electrode.

The second gate electrode of the second switching transistor SW2 is coupled to the first gate electrode G1 of the first switching transistor 21, and a threshold voltage of the second switching transistor SW2 may be equal to a threshold voltage of the first switching transistor 21. In other words, the first control signal controls the first switching transistor 21 and the second switching transistor SW2 to be simultaneously turned on and turned off.

The first control signal controls turn-on or turn-off of the first switching transistor 21 and the second switching transistor SW2. It is generally considered that, when a potential difference of the first control signal relative to the lower potential of the first drain electrode D1 and the second drain electrode D2 is higher than the threshold voltages of the first switching transistor 21 and the second switching transistor SW2, the first switching transistor 21 and the second switching transistor SW2 are turned on. When the potential difference of the first control signal relative to the lower potential of the first drain electrode D1 and the second drain electrode D2 is lower than the threshold voltages of the first switching transistor 21 and the second switching transistor SW2, the first switching transistor 21 and the second switching transistor SW2 are turned off.

The pull-down circuit includes a second resistor R2. A first end of the second resistor R2 is coupled to the substrate electrode Sub, and a second end of the second resistor R2 is coupled to the reference ground end GND.

In some embodiments, both the first switching transistor 21 and the second switching transistor SW2 may be HEMTs devices, or may be MOSFET devices. Definitely, the first switching transistor 21 and the second switching transistor SW2 may alternatively be different types of devices.

In some embodiments, the first switching transistor 21 and the second switching transistor SW2 share the same substrate electrode Sub.

In some embodiments, the first resistor R1 is integrated onto the substrate electrode Sub.

In some embodiments, the second resistor R2 is also integrated onto the substrate electrode Sub.

For example, the first switching transistor 21 is a HEMTs device, the second switching transistor SW2 is a MOSFET device, and the MOSFET device may be directly formed on a Si substrate (the Si substrate is the substrate electrode Sub of the HEMTs device) of the HEMTs device. The first resistor R1 and the second resistor R2 are formed by using a square resistor of the HEMTs device, and metal layers at two ends may be formed synchronously with the first drain electrode D1 and the second drain electrode D2 of the HEMTs device.

Alternatively, for example, as shown in FIG. 7B-1 and FIG. 7B-2, both the first switching transistor 21 and the second switching transistor SW2 are HEMTs devices, and the first switching transistor 21 and the second switching transistor SW2 share a same substrate. The first resistor R1 and the second resistor R2 are formed by using a square resistor of the HEMTs device, and metal layers at two ends may be formed synchronously with the first drain electrode D1 and the second drain electrode D2 of the HEMTs device.

The first switching transistor 21 is selected as a bi-directional HEMTs device prepared by using GaN (gallium nitride), Ga₂O₃ (gallium oxide), or GaAs (gallium arsenide). Compared with a bi-directional MOSFET device, a turn-on impedance of the bi-directional HEMTs device may theoretically be reduced by one order of magnitude with a same breakdown voltage. In an actual low-voltage application (30 V), the turn-on impedance may also be optimized by more than one time. If a 2 mm × 2 mm wafer level chip scale package (wafer level chip scale package, WLCSP) is used for packaging, the turn-on impedance of the HEMTs device may reach 5 ohms. In addition, the HEMTs device has no parasitic diode, has a simpler structure, and has no parasitic NPN-type triode structure. When the HEMTs device is turned off, the breakdown voltage characteristic may be met without pulling the potential of the substrate electrode Sub down to the potential of the reference ground end GND.

For example, as shown in FIG. 7C, a method for preparing the charging protection circuit 20 includes the following steps.

Step 1: Select a substrate.

The substrate is used to serve as the substrate electrode Sub of the first switching transistor 21. For example, the substrate may be a Si substrate.

Step 2: Form a nucleation layer (nucleation layer) on the substrate.

A method for forming the nucleation layer 40 may be, for example, a metal-organic chemical vapor deposition (metal-organic chemical vapor deposition, MOCVD) growth method or a molecular beam epitaxy (molecular beam epitaxy, MBE) growth method.

A material of the nucleation layer 40 may include, for example, one or more of GaN, AlGaN (aluminum gallium nitrogen), and AlN (aluminum nitride).

The nucleation layer is used to provide a nucleation center and promote epitaxial growth of a buffer layer.

Step 3: Form a buffer layer (buffer layer) on the nucleation layer.

For a method for forming the buffer layer, for example, an AlGaN gradient layer whose Al (aluminum) components gradually decrease may be epitaxially grown by using an MOCVD process.

For example, an Al_{0.8}Ga_{0.2} N layer, an Al_{0.5}Ga_{0.5} N layer, an Al_{0.2}Ga_{0.8} N layer, and a GaN layer are sequentially formed on the nucleation layer by using the MOCVD process, to form the buffer layer.

Step 4: Form a channel layer (channel layer) on the buffer layer.

A method for forming the channel layer may be, for example, the MOCVD growth method or the MBE growth method.

A material of the channel layer may include, for example, one or more of GaN, InGaN, InAlN (indium aluminum nitride), and ScAlN (scandium aluminum nitride).

Step 5: Form a barrier layer (barrier layer) on the channel layer.

A method for forming the barrier layer may be, for example, the MOCVD growth method or the MBE growth method.

A material of the barrier layer may include, for example, one or more of AlGaN, InAlN, AlN, ScAlN and InAlGaN.

Materials of the channel layer and the barrier layer are different. For example, the material of the channel layer includes GaN, and the material of the barrier layer includes AlGaN.

Step 6: Form a p-type thin film on the barrier layer.

A method for forming the p-type thin film may be, for example, the MOCVD growth method or the MBE growth method.

A material of the gate cap film may be, for example, p-GaN or p-AlGaN.

Step 7: Form a gate metal layer on the p-type thin film.

The gate metal layer includes the first gate electrode G1 of the first switching transistor 21 and the second gate electrode G2 of the second switching transistor SW2.

A method for forming the gate metal layer may be, for example, a picture composition process (including steps such as film forming and photoetching).

A material of the gate metal layer may be, for example, Ti, TiN, Ni, or palladium (Pd).

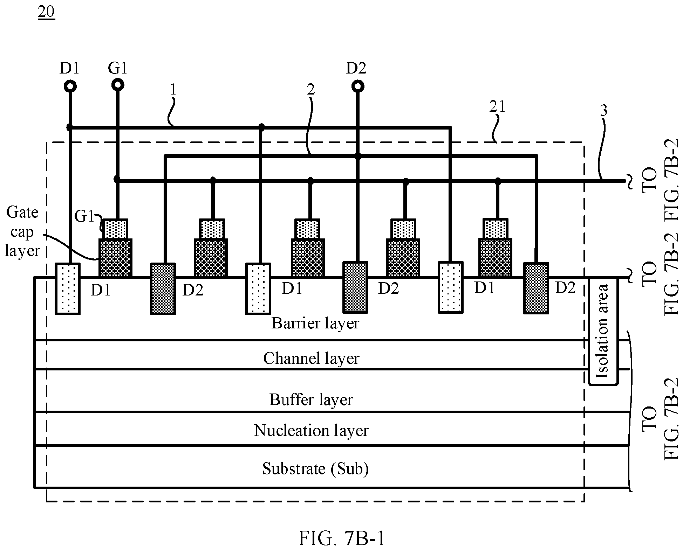

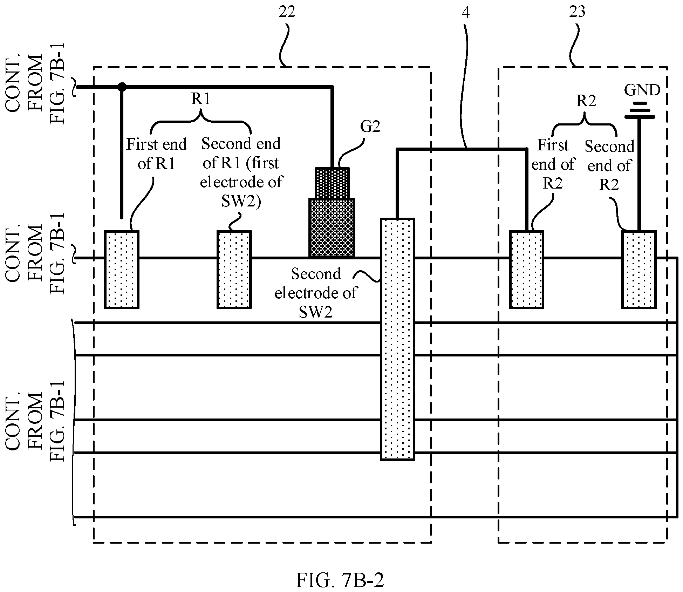

It should be noted that, multiple first gate electrodes G1 shown in FIG. 7B-1 are only multiple signal lead-out points of the first gate electrode G1 of the first switching transistor 21, and the multiple first gate electrodes G1 serving as the lead-out points receive the first control signal after being coupled.

Step 8: Etch the p-type thin film by using the gate metal layer as a mask to form a gate cap layer.

The gate cap layer is used to adjust an energy band structure of a heterojunction structure between the barrier layer and the channel layer, so that 2DEG under the gate cap layer is exhausted and 2DEG in other areas is reserved. In this way, the 2DEG in the HEMTs device is in a pinch-off state without a bias voltage, the 2DEG cannot communicate and flow in the channel layer between the first drain electrode D1 and the second drain electrode D2, and the HEMTs device is in a closed state, so that the HEMTs device is a normally closed device. A material of the gate cap layer may be, for example, p-GaN or p-AlGaN.

Step 9: Remove an epitaxial layer of some areas through deep trench etching (through GaN via, TGV).

In this step, on one hand, a cutting path may be formed, and on the other hand, a through hole for connecting the second electrode of the second switching transistor SW2 to the substrate electrode Sub may be formed.

Step 10: Form a source-drain metal layer.

The source-drain metal layer includes the first drain electrode D1, the second drain electrode D2, the first electrode and the second electrode of the second switching transistor SW2, first-end metal and second-end metal of the first resistor R1, and first-end metal and second-end metal of the second resistor R2.

A method for forming the source-drain metal layer may be, for example, a picture composition process (including steps such as film forming and photoetching).

Materials of the source-drain metal layer may be, for example, a titanium (Ti) layer, an Al layer, a nickel (Ni) layer, and an aurum (Au) layer that are sequentially stacked. In other words, the source-drain metal layer is Ti/Al/Ni/Au. Alternatively, materials of the source-drain metal layer may be a Ti layer, an Al layer, a Ti layer, and an Au layer that are sequentially stacked. In other words, the source-drain metal layer is Ti/Al/Ti/Au. Alternatively, materials of the source-drain metal layer may be a Ti layer, an Al layer, and a tin (TiN) layer that are sequentially stacked. In other words, the source-drain metal layer is Ti/Al/TiN. Alternatively, materials of the source-drain metal layer may be a tantalum (Ta) layer, an Al layer, and a TiN layer that are sequentially stacked. In other words, the source-drain metal layer is Ta/Al/TiN. Alternatively, materials of the source-drain metal layer may be a Ta layer, an Al layer, and a Ta layer that are sequentially stacked. In other words, the source-drain metal layer is Ta/Al/Ta.

It needs to be noted that in the first switching transistor 21 in FIG. 7B-1, multiple groups of first drain electrodes D1 and second drain electrodes D2 are shown as an example. However, in practice, the first switching transistor 21 in a circuit application may be simplified into one group of a first drain electrode D1 and a second drain electrode D2. Multiple first drain electrodes D1 shown in FIG. 7B-1 are only multiple signal lead-out points of the first drain electrode D1 of the first switching transistor 21, and the multiple first drain electrodes D1 serving as the lead-out points are coupled. Similarly, multiple second drain electrodes D2 shown in FIG. 7B-1 are only multiple signal lead-out points of the second drain electrode D2 of the first switching transistor 21, and the multiple second drain electrodes D2 serving as the lead-out points are coupled.

Step 11: Form an isolation area between devices.

A method for forming the isolation area may be, for example, an injection process or an etching process, so that an electron blocking function exists between different functional devices.

In some embodiments, as shown in FIG. 7B-1 and FIG. 7B-2, to avoid signal interference between the first switching transistor 21 and the second switching transistor SW2, an isolation area is formed between the first switching transistor 21 and the second switching transistor SW2.

Certainly, an isolation area may also be formed between the second switching transistor SW2 and the second resistor R2 as required. Alternatively, an isolation area is formed in another place at which the isolation area is required, so as to reduce interference between devices. Alternatively, the isolation area may not be formed as required. In other words, step 11 does not need to be performed in the process of preparing the charging protection circuit 20.

Step 12: Form a passivation layer.

A via hole on the passivation layer exposes the source-drain metal layer and the gate metal layer. The passivation layer is not shown in FIG. 7B-1 and FIG. 7B-2.

Step 13: Form a wiring layer.

The wiring layer includes a first wiring 1 that couples multiple lead-out points of the first drain electrode D1, a second wiring 2 that couples multiple lead-out points of the second drain electrode D2, a third wiring 3 that couples multiple lead-out points of the first gate electrode G1, the second gate electrode G2, and the first end of the first resistor R1, and a fourth wiring 4 that couples the second electrode of the second switching transistor SW2 and the first end of the second resistor R2. The second electrode of the second switching transistor SW2 is coupled to the substrate electrode Sub, and the first end of the second resistor R2 is coupled to the second electrode of the second switching transistor SW2 by using the wiring 4, so that the first end of the second resistor R2 is coupled to the substrate electrode Sub.

It should be noted that during preparation of the charging protection circuit 20, step 13 may or may not be included depending on a requirement. In this embodiment of this application, an example in which step 13 is included during preparation of the charging protection circuit 20 is used for description.

The charging protection circuit 20 prepared by using the foregoing method is shown in FIG. 7B-1 and FIG. 7B-2. In the pull-up circuit 22, the second gate electrode G2 of the second switching transistor SW2 is coupled to the first gate electrode G1, the first electrode of the second switching transistor SW2 is coupled to the second end of the first resistor R1, and the second electrode of the second switching transistor SW2 is coupled to the substrate electrode Sub. The first end of the first resistor R1 is coupled to the first gate electrode G1. In the pull-down circuit 23, the first end of the second resistor R2 is coupled to the substrate electrode Sub, and the second end of the second resistor R2 is coupled to the reference ground end GND.

Based on this, for the charging protection circuit 20 shown in FIG. 7A, as shown in FIG. 7D, during normal wired charging, the first control signal received by the first gate electrode G1 is a high-level turn-on signal, and the first gate electrode G1 controls the first switching transistor 21 to be turned on. The second gate electrode G2 of the second switching transistor SW2 also receives the first control signal, the threshold voltage of the second switching transistor SW2 may be basically the same as the threshold voltage of the first switching transistor 21, and the second gate electrode G2 controls the second switching transistor SW2 to be turned on. When the second switching transistor SW2 is completely turned on, an impedance of the second switching transistor SW2 is much less than an impedance of the first resistor R1 and an impedance of the second resistor R2. Therefore, after the first control signal (a high-level signal) that is received by the first gate electrode G1 and that controls the first switching transistor 21 to be turned on passes through the first resistor R1 and the second switching transistor SW2, the potential of the substrate electrode Sub is adjusted to the threshold (for example, R2/(R1 + R2) × VG1) by the voltage division action of the first resistor R1 and the second resistor R2, to ensure that the turn-on characteristic of the first switching transistor 21 is not affected.

In other words, the potential VSub of the substrate electrode Sub is approximately VSub = R2/(R1 + R2) × VG1. In other words, a threshold point is approximately VSub = R2/(R1 + R2) × VG1. VG1 is a voltage of the first gate electrode G1. Therefore, by adjusting values of the first resistor R1 and the second resistor R2, or by adjusting a ratio of the first resistor R1 to the second resistor R2, the potential VSub of the substrate electrode Sub may be randomly adjusted between VD1 and VG1 when the first switching transistor 21 is turned on, to properly improve the turn-on resistance of the device.

With respect to selection of the ratio of the first resistor R1 to the second resistor R2, in some embodiments, the ratio of the first resistor R1 to the second resistor R2 is equal to a ratio of the potential of the first gate electrode G1 to the potential of the first drain electrode D1. In other words, R1/R2 = VG1/VD1.

In this case, VSub = VD1 due to voltage division of the first resistor R1 and the second resistor R2, that is, VSub - VD1 = 0. To be specific, the threshold voltage is the voltage of the first drain electrode D1. In other words, during normal charging, the potential of the substrate electrode Sub is adjusted to the potential of the first drain electrode D1, so that the turn-on impedance of the first switching transistor 21 is not affected. In addition, a gate voltage drop of the second switching transistor SW2 is approximately a gate voltage drop of the first switching transistor 21, so that reliability of the first gate electrode and the second gate electrode is not affected.

For example, when the first switching transistor 21 is turned on, VD1 ≈ VD2 = 30 V, and VG1 = 35 V. When R1:R2 = VG1:VD1 = 1:6 is selected, VSub = VD1 = VD2 = 30 V.

By making a voltage drop between the substrate electrode Sub and the first drain electrode D1 relatively small, for example, VSub - VD1 = 0, a leakage current (through the buffer layer) between the substrate electrode Sub and the first drain electrode D1 is relatively small, so that an electron capture effect generated when the potential of the substrate electrode Sub is relatively high is reduced, and the impact on a dynamic impedance is relatively small.

In some other embodiments, the ratio of the first resistor R1 to the second resistor R2 is less than a ratio of the potential of the first gate electrode G1 to the potential of the first drain electrode D1. In other words, R1/R2 < VG1/VD1.

In this case, 0 < VSub - VD1 < VG1 - VD1, VD1 < VSub ≤ VG1. In other words, during normal charging, the potential of the substrate electrode Sub is adjusted to be greater than the potential of the first drain electrode D1, so that the turn-on impedance of the first switching transistor 21 is not affected. In addition, a gate voltage drop of the second switching transistor SW2 is approximately a gate voltage drop of the first switching transistor 21, so that the reliability of the first gate electrode and the second gate electrode is not affected.

For example, when the first switching transistor 21 is turned on, VD1 ≈ VD2 = 30 V, VG1 = 35 V. When R1:R2 = VG1:VD1 = 2:33 is selected, VSub = 33/35 × 35 = 33 V.

When the first switching transistor 21 is turned on, the potential of the substrate electrode Sub is appropriately increased, and a positive back-gate effect of the substrate electrode is increased, which helps increase a 2DEG concentration of a channel of the first switching transistor 21 and reduce the turn-on impedance. In addition, the potential VSub of the substrate electrode Sub may be randomly adjusted between VD1 and VG1, to properly improve the turn-on resistance of the device.

In some embodiments, the first resistor R1 is a variable resistor, and the second resistor R2 is a variable resistor.

In this way, in a driving process of the charging protection circuit 20, the ratio of the first resistor R1 to the second resistor R2 may be adjusted as required, so as to increase the potential of the substrate electrode Sub, thereby achieving an effect of dynamically increasing the 2DEG concentration of the channel of the first switching transistor 21 and reducing the turn-on impedance.

On one hand, a leakage current during turn-off of the second switching transistor SW2 is usually at the µA magnitude, that is, a turn-off impedance is at the GS2 magnitude. The impedance of the second resistor R2 needs to be less than the impedance of the second switching transistor SW2. Therefore, the second resistor R2 cannot be too large. On the other hand, when the first switching transistor SW1 is turned on, the leakage current between the substrate electrode Sub and the fixed signal end needs to be small. Therefore, the second resistor R2 cannot be too small. Based on this, in some embodiments, the second resistor R2 is in a value range in the order of kS2 to MΩ.

When a surge occurs on the power supply end of wired charging or during wireless charging, the first control signal received by the first gate electrode G1 changes to a low-level turn-off signal, to control the first switching transistor 21 to be turned off. In this case, the second switching transistor SW2 is also turned off under control of the first control signal. When the second switching transistor SW2 is turned off, the impedance of the second switching transistor SW2 + the impedance of the first resistor R1 is much greater than the impedance of the second resistor R2. Therefore, after the first control signal (a low-level signal) that is received by the first gate electrode G1 and that controls turn-off of the first switching transistor 21 passes through the first resistor R1 and the second switching transistor SW2, the potential of the substrate electrode Sub is adjusted to the potential of the fixed signal end (for example, a potential 0 of the reference ground end GND) by the voltage division action of the first resistor R1, the second switching transistor SW2, and the second resistor R2.

The second resistor R2 is coupled to the fixed signal end. When the first switching transistor 21 is turned off, the potential of the substrate electrode Sub is adjusted to the potential of the fixed signal end, and the potential of the fixed signal end is less than the lower potential of the first drain electrode D1 and the second drain electrode D2. Therefore, the charging protection circuit 20 can make a breakdown characteristic and the breakdown voltage characteristic of the first switching transistor 21 not affected.

In the charging protection circuit 20 shown in FIG. 7A, the pull-up circuit 22 is located between the first gate electrode G1 and the substrate electrode Sub of the first switching transistor 21, and the pull-down circuit 23 is located between the substrate electrode Sub and the fixed signal end. Therefore, a voltage division principle is used, and a ratio of an impedance of the pull-up circuit 22 to an impedance of the pull-down circuit 23 is adjusted, so that the potential VSub of the substrate electrode Sub of the first switching transistor 21 during turn-on may meet VD1 ≤ VSub ≤ VG1 - Vth_21, where Vth_21 is the threshold voltage of the first switching transistor 21.

In addition, when the first switching transistor 21 is turned on, a back gate voltage of the substrate electrode Sub is properly adjusted, so that when a relatively small leakage current is ensured between the substrate electrode Sub and the first drain electrode D1, the 2DEG concentration of the channel can be further adjusted, thereby further reducing the turn-on impedance.

In addition, the first gate electrode G1 of the first switching transistor 21 and the second gate electrode G2 of the second switching transistor SW2 are coupled, and receive a same first control signal, so that a requirement on the drive circuit 10 may be reduced.

With respect to the structures of the pull-up circuit 22 and the pull-down circuit 23, in some other embodiments, as shown in FIG. 8A, the pull-up circuit 22 includes a clamping diode 221 and a second switching transistor SW2, and the pull-down circuit 23 includes a second resistor R2.

A second gate electrode of the second switching transistor SW2 is coupled to the first gate electrode G1 of the first switching transistor 21, a first electrode of the second switching transistor SW2 is coupled to a second end of the clamping diode 221, and a second electrode of the second switching transistor SW2 is coupled to the substrate electrode Sub.

A first end of the clamping diode 221 is coupled to the first gate electrode G1 of the first switching transistor 21, and the second end of the clamping diode 221 is coupled to the substrate electrode Sub by using the second switching transistor SW2.

A structure of the pull-down circuit 23 shown in FIG. 8A is the same as the structure of the pull-down circuit 23 shown in FIG. 7A. Refer to related descriptions, and details are not described herein again.

A structure of the pull-up circuit 22 shown in FIG. 8A differs from the pull-up circuit 22 shown in FIG. 7A in that a voltage drop of the clamping diode 221 is used as an equivalent resistor, and a voltage division principle is used to adjust the potential of the substrate electrode Sub. For the voltage division principle and the first switching transistor 21 and the second switching transistor SW2, refer to related descriptions of the charging protection circuit 20 shown in FIG. 7A.

Based on this, in a driving process of the charging protection circuit 20, during normal wired charging, the first control signal received by the first gate electrode G1 and the second gate electrode G2 is a turn-on signal, and the first gate electrode G1 controls the first switching transistor 21 to be turned on. A threshold voltage of the second switching transistor SW2 is the same as a threshold voltage of the first switching transistor 21, and the second switching transistor SW2 is turned on. The first end of the clamping diode 221 receives the turn-on signal, so that the clamping diode 221 is turned on. A voltage drop of the clamping diode 221 after turn-on of the clamping diode 221 makes a potential of the first control signal decreased after the first control signal passes through the clamping diode 221, and the potential of the substrate electrode Sub is adjusted to a threshold (for example, VG1 - Vdiode), to ensure that the turn-on characteristic of the first switching transistor 21 is not affected.

The threshold may be adjusted by adjusting the voltage drop Vdiode of the clamping diode 221 after turn-on of the clamping diode 221.

In other words, the clamping diode 221 is equivalent to the first resistor R1. Therefore, for selection of the clamping diode 221 and the second resistor R2, reference may be made to the foregoing selection principle of the first resistor R1 and the second resistor R2.

When a surge occurs in wired charging or during wireless charging, the first control signal received by the first gate electrode G1 and the second gate electrode G2 is a turn-off signal, and the first gate electrode G1 controls the first switching transistor 21 to be turned off. A threshold voltage of the second switching transistor SW2 is the same as a threshold voltage of the first switching transistor 21, and the second gate electrode G2 controls the second switching transistor SW2 to be turned off. When the second switching transistor SW2 is turned off, the impedance of the second switching transistor SW2 + the impedance of the clamping diode 221 is much greater than the impedance of the second resistor R2. Therefore, after the first control signal that is received by the first gate electrode G1 and that controls the first switching transistor 21 to be turned off passes through the clamping diode 221 and the second switching transistor SW2, the potential of the substrate electrode Sub is adjusted to the potential of the fixed signal end (for example, a potential 0 of the reference ground end GND) by the voltage division action of the clamping diode 221, the second switching transistor SW2, and the second resistor R2. The second resistor R2 is coupled to the fixed signal end. When the first switching transistor 21 is turned off, the potential of the substrate electrode Sub is adjusted to the potential of the fixed signal end, to ensure that the breakdown voltage characteristic of the first switching transistor 21 is not affected.

With respect to the clamping diode 221, in some embodiments, as shown in FIG. 8B, the first end of the clamping diode 221 is an anode and is coupled to the first gate electrode G1 of the first switching transistor 21, and the second end of the clamping diode 221 is a cathode and is coupled to the substrate electrode Sub by using the second switching transistor SW2.

For example, the clamping diode 21 is a PN diode, a Schottky barrier diode (Schottky barrier diode, SBD), or an equivalent diode formed by short-circuiting a source electrode and a gate electrode in a transistor.

The transistor may be, for example, a metal oxide thin-film transistor or a HEMTs.

With respect to a quantity of clamping diodes 221, as shown in FIG. 8B, the pull-up circuit 22 includes one clamping diode 221.

Alternatively, as shown in FIG. 8C, the pull-up circuit 22 includes multiple clamping diodes connected in series.

The multiple clamping diodes 221 connected in series may be understood as: An anode of the clamping diode 221 closest to the first gate electrode G1 is coupled to the first gate electrode G1, and a cathode of the clamping diode 221 closest to the first gate electrode G1 is coupled to an anode of a next clamping diode 221. By analogy, a cathode of the clamping diode 221 is coupled to an anode of another clamping diode 221. A cathode of the clamping diode 221 closest to the second switching transistor SW2 is coupled to the first electrode of the second switching transistor SW2.

For example, the multiple clamping diodes 221 connected in series may be, for example, multiple PN diodes with a threshold voltage Vth = 0.7 V/single level connected in series, or multiple Schottky barrier diodes with a threshold voltage Vth ≈ 0.3 V/single level connected in series.

As shown in FIG. 8D-1 and FIG. 8D-2, an example in which the pull-up circuit 22 includes two diodes formed by short-circuiting a source electrode and a gate electrode in a conventional HEMTs device is used to describe a method for preparing the charging protection circuit 20 shown in FIG. 8A.

The method for preparing the charging protection circuit 20 shown in FIG. 8D-1 and FIG. 8D-2 has the same steps as the method for preparing the charging protection circuit shown in FIG. 7C. Differences lie in that a structure of the gate metal layer formed in step 7 is different, a structure of the source-drain metal layer formed in step 10 is different, and a structure of the wiring layer formed in step 13 is also different.

For example, the method for preparing the charging protection circuit 20 includes the following steps.

Step 1: Select a substrate.

Step 2: Form a nucleation layer on the substrate.

Step 3: Form a buffer layer on the nucleation layer.

Step 4: Form a channel layer on the buffer layer.

Step 5: Form a barrier layer on the channel layer.

Step 6: Form a p-type thin film on the barrier layer.

Step 7: Form a gate metal layer on the p-type thin film.

As shown in FIG. 8D-1 and FIG. 8D-2, the gate metal layer includes the first gate electrode G1 of the first switching transistor 21, the second gate electrode G2 of the second switching transistor SW2, and gate electrodes G of the HEMTs devices used as diodes.

Step 8: Etch the p-type thin film by using the gate metal layer as a mask to form a gate cap layer.

Step 9: Remove an epitaxial layer of some areas through deep trench etching.

Step 10: Form a source-drain metal layer.

As shown in FIG. 8D-1 and FIG. 8D-2, the source-drain metal layer includes the first drain electrode D1, the second drain electrode D2, the first electrode and the second electrode of the second switching transistor SW2, a source electrode S and a drain electrode D of the HEMTs device used as the diode, and first-end metal and second-end metal of the second resistor R2.

Step 11: Form an isolation area between devices.

Step 12: Form a passivation layer.

Step 13: Form a wiring layer.

As shown in FIG. 8D-1 and FIG. 8D-2, the wiring layer includes a first wiring 1 that couples multiple lead-out points of the first drain electrode D1, a second wiring 2 that couples multiple lead-out points of the second drain electrode D2, and a third wiring 3 that couples multiple lead-out points of the first gate electrode G1, the second gate electrode G2, and the gate electrode G (the anode of the clamping diode 221) of the HEMTs device used as the diode, a fourth wiring 4 that couples the second electrode of the second switching transistor SW2 and the first end of the second resistor R2, and a fifth wiring 5 that couples the drain electrode D (the cathode of the clamping diode 221) of the HEMTs device used as the diode and the first electrode of the second switching transistor SW2.

The charging protection circuit 20 prepared by using the foregoing method is shown in FIG. 8D-1 and FIG. 8D-2. In the pull-up circuit 22, the second gate electrode of the second switching transistor SW2 is coupled to the first gate electrode G1 of the first switching transistor 21, the first electrode of the second switching transistor SW2 is coupled to the second end of the clamping diode 221, and the second electrode of the second switching transistor SW2 is coupled to the substrate electrode Sub. The first end of the clamping diode 221 is coupled to the first gate electrode G1 of the first switching transistor 21, and the second end of the clamping diode 221 is coupled to the substrate electrode Sub through the second switching transistor SW2. The first end of the second resistor R2 in the pull-down circuit 23 is coupled to the substrate electrode Sub, and the second end of the second resistor R2 is coupled to the reference ground end GND.

Based on this, in a driving process of the charging protection circuit 20 shown in FIG. 8C, as shown in FIG. 8E, during normal wired charging, the first control signal received by the first gate electrode G1 and the second gate electrode G2 is a high-level turn-on signal, and the first gate electrode G1 controls the first switching transistor 21 to be turned on. A threshold voltage of the second switching transistor SW2 is the same as a threshold voltage of the first switching transistor 21, and the second switching transistor SW2 is also turned on under control of the second gate electrode G2. The first end of the clamping diode 221 receives a high-level turn-on signal, so that the clamping diode 221 is forwardly turned on. A clamping voltage of the clamping diode 221 makes a potential of the first control signal decreased after the first control signal passes through the clamping diode 221, and the potential of the substrate electrode Sub is adjusted to a threshold (for example, VG1 - Vdiode), to ensure that the turn-on characteristic of the first switching transistor 21 is not affected.

The threshold may be adjusted by adjusting the voltage drop Vdiode of the clamping diode 221 after turn-on of the clamping diode 221.

For example, a quantity of stages of the multi-stage series-connected clamping diodes 221 is adjusted, so that a voltage drop Vdiode of the multi-stage series-connected clamping diodes 221 changes from 0 to VG1 - VD1 when the diodes 221 are turned on. Therefore, the potential of the substrate electrode Sub changes from VD1 to VG1.

For example, when the first switching transistor 21 is turned on, VG1 = VD1 + 5 V, and the pull-up circuit 22 includes seven stages of PN diodes connected in series, and a turn-on voltage drop of a single PN diode is, for example, 0.7 V. Then, VSub = VG1 - Vdiode ≈ VD1. In other words, during normal charging, the potential of the substrate electrode Sub is adjusted to the potential of the first drain electrode D1, so that the turn-on impedance of the first switching transistor 21 is not affected. In addition, a gate voltage drop of the second switching transistor SW2 is approximately a gate voltage drop of the first switching transistor 21, so that reliability of the first gate electrode and the second gate electrode is not affected.

When a surge occurs in wired charging or during wireless charging, the first control signal received by the first gate electrode G1 and the second gate electrode G2 is a low-level turn-off signal, and the first gate electrode G1 controls the first switching transistor 21 to be turned off. A threshold voltage of the second switching transistor SW2 is the same as a threshold voltage of the first switching transistor 21, and the second switching transistor SW2 is also turned off under control of the second gate electrode G2. The second switching transistor SW2 is turned off, and a drive current of the clamping diode 221 is reduced, so that the clamping diode 221 is cut off. When the second switching transistor SW2 is turned off and the clamping diode 221 is cut off, the impedance of the second switching transistor SW2 + the impedance of the clamping diode 221 is much greater than the impedance of the second resistor R2. Therefore, after the first control signal (a low-level signal) that is received by the first gate electrode G1 and that controls turn-off of the first switching transistor 21 passes through the clamping diode 221 and the second switching transistor SW2, the potential of the substrate electrode Sub is adjusted to the potential of the fixed signal end (for example, a potential 0 of the reference ground end GND) by the voltage division action of the clamping diode 221, the second switching transistor SW2, and the second resistor R2. The second resistor R2 is coupled to the fixed signal end. When the first switching transistor 21 is turned off, the potential of the substrate electrode Sub is adjusted to the potential of the fixed signal end, to ensure that the breakdown voltage characteristic of the first switching transistor 21 is not affected.

With respect to the clamping diode 221, in some embodiments, as shown in FIG. 8F, the first end of the clamping diode 221 is a cathode and is coupled to the first gate electrode G1 of the first switching transistor 21, and the second end of the clamping diode 221 is an anode and is coupled to the substrate electrode Sub by using the second switching transistor SW2.

For example, the clamping diode 221 is a Zener diode (zener diode).

With respect to a quantity of clamping diodes 221, as shown in FIG. 8F, the pull-up circuit 22 includes one clamping diode 221.

Alternatively, as shown in FIG. 8G, the pull-up circuit 22 includes multiple clamping diodes connected in series.

The multiple clamping diodes 221 connected in series may be understood as: A cathode of the clamping diode 221 closest to the first gate electrode G1 is coupled to the first gate electrode G1, and an anode of the clamping diode 221 closest to the first gate electrode G1 is coupled to a cathode of a next clamping diode 221. By analogy, an anode of the clamping diode 221 is coupled to a cathode of another clamping diode 221. An anode of the clamping diode 221 closest to the second switching transistor SW2 is coupled to a first electrode of the second switching transistor SW2.

Based on this, in a driving process of the charging protection circuit 20 shown in FIG. 8F, as shown in FIG. 8E, during normal wired charging, the first control signal received by the first gate electrode G1 and the second gate electrode G2 is a high-level turn-on signal, and the first gate electrode G1 controls the first switching transistor 21 to be turned on. A threshold voltage of the second switching transistor SW2 is the same as a threshold voltage of the first switching transistor 21, and the second switching transistor SW2 is also turned on under control of the second gate electrode G2. The first end of the clamping diode 221 receives a high-level turn-on signal, so that the clamping diode 221 is reversely turned on. A reverse clamping voltage of the clamping diode 221 makes a potential of the first control signal decreased after the first control signal passes through the clamping diode 221, and the potential of the substrate electrode Sub is adjusted to a threshold (for example, VG1 - Vdiode), to ensure that the turn-on characteristic of the first switching transistor 21 is not affected.

By changing the structure of the Zener diode and adjusting a value of the reverse clamping voltage of the clamping diode 221, the threshold may be adjusted, so that the voltage drop Vdiode of the clamping diode 221 changes from 0 to VG1 to VD1 when the clamping diode 221 is reversely turned on. Therefore, the potential of the substrate electrode Sub changes from VD1 to VG1.

When a surge occurs in wired charging or during wireless charging, the first control signal received by the first gate electrode G1 and the second gate electrode G2 is a low-level turn-off signal, and the first gate electrode G1 controls the first switching transistor 21 to be turned off. A threshold voltage of the second switching transistor SW2 is the same as a threshold voltage of the first switching transistor 21, and the second switching transistor SW2 is also turned off under control of the second gate electrode G2. A drive current of the clamping diode 221 is reduced, so that the clamping diode 221 is in a cut-off state. When the second switching transistor SW2 is turned off, the impedance of the second switching transistor SW2 + the impedance of the clamping diode 221 is much greater than the impedance of the second resistor R2. Therefore, after the first control signal (a low-level signal) that is received by the first gate electrode G1 and that controls turn-off of the first switching transistor 21 passes through the clamping diode 221 and the second switching transistor SW2, the potential of the substrate electrode Sub is adjusted to a potential of the fixed signal end (for example, a potential 0 of the reference ground end GND) by the voltage division action of the clamping diode 221, the second switching transistor SW2, and the second resistor R2. The second resistor R2 is coupled to the fixed signal end. When the first switching transistor 21 is turned off, the potential of the substrate electrode Sub is adjusted to the potential of the fixed signal end, to ensure that the breakdown voltage characteristic of the first switching transistor 21 is not affected.

In the charging protection circuit 20 shown in FIG. 8A, the clamping diode 221 is used as a core component of the pull-up circuit 22, and the potential VSub of the substrate electrode Sub may be adjusted only by using the voltage VG1 of the first gate electrode of the first switching transistor 21 and the clamping voltage Vdiode of the clamping diode 221. Based on this, in the charging protection circuit 20 in this example, the pull-up circuit 22 is disposed between the first gate electrode G1 and the substrate electrode Sub, and the pull-down circuit 23 is disposed between the substrate electrode Sub and the fixed signal end. Therefore, when the first switching transistor 21 is turned on, the pull-up circuit 22 and the pull-down circuit 23 make a voltage bias between the first gate electrode G1 and the substrate electrode Sub be an expected potential, so that the potential of the substrate electrode Sub is adjusted to the threshold (for example, equal to or approximately equal to potentials of the first drain electrode D1 and the second drain electrode D2). This can avoid a phenomenon that the turn-on resistance is degraded due to negative back-gate effect caused by charge storage of the substrate electrode Sub. When the first switching transistor 21 is turned off, on one hand, the voltage of the first gate electrode G1 gradually decreases, and the potential of the substrate electrode Sub decreases with the potential of the first gate electrode G1. On the other hand, the pull-up circuit 22 enables the first gate electrode G1 to be approximately open-circuited to the substrate electrode Sub, and the pull-down circuit 23 enables the substrate electrode Sub to be approximately short-circuited to the fixed signal end, to adjust the potential of the substrate electrode Sub to be approximately equal to the potential of the reference ground end GND, so that the breakdown characteristic of the first switching transistor 21 is not affected at all.

### Example 2

A difference between Example 2 and Example 1 lies in that the pull-up circuit 22 does not include the second switching transistor SW2, so that a structure is relatively simplified. In this way, the pull-down circuit 23 is configured to: when the first switching transistor 21 is turned off, adjust the potential of the substrate electrode Sub to a potential between the potential of the first gate electrode G1 and the potential of the fixed signal end during turn-off of the first switching transistor 21, and no longer adjust the potential to the potential of the fixed signal end.

As shown in FIG. 9A, the charging protection circuit 20 includes a first switching transistor 21, a pull-up circuit 22, and a pull-down circuit 23.

A result of the first switching transistor 21 may be the same as a result of the first switching transistor 21 shown in Example 1. Refer to related descriptions of the first switching transistor 21 in Example 1, and details are not described herein again.

The pull-up circuit 22 is coupled to a first gate electrode G1 and a substrate electrode Sub, and is configured to: when the first switching transistor 21 is turned on, adjust a potential of the substrate electrode Sub to a threshold.

The pull-down circuit 23 is coupled to the substrate electrode Sub and a fixed signal end, and is configured to: when the first switching transistor 21 is turned off, adjust the potential of the substrate electrode Sub to a potential between the first gate electrode G1 (a potential during turn-off of the first switching transistor 21) and the fixed signal end.

Based on this, a driving process of the charging protection circuit 20 provided in this example includes the following steps.

During normal wired charging (an electronic device is charged), the first switching transistor 21 is turned on under control of a first control signal received by the first gate electrode G1, and a first drain electrode D1 transmits a received power supply voltage Vsy to a second drain electrode D2 for output. At the same time, the pull-up circuit 22 adjusts the potential of the substrate electrode Sub to the threshold.

During normal reverse charging (the electronic device charges an external device), the first switching transistor 21 is turned on under control of a first control signal received by the first gate electrode G1, and the second drain electrode D2 transmits a received discharge voltage to the first drain electrode D1 for output. At the same time, the pull-up circuit 22 adjusts the potential of the substrate electrode Sub to the threshold.

A principle of normal wired charging is the same as that of normal reverse charging. The following uses only normal wired charging as an example for description.

When a surge occurs in wired charging or during wireless charging, the first switching transistor 21 is turned off under control of a first control signal received by the first gate electrode G1, and the pull-down circuit 23 adjusts the potential of the substrate electrode Sub to the potential between the first gate electrode G1 and the fixed signal end.

In some embodiments, as shown in FIG. 9A, the pull-up circuit 22 includes a first resistor R1. A first end of the first resistor R1 is coupled to the first gate electrode G1, and a second end of the first resistor R1 is coupled to the substrate electrode Sub. In this case, the pull-up circuit 22 may also be referred to as a pull-up resistor.

The pull-down circuit 23 includes a second resistor R2. A first end of the second resistor R2 is coupled to the substrate electrode Sub, and a second end of the second resistor R2 is coupled to the fixed signal end (for example, a reference ground end GND). In this case, the pull-up circuit 23 may also be referred to as a pull-down resistor.

In other words, a difference between the charging protection circuit 20 shown in FIG. 9A and the charging protection circuit 20 shown in FIG. 7A lies in that in the charging protection circuit 20 shown in FIG. 9A, the pull-up circuit 22 includes the first resistor R1 but does not include the second switching transistor SW2.

In some embodiments, the first resistor R1 and/or the second resistor R2 are integrated onto a substrate of the first switching transistor 21.

Based on this, for example, during preparation of the charging protection circuit 20, a preparation method is the same as a preparation method procedure shown in FIG. 7C. As shown in FIG. 9B, the second switching transistor 22 does not need to be prepared synchronously with the first switching transistor 21.

For example, the method for preparing the charging protection circuit 20 has the same steps as the method for preparing the charging protection circuit shown in FIG. 7C. Differences lie in that a structure of the gate metal layer formed in step 7 is different, a structure of the source-drain metal layer formed in step 10 is different, and a structure of the wiring layer formed in step 13 is also different.

For example, the method for preparing the charging protection circuit 20 includes the following steps.

Step 1: Select a substrate.

Step 2: Form a nucleation layer on the substrate.

Step 3: Form a buffer layer on the nucleation layer.

Step 4: Form a channel layer on the buffer layer.

Step 5: Form a barrier layer on the channel layer.

Step 6: Form a p-type thin film on the barrier layer.

Step 7: Form a gate metal layer on the p-type thin film.

As shown in FIG. 9B, the gate metal layer includes the first gate electrode G1 of the first switching transistor 21.

Step 8: Etch the p-type thin film by using the gate metal layer as a mask to form a gate cap layer.

Step 9: Remove an epitaxial layer of some areas through deep trench etching.

Step 10: Form a source-drain metal layer.

As shown in FIG. 9B, the source-drain metal layer includes the first drain electrode D1, the second drain electrode D2, first-end metal and second-end metal of the first resistor R1, and first-end metal and second-end metal of the second resistor R2.

Step 11: Form an isolation area between devices.

Step 12: Form a passivation layer.

Step 13: Form a wiring layer.

As shown in FIG. 9B, the wiring layer includes a first wiring 1 that couples multiple lead-out points of the first drain electrode D1, a second wiring 2 that couples multiple lead-out points of the second drain electrode D2, a third wiring 3 that couples multiple lead-out points of the first gate electrode G1 and the first end of the first resistor R1, and a fourth wiring 4 that couples the second end of the first resistor R1 and the first end of the second resistor R2.

The charging protection circuit 20 prepared by using the foregoing method is shown in FIG. 9B. The first end of the first resistor R1 in the pull-up circuit 22 is coupled to the first gate electrode G1, and the second end of the first resistor R1 in the pull-up circuit 22 is coupled to the substrate electrode Sub. The first end of the second resistor R2 in the pull-down circuit 23 is coupled to the substrate electrode Sub, and the second end of the second resistor R2 in the pull-down circuit 23 is coupled to the reference ground end GND.

Based on this, in a driving process of the charging protection circuit 20 shown in FIG. 9A, as shown in FIG. 9C, during normal wired charging, the first control signal received by the first gate electrode G1 is a high-level turn-on signal, and the first switching transistor 21 is controlled to be turned on. After the first control signal (a high-level signal) that is received by the first gate electrode G1 and that controls the first switching transistor 21 to be turned on passes through the first resistor R1, the potential of the substrate electrode Sub is adjusted to the threshold by the voltage division action of the first resistor R1 and the second resistor R2, to ensure that a turn-on characteristic of the first switching transistor 21 is not affected.

When a surge occurs in wired charging or during wireless charging, the first control signal received by the first gate electrode G1 is a low-level turn-off signal, and the first switching transistor 21 is controlled to be turned off. After the first control signal (a low-level signal) that is received by the first gate electrode G1 and that controls the first switching transistor 21 to be turned off passes through the first resistor R1 and the second switching transistor SW2, the potential of the substrate electrode Sub is adjusted to the potential between the first gate electrode G1 and the fixed signal end by the voltage division action of the first resistor R1 and the second resistor R2.

When the first switching transistor 21 is turned off, as long as the potential of the substrate electrode Sub is less than the lower potential of the first drain electrode D1 and the second drain electrode D2, it may be ensured that a breakdown voltage characteristic of the first switching transistor 21 is not affected. Generally, when the first switching transistor 21 is turned off, the potential of the first gate electrode G1 is less than the lower potential of the first drain electrode D 1 and the second drain electrode D2, and both the potential of the first drain electrode D1 and the potential the second drain electrode D2 are greater than 0. Therefore, the potential of the substrate electrode Sub is adjusted to the potential between the first gate electrode G1 and the fixed signal end, so that it may be ensured that the potential of the substrate electrode Sub is less than the lower potential of the first drain electrode D1 and the second drain electrode D2, and a breakdown characteristic and the breakdown voltage characteristic of the first switching transistor 21 are not affected.

For example, when the first switching transistor 21 is turned off, potentials of all the first gate electrode G1, the first drain electrode D1, and the second drain electrode D2 are greater than 0, and the potential of the fixed signal end is less than or equal to 0. Because the potential of the first gate electrode G1 is less than the lower potential of the first drain electrode D1 and the second drain electrode D2, if the potential of the substrate electrode Sub is between the first gate electrode G1 and the fixed signal end, the potential of the substrate electrode Sub is definitely less than the lower potential of the first drain electrode D1 and the second drain electrode D2.

For example, the potential of the first gate electrode G1 is 2, and the potential of the fixed signal end is 0. The potential of the substrate electrode Sub is 0, which is less than the lower potential of the first drain electrode D1 and the second drain electrode D2.

Alternatively, for example, a potential of the first gate electrode G1 is less than or equal to 0, and a potential of the fixed signal end is less than or equal to 0. If the potential of the substrate electrode Sub is between the first gate electrode G1 and the fixed signal end, the potential of the substrate electrode Sub is definitely less than 0. Generally, both the potential of the first drain electrode D1 and the potential of the second drain electrode D2 are greater than 0. Therefore, the potential of the substrate electrode Sub is definitely less than the lower potential of the first drain electrode D1 and the second drain electrode D2.

For example, the potential of the first gate electrode G1 is -2, and the potential of the fixed signal end is 0. The potential of the substrate electrode Sub is -1, which is less than the lower potential of the first drain electrode D1 and the second drain electrode D2.

For example, the potential of the first gate electrode G1 is 0, and the potential of the fixed signal end is 0. The potential of the substrate electrode Sub is 0, which is approximately equal to the potential of the first gate electrode G1, and less than the lower potential of the first drain electrode D1 and the second drain electrode D2.

For principles of selecting resistance values of the first resistor R1 and the second resistor R2, refer to related descriptions in Example 1, and details are not described herein again.

In some other embodiments, as shown in FIG. 9D, the pull-up circuit 22 includes a clamping diode 221. A first end of the clamping diode 221 is coupled to the first gate electrode G1 of the first switching transistor 21, and a second end of the clamping diode 221 is coupled to the substrate electrode Sub.

The pull-down circuit 23 includes a second resistor R2. A first end of the second resistor R2 is coupled to the substrate electrode Sub, and a second end of the second resistor R2 is coupled to the fixed signal end (for example, a reference ground end GND).

For example, as shown in FIG. 9D, the clamping diode 21 is a PN diode, a Schottky barrier diode (schottky barrier diode, SBD), an equivalent diode formed by short-circuiting a source electrode and a gate electrode in a transistor, or the like. The first end of the clamping diode 221 is an anode, and the second end of the clamping diode 221 is a cathode. The anode of the clamping diode 221 is coupled to the first gate electrode G1, and the cathode of the clamping diode 221 is coupled to the substrate electrode Sub.

There may be one or more clamping diodes 21. Herein, only an example in which there are multiple clamping diodes 21 is used for illustration.

In other words, a structure difference between the charging protection circuit 20 shown in FIG. 9D and the charging protection circuit 20 shown in FIG. 8C lies in that the pull-up circuit 22 in the charging protection circuit 20 shown in FIG. 9D does not include the second switching transistor SW2.

Based on this, for example, during preparation of the charging protection circuit 20, a preparation method is the same as a preparation method procedure shown in FIG. 7C. As shown in FIG. 9E-1 and FIG. 9E-2, the second switching transistor 22 does not need to be prepared synchronously with the first switching transistor 21.

For example, the method for preparing the charging protection circuit 20 has the same steps as the method for preparing the charging protection circuit shown in FIG. 7C. Differences lie in that a structure of the gate metal layer formed in step 7 is different, a structure of the source-drain metal layer formed in step 10 is different, and a structure of the wiring layer formed in step 13 is also different.

For example, the method for preparing the charging protection circuit 20 includes the following steps.

Step 1: Select a substrate.

Step 2: Form a nucleation layer on the substrate.

Step 3: Form a buffer layer on the nucleation layer.

Step 4: Form a channel layer on the buffer layer.

Step 5: Form a barrier layer on the channel layer.

Step 6: Form a p-type thin film on the barrier layer.

Step 7: Form a gate metal layer on the p-type thin film.

As shown in FIG. 9E-1 and FIG. 9E-2, the gate metal layer includes a first gate electrode G1 of the first switching transistor 21 and a gate electrode G of a HEMTs device used as a diode.

Step 8: Etch the p-type thin film by using the gate metal layer as a mask to form a gate cap layer.

Step 9: Remove an epitaxial layer of some areas through deep trench etching.

Step 10: Form a source-drain metal layer.

As shown in FIG. 9E-1 and FIG. 9E-2, the source-drain metal layer includes the first drain electrode D1, the second drain electrode D2, a source electrode S and a drain electrode D of the HEMTs device used as the diode, and first-end metal and second-end metal of the second resistor R2.

Step 11: Form an isolation area between devices.

Step 12: Form a passivation layer.

Step 13: Form a wiring layer.

As shown in FIG. 9E-1 and FIG. 9E-2, the wiring layer includes a first wiring 1 that couples multiple lead-out points of the first drain electrode D1, a second wiring 2 that couples multiple lead-out points of the second drain electrode D2, a third wiring 3 that couples multiple lead-out points of the first gate electrode G1 and the gate electrode G (the anode of the clamping diode 221) of the HEMTs device used as the diode, and a fourth wiring 4 that couples the drain electrode D (the cathode of the clamping diode 221) of the HEMTs device used as the diode and the first end of the second resistor R2.

The charging protection circuit 20 prepared by using the foregoing method is shown in FIG. 9E-1 and FIG. 9E-2. The first end of the clamping diode 221 in the pull-up circuit 22 is coupled to the first gate electrode G1 of the first switching transistor 21, and the second end of the clamping diode 221 is coupled to the substrate electrode Sub. The first end of the second resistor R2 in the pull-down circuit 23 is coupled to the substrate electrode Sub, and the second end of the second resistor R2 is coupled to the reference ground end GND.

Based on this, in a driving process of the charging protection circuit 20 shown in FIG. 9D, as shown in FIG. 9C, during normal wired charging, the first control signal received by the first gate electrode G1 is a high-level turn-on signal, and the first gate electrode G1 controls the first switching transistor 21 to be turned on. The first end of the clamping diode 221 receives the high-level turn-on signal, so that the clamping diode 221 is forwardly turned on. A clamping voltage of the clamping diode 221 makes a potential of the first control signal decreased after the first control signal passes through the clamping diode 221, and the potential of the substrate electrode Sub is adjusted to a threshold, to ensure that a turn-on characteristic of the first switching transistor 21 is not affected.

When a surge occurs in wired charging or during wireless charging, the first control signal received by the first gate electrode G1 is a low-level turn-off signal, and the first gate electrode G1 controls the first switching transistor 21 to be turned off. The first end of the clamping diode 221 receives the low-level turn-off signal, so that the clamping diode 221 is cut off. The potential of the substrate electrode Sub is adjusted to the potential of the fixed signal end (for example, a potential 0 of the reference ground end GND) by the voltage division action of the clamping diode 221 and the second resistor R2. The second resistor R2 is coupled to the fixed signal end. When the first switching transistor 21 is turned off, the potential of the substrate electrode Sub is adjusted to the potential between the first gate electrode G1 and the fixed signal end, to ensure that a breakdown voltage characteristic of the first switching transistor 21 is not affected.

For example, as shown in FIG. 9F, the clamping diode 221 is a Zener diode. The first end of the clamping diode 221 is a cathode, and the second end of the clamping diode 221 is an anode. The cathode of the clamping diode 221 is coupled to the first gate electrode G1, and the anode of the clamping diode 221 is coupled to the substrate electrode Sub.

There may be one or more clamping diodes 21. Herein, only one clamping diode 21 is used as an example for illustration.

In other words, a structure difference between the charging protection circuit 20 shown in FIG. 9F and the charging protection circuit 20 shown in FIG. 8F lies in that the pull-up circuit 22 in the charging protection circuit 20 shown in FIG. 9F does not include the second switching transistor SW2.

Based on this, in a driving process of the charging protection circuit 20 shown in FIG. 9F, during normal wired charging, the first control signal received by the first gate electrode G1 is a high-level turn-on signal, and the first switching transistor 21 is controlled to be turned on. The first end of the clamping diode 221 receives the high-level turn-on signal, so that the clamping diode 221 is reversely turned on. A reverse clamping voltage of the clamping diode 221 makes a potential of the first control signal decreased after the first control signal passes through the clamping diode 221, and the potential of the substrate electrode Sub is adjusted to the threshold, to ensure that a turn-on characteristic of the first switching transistor 21 is not affected.

When a surge occurs in wired charging or during wireless charging, the first control signal received by the first gate electrode G1 is a low-level turn-off signal, and the first gate electrode G1 controls the first switching transistor 21 to be turned off. The first end of the clamping diode 221 receives the low-level turn-off signal, so that the clamping diode 221 is forwardly turned on. A forward clamping voltage of the clamping diode 221 makes a potential of the first control signal decreased after the first control signal passes through the clamping diode 221, and the potential of the substrate electrode Sub is adjusted to the potential between the first gate electrode G1 and the fixed signal end, to ensure that a breakdown voltage characteristic of the first switching transistor 21 is not affected.

Beneficial effects of this example are the same as those of Example 1, and details are not described herein again.

### Example 3

A structure of the charging protection circuit 20 in Example 3 is different from that in Example 1 and Example 2.

As shown in FIG. 10A, the charging protection circuit 20 includes a first switching transistor 21 and a bi-directional circuit 24.

The first switching transistor 21 includes a first drain electrode D1, a second drain electrode D2, a first gate electrode G1, and a substrate electrode Sub. The first drain electrode D1 is configured to receive a signal from the second drain electrode D2, the second drain electrode D2 is configured to receive a signal from the first drain electrode D1, and the first gate electrode G1 is configured to receive a first control signal, to control the first switching transistor 21 to be turned on or turned off.

A structure of the first switching transistor 21 may be the same as the structure of the first switching transistor 21 in Example 1. Refer to descriptions of the first switching transistor 21 in Example 1, and details are not described herein again.

The bi-directional circuit 24 is coupled to the first drain electrode D1, the second drain electrode D2, and the substrate electrode Sub, and is configured to: when the first switching transistor 21 is controlled to be turned on, adjust a potential of the substrate electrode Sub to a potential between the first drain electrode D1 and the second drain electrode D2; and when the first switching transistor 21 is turned off, adjust the potential of the substrate electrode Sub to be close to a lower potential of the first drain electrode D1 and the second drain electrode D2.

In other words, during normal wired charging (an electronic device is charged), the first switching transistor 21 is turned on under control of the first control signal received by the first gate electrode G1, and the first drain electrode D1 transmits a received power supply voltage Vsy to the second drain electrode D2 for output. In addition, the bi-directional circuit 24 adjusts the potential of the substrate electrode Sub to the potential between the first drain electrode D1 and the second drain electrode D2.

During normal reverse charging (the electronic device charges an external device), the first switching transistor 21 is turned on under control of the first control signal received by the first gate electrode G1, and the second drain electrode D2 transmits a received discharge voltage to the first drain electrode D1 for output. In addition, the bi-directional circuit 24 adjusts the potential of the substrate electrode Sub to the potential between the first drain electrode D1 and the second drain electrode D2.

A principle of normal wired charging is the same as that of normal reverse charging. The following uses only normal wired charging as an example for description.

When a surge occurs in wired charging or during wireless charging, the first switching transistor 21 is turned off under control of the first control signal received by the first gate electrode G1, and the bi-directional circuit 24 adjusts the potential of the substrate electrode Sub to a lower potential of the first drain electrode D1 and the second drain electrode D2.

With respect to a structure of the bi-directional circuit 24, in some embodiments, as shown in FIG. 10B, the bi-directional circuit includes a third switching transistor SW3 and a fourth switching transistor SW4.

A third gate electrode G3 of the third switching transistor SW3 is configured to control turn-on or turn-off of the third switching transistor SW3, a first electrode of the third switching transistor SW3 is coupled to the first drain electrode D1, and a second electrode of the third switching transistor SW3 is coupled to the substrate electrode Sub.

A fourth gate electrode G4 of the fourth switching transistor SW4 is configured to control turn-on or turn-off of the fourth switching transistor SW4, a first electrode of the fourth switching transistor SW4 is coupled to the second drain electrode D2, and a second electrode of the fourth switching transistor SW4 is coupled to the substrate electrode Sub.

It should be noted that the first switching transistor 21 is a bi-directional switching transistor, and includes the first drain electrode D1, the second drain electrode D2, the first gate electrode G1, and the substrate electrode Sub. The third switching transistor SW3 and the fourth switching transistor SW4 are conventional switching transistors. In other words, three ends are included: a source electrode, a drain electrode, and a gate electrode. Therefore, the first electrode and the second electrode of each of the third switching transistor SW3 and the fourth switching transistor SW4 are a source electrode and a drain electrode of each other. In this embodiment of this application, unless otherwise specified, the first electrode and the second electrode of the switching transistor are the source electrode and the drain electrode of the switching transistor. Specifically, whether the first electrode is a source electrode or a drain electrode is related to a type of the switching transistor.

For example, in Example 3, the first electrode of the third switching transistor SW3 is a drain electrode, and the second electrode of the third switching transistor SW3 is a source electrode. The first electrode of the fourth switching transistor SW4 is a drain electrode, and the second electrode of the fourth switching transistor SW4 is a source electrode.

The third switching transistor SW3 and the fourth switching transistor SW4 may be MOSFET devices or HEMTs devices. The third switching transistor SW3 and the fourth switching transistor SW4 may be integrated onto a same substrate, and the third switching transistor SW3 and the fourth switching transistor SW4 may alternatively be discrete structures.

In some embodiments, as shown in FIG. 10B, the third switching transistor SW3 and the fourth switching transistor SW4 are connected in series in a back-to-back manner and share a source electrode. Therefore, structures of the third switching transistor SW3 and the fourth switching transistor SW4 are simplified.

In some embodiments, as shown in FIG. 10C, for example, the drive circuit 10 in the charging circuit 140 may output a second control signal to the third gate electrode G3, and the third gate electrode G3 controls turn-on or turn-off of the third switching transistor SW3 based on a magnitude of the second control signal.

For example, the drive circuit 10 in the charging circuit 140 may output the second control signal to the fourth gate electrode G4, and the fourth gate electrode G4 controls turn-on or turn-off of the fourth switching transistor SW4 based on a magnitude of the second control signal.

The third switching transistor SW3 and the fourth switching transistor SW4 are controlled to be turned on or turned off based on the magnitude of the second control signal. It is generally considered that when the second control signal is higher than threshold voltages of the third switching transistor SW3 and the fourth switching transistor SW4, the third switching transistor SW3 and the fourth switching transistor SW4 are turned on. When the second control signal is lower than the threshold voltages of the third switching transistor SW3 and the fourth switching transistor SW4, the third switching transistor SW3 and the fourth switching transistor SW4 are turned off.

In some embodiments, as shown in FIG. 10D, both the third gate electrode G3 of the third switching transistor SW3 and the fourth gate electrode G4 of the fourth switching transistor SW4 are coupled to the first gate electrode G1 of the first switching transistor 21.

In other words, the first control signal and the second control signal are a same control signal, and the first switching transistor 21, the third switching transistor SW3, and the fourth switching transistor SW4 are simultaneously turned on and turned off.

In some embodiments, as shown in FIG. 10E, the first switching transistor 21, the third switching transistor SW3, and the fourth switching transistor SW4 each are a HEMTs device.

The first switching transistor 21 is selected as a bi-directional HEMTs device prepared by using GaN, Ga₂O₃, or GaAs. Compared with a bi-directional MOSFET device, a turn-on impedance of the bi-directional HEMTs device may theoretically be reduced by one order of magnitude with a same breakdown voltage. In an actual low-voltage application (30 V), the turn-on impedance may also be optimized by more than one time. If a 2 mm × 2 mm wafer level chip scale package (wafer level chip scale package, WLCSP) is used for packaging, the turn-on impedance of the HEMTs device may reach 5 ohms. In addition, the HEMTs device has no parasitic diode, has a simpler structure, and has no parasitic NPN-type triode structure. When the HEMTs device is turned off, a breakdown voltage characteristic may be met without pulling the potential of the substrate electrode Sub down to a potential of a reference ground end GND.

In some embodiments, the first switching transistor 21, the third switching transistor SW3, and the fourth switching transistor SW4 share a same substrate.

For example, a method for preparing the charging protection circuit 20 shown in FIG. 10E has the same steps as the method for preparing the charging protection circuit shown in FIG. 7C. Differences lie in that a structure of the gate metal layer formed in step 7 is different, a structure of the source-drain metal layer formed in step 10 is different, and a structure of the wiring layer formed in step 13 is also different.

For example, the method for preparing the charging protection circuit 20 includes the following steps.

Step 1: Select a substrate.

Step 2: Form a nucleation layer on the substrate.

Step 3: Form a buffer layer on the nucleation layer.

Step 4: Form a channel layer on the buffer layer.

Step 5: Form a barrier layer on the channel layer.

Step 6: Form a p-type thin film on the barrier layer.

Step 7: Form a gate metal layer on the p-type thin film.

As shown in FIG. 10E, the gate metal layer includes the first gate electrode G1 of the first switching transistor 21, the third gate electrode G3 of the third switching transistor SW3, and the fourth gate electrode G4 of the fourth switching transistor SW4.

Step 8: Etch the p-type thin film by using the gate metal layer as a mask to form a gate cap layer.

Step 9: Remove an epitaxial layer of some areas through deep trench etching.

Step 10: Form a source-drain metal layer.

As shown in FIG. 10E, the source-drain metal layer includes the first drain electrode D1, the second drain electrode D2, the first electrode and the second electrode of the third switching transistor SW3, and the first electrode and the second electrode of the fourth switching transistor SW4.

Step 11: Form an isolation area between devices.

Step 12: Form a passivation layer.

Step 13: Form a wiring layer.

As shown in FIG. 10E, the wiring layer includes a first wiring 1 that couples multiple lead-out points of the first drain electrode D1, a second wiring 2 that couples multiple lead-out points of the second drain electrode D2, and a third wiring 3 that couples multiple lead-out points of the first gate electrode G1, the third gate electrode G3, and the fourth gate electrode G4.

The charging protection circuit 20 prepared by using the foregoing method is shown in FIG. 10E. In the bi-directional circuit 24, the third gate electrode G3 of the third switching transistor SW3 is coupled to the first gate electrode G1 of the first switching transistor 21, the first electrode of the third switching transistor SW3 is coupled to the first drain electrode D1, and the second electrode of the third switching transistor SW3 is coupled to the substrate electrode Sub. The fourth gate electrode G4 of the fourth switching transistor SW4 is coupled to the first gate electrode G1 of the first switching transistor 21, the first electrode of the fourth switching transistor SW4 is coupled to the second drain electrode D2, and the second electrode of the fourth switching transistor SW4 is coupled to the substrate electrode Sub.

Based on this, in a driving process of the charging protection circuit 20 shown in FIG. 10D, as shown in FIG. 10F, during normal wired charging, the first control signal received by the first gate electrode G1 is a high-level turn-on signal, and the first switching transistor 21, the third switching transistor SW3, and the fourth switching transistor SW4 are controlled to be turned on. The potential of the substrate electrode Sub is adjusted to the potential between the first drain electrode D1 and the second drain electrode D2 by the voltage division action of the third switching transistor SW3 and the fourth switching transistor SW4, to ensure that a turn-on characteristic of the first switching transistor 21 is not affected.

It may be understood that, when the first switching transistor 21 is turned on, a resistance of the first switching transistor 21 may also be ignored. In this case, potentials of the first drain electrode D1 and the second drain electrode D2 are equal or approximately equal. In this case, the potential of the substrate electrode Sub is adjusted to the potential between the first drain electrode D1 and the second drain electrode D2, which may be understood that the potential of the substrate electrode Sub follows the potentials of the first drain electrode D1 and the second drain electrode D2.

When a surge occurs in wired charging, the first control signal received by the first gate electrode G1 is a low-level turn-off signal, and the first switching transistor 21, the third switching transistor SW3, and the fourth switching transistor SW4 are controlled to be turned off. In this case, the first drain electrode D1 is at a high potential due to existence of the surge, and the second drain electrode D2 is at a low potential compared with the first drain electrode D1. A voltage drop direction of the third switching transistor SW3 is from the first electrode to the second electrode (with a large voltage difference, a large leakage current, and a small turn-off impedance), and a voltage drop direction of the fourth switching transistor SW4 is from the second electrode to the first electrode (with a small voltage difference, a small leakage current, and a large turn-off impedance). Therefore, an impedance of the fourth switching transistor SW4 during turned-off is much greater than an impedance of the third switching transistor SW3 during turned-off. The potential of the substrate electrode Sub is approximately equal to the potential of the second drain electrode D2 by the voltage division action of the third switching transistor SW3 and the fourth switching transistor SW4, so that a breakdown characteristic and a breakdown voltage characteristic of the first switching transistor 21 are not affected.

During wireless charging, the first control signal received by the first gate electrode G1 is a low-level turn-off signal, and the first switching transistor 21, the third switching transistor SW3, and the fourth switching transistor SW4 are controlled to be turned off. As shown in FIG. 10C, in this case, the second drain electrode D2 is at a high potential because the power supply voltage Vsy of the wireless power supply end is received, and the first drain electrode D1 is at a low potential compared with the second drain electrode D2. A voltage drop direction of the third switching transistor SW3 is from the second electrode to the first electrode (with a small voltage difference, a small leakage current, and a large turn-off impedance), and a voltage drop direction of the fourth switching transistor SW4 is from the first electrode to the second electrode (with a large voltage difference, a large leakage current, and a small turn-off impedance). Therefore, an impedance of the third switching transistor SW3 during turned-off is much greater than an impedance of the fourth switching transistor SW4 during turned-off. The potential of the substrate electrode Sub is approximately equal to the potential of the first drain electrode D1 by the voltage division action of the third switching transistor SW3 and the fourth switching transistor SW4, so that a breakdown characteristic and a breakdown voltage characteristic of the first switching transistor 21 are not affected.

The charging protection circuit 20 provided in this example is verified by using a circuit simulation tool. A circuit diagram of a simulation circuit is shown in FIG. 10G. The power supply voltage Vsy is 20 V An output voltage Vot1 that is output by the charging protection circuit 20 to a load is raised to 20 V by using an energy-storage capacitor C1 when the first switching transistor 21 is turned on. In addition, a gate driving signal Vpulse is used to control turn-on and turn-off of the first switching transistor 21, the third switching transistor SW3, and the fourth switching transistor SW4.

FIG. 10H is a waveform of an output voltage Vot1 of the charging protection circuit 20 and a voltage VSub of the substrate electrode Sub when the gate driving signal Vpulse changes from 0 to 5 V When Vpulse = 5 V, a voltage of the first gate electrode G1 is at a high potential compared with a voltage of the second drain electrode D2, a voltage of the third gate electrode G3 is at a high potential compared with voltages of the first electrode and the second electrode of the third switching transistor SW3, and a voltage of the fourth gate electrode G4 is at a high potential compared with voltages of the first electrode and the second electrode of the fourth switching transistor SW4. The first switching transistor 21, the third switching transistor SW3, and the fourth switching transistor SW4 are turned on, and the energy-storage capacitor C1 is charged, so that the output voltage Vot1 = Vsy = 20 V In addition, the voltage VSub of the substrate electrode Sub follows the voltage of the first drain electrode D1, and the voltage of the substrate electrode Sub is close to 20 V, so that a turn-on characteristic of the first switching transistor 21 is not affected.

When Vpulse = 0 V, the voltage of the first gate electrode G1 is at a low potential compared with the voltage of the second drain electrode D2, the voltage of the third gate electrode G3 is at a low potential compared with the voltage of the second electrode of the third switching transistor SW3, and the voltage of the fourth gate electrode G4 is at a low potential compared with the voltage of the second electrode of the fourth switching transistor SW4. The first switching transistor 21, the third switching transistor SW3, and the fourth switching transistor SW4 are turned off. In this case, an auxiliary resistor Rload enables the energy-storage capacitor C1 to discharge, and the output voltage Vot1 gradually changes to 0 V In addition, the voltage VSub of the substrate electrode Sub is jointly controlled by the third switching transistor SW3 and the fourth switching transistor SW4, and is close to Vot1 = 0 V (VSub < 0.5 V). Therefore, when the first switching transistor 21 is turned off, VSub - VD2 is close to 0 V, so that breakdown voltage of the first switching transistor 21 is not affected.

Similarly, during wireless charging, when the first switching transistor 21 is turned off, VSub - VD1 is close to 0 V, so that breakdown voltage of the first switching transistor 21 is not affected.

Based on this, the charging protection circuit 20 provided in this example includes the bi-directional circuit 24. The bi-directional circuit includes a transistor such as a HEMTs device or a MOSFET device, and is configured to adjust the potential of the substrate electrode Sub. When the first switching transistor 21 is turned on, the potential of the substrate electrode Sub is adjusted to be approximately equal to the potential of the first drain electrode D1. This can avoid a phenomenon that a turn-on resistance is degraded due to back-gate effect caused by charge storage of the substrate electrode Sub. When the first switching transistor 21 is turned off, the potential of the substrate electrode Sub is adjusted to be approximately equal to the lower potential of the first drain electrode D1 and the second drain electrode D2, so that the breakdown characteristic of the first switching transistor 21 is not affected at all, and it is ensured that the breakdown voltage characteristic of the first switching transistor 21 is not affected.

In addition, the first switching transistor 21 in this example is a single-gate bi-directional conduction device, and has a small cell size. The single-gate bi-directional conduction device has a smaller characteristic resistance compared with a dual-gate bi-directional conduction device. In addition, the third switching transistor SW3 and the fourth switching transistor SW4 are used as pull-up and pull-down switches. When the first switching transistor 21 is turned on, resistances of the third switching transistor SW3 and the fourth switching transistor SW4 are relatively small, and the potential of the substrate electrode Sub can be quickly pulled up to a high potential. When the first switching transistor 21 is turned off, the resistances of the third switching transistor SW3 and the fourth switching transistor SW4 are equivalent to infinity, which has little impact on a turn-off leakage current, thereby resolving a problem of a turn-off leakage current when resistors are used as a pull-up circuit and a pull-down circuit.

### Example 4

A structure of the charging protection circuit 20 in Example 4 is different from those in Example 1, Example 2, and Example 3.

As shown in FIG. 11A, the charging protection circuit 20 includes a high electron mobility transistor HEMTs, a pull-up circuit 22, and a pull-down circuit 23.

The HEMTs includes a first drain electrode D1, a second drain electrode D2, a first gate electrode G1, and a substrate electrode Sub. The first drain electrode D1 is configured to receive a signal from the second drain electrode D2, the second drain electrode D2 is configured to receive a signal from the first drain electrode D1, and the first gate electrode G1 is configured to receive a first control signal, to control the HEMTs to be turned on or off.

A detailed structure of the HEMTs may be the same as a structure in which the first switching transistor 21 is a HEMTs device in Example 1. Refer to related descriptions in Example 1, and details are not described herein again.

A structure of the pull-up circuit 23 is shown in FIG. 11A. In some embodiments, the pull-up circuit 22 is configured to: when the HEMTs is turned on, adjust a potential of the substrate electrode Sub to be equal to or approximately equal to a potential of the second drain electrode D2.

For example, the pull-up circuit 22 includes a fifth switching transistor SW5. A fifth gate electrode G5 of the fifth switching transistor SW5 is configured to control turn-on or turn-off of the fifth switching transistor SW5, a first electrode of the fifth switching transistor SW5 is coupled to the second drain electrode D2, and a second electrode of the fifth switching transistor SW5 is coupled to the substrate electrode Sub.

When the HEMTs is turned on, a voltage drop of the HEMTs is relatively small, and a potential of the first drain electrode D1 is approximately equal to the potential of the second drain electrode D2. If the voltage drop of the HEMTs is ignored, the potential of the first drain electrode D1 is equal to the potential of the second drain electrode D2. When the fifth switching transistor SW5 is turned on, a voltage drop of the fifth switching transistor SW5 is relatively small, and the substrate electrode Sub is approximately equal to the potential of the second drain electrode D2, and is also approximately equal to the potential of the first drain electrode D1. If the voltage drop of the fifth switching transistor SW5 is ignored, the substrate electrode Sub is equal to the potential of the second drain electrode D2, and is also equal to the potential of the first drain electrode D1.

Therefore, that the potential is approximately equal to the potential of the second drain electrode D2 may be understood as: On the basis of the potential of the first drain electrode D1, potential fluctuation caused by a voltage drop of a device such as the HEMTs, the fifth switching transistor SW5, or a wiring is approximately equal to the potential of the second drain electrode D2.

For example, potentials in a range from (the potential of the first drain electrode D1 - the voltage drop of the HEMTs) to the potential of the first drain electrode D1 all belong to potentials approximately equal to the potential of the second drain electrode D2. When the HEMTs is turned on, as long as the potential of the substrate electrode Sub is greater than or equal to the potential of the first drain electrode D1 or the second drain electrode D2, it may be ensured that a turn-on characteristic of the HEMTs is not affected. Therefore, when the first control signal controls the HEMTs to be turned on, the pull-up circuit 22 adjusts the potential of the substrate electrode Sub to the potential of the second drain electrode D2, so that it may be ensured that the turn-on characteristic of the HEMTs is not affected.

A structure of the pull-up circuit 23 is shown in FIG. 11B. In some other embodiments, the pull-up circuit 22 includes a sixth switching transistor SW6.

A sixth gate electrode G6 of the sixth switching transistor SW6 is configured to control turn-on or turn-off of the sixth switching transistor SW6, a first electrode of the sixth switching transistor SW6 is coupled to the first drain electrode D1, and a second electrode of the sixth switching transistor SW6 is coupled to the substrate electrode Sub.

When the HEMTs is turned on, a voltage drop of the HEMTs is relatively small, and a potential of the first drain electrode D1 is approximately equal to a potential of the second drain electrode D2. If the voltage drop of the HEMTs is ignored, the potential of the first drain electrode D1 is equal to the potential of the second drain electrode D2. When the sixth switching transistor SW6 is turned on, a voltage drop of the sixth switching transistor SW6 is relatively small, and the substrate electrode Sub is approximately equal to the potential of the first drain electrode D1, and is also approximately equal to the potential of the second drain electrode D2. If the voltage drop of the sixth switching transistor SW6 is ignored, the substrate electrode Sub is equal to the potential of the first drain electrode D1, and is also equal to the potential of the second drain electrode D2.

A structure of the pull-up circuit 23 is shown in FIG. 11C. In some other embodiments, the pull-up circuit 22 includes a fifth switching transistor SW5 and a sixth switching transistor SW6.

A fifth gate electrode G5 of the fifth switching transistor SW5 is configured to control turn-on or turn-off of the fifth switching transistor SW5, a first electrode of the fifth switching transistor SW5 is coupled to the second drain electrode D2, and a second electrode of the fifth switching transistor SW5 is coupled to the substrate electrode Sub. A sixth gate electrode G6 of the sixth switching transistor SW6 is configured to control turn-on or turn-off of the sixth switching transistor SW6, a first electrode of the sixth switching transistor SW6 is coupled to the first drain electrode D1, and a second electrode of the sixth switching transistor SW6 is coupled to the substrate electrode Sub.

When the HEMTs is turned on, a voltage drop of the HEMTs is relatively small, and a potential of the first drain electrode D1 is approximately equal to a potential of the second drain electrode D2. If the voltage drop of the HEMTs is ignored, the potential of the first drain electrode D1 is equal to the potential of the second drain electrode D2. When the fifth switching transistor SW5 and the sixth switching transistor SW6 are turned on, voltage drops of the fifth switching transistor SW5 and the sixth switching transistor SW6 are relatively small, and the substrate electrode Sub is a potential between the potential of the first drain electrode D1 and the potential of the second drain electrode D2. If the voltage drops of the fifth switching transistor SW5 and the sixth switching transistor SW6 are ignored, the substrate electrode Sub is equal to the potential of the first drain electrode D1, and is also equal to the potential of the second drain electrode D2.

The pull-down circuit 23 is coupled to a fixed signal end and the substrate electrode Sub, and is configured to: when the HEMTs is turned off, pull down the potential of the substrate electrode Sub to a potential of the fixed signal end.

The pull-down circuit 23 adjusts the potential of the substrate electrode Sub to the potential of the fixed signal end, so as to adjust, when the first switching transistor 21 is turned off, the potential of the substrate electrode Sub to a potential that can ensure a breakdown voltage characteristic of the first switching transistor 21. Therefore, in this embodiment of this application, a potential of a signal transmitted by the fixed signal end is not limited, provided that the breakdown voltage characteristic of the first switching transistor 21 can be ensured.

In some embodiments, the potential of the fixed signal end is less than or equal to a lower potential of the first drain electrode D1 and the second drain electrode D2 during turn-off of the first switching transistor 21.

Alternatively, it is understood that the potential of the fixed signal end is less than or equal to the potential of the first drain electrode D1 during turn-off of the first switching transistor 21, and the potential of the fixed signal end is less than or equal to the potential of the second drain electrode D2 during turn-off of the first switching transistor 21. Alternatively, it may be understood that, when the first switching transistor 21 is turned off, both the potential of the first drain electrode D1 and the potential of the second drain electrode D2 are greater than the potential of the fixed signal end.

For example, the potential of the fixed signal end is less than or equal to 0. For example, the fixed signal end is a reference ground end (ground, GND). In other words, a potential of a signal transmitted by the fixed signal end is 0. Alternatively, a potential of a signal transmitted by the fixed signal end is a potential less than 0. In the following, an example in which the fixed signal end is the reference ground end GND is used for illustration.

In some embodiments, as shown in FIG. 11D, the first gate electrode G1 of the HEMTs is coupled to the fifth gate electrode G5 of the fifth switching transistor SW5 and the sixth gate electrode G6 of the sixth switching transistor SW6.

The fifth gate electrode G5 of the fifth switching transistor SW5 and the sixth gate electrode G6 of the sixth switching transistor SW6 may receive, for example, a third control signal output by a drive circuit 10. The fifth gate electrode G5 controls turn-on or turn-off of the fifth switching transistor SW5 based on a magnitude of the third control signal. The sixth gate electrode G6 controls turn-on or turn-off of the sixth switching transistor SW6 based on the magnitude of the third control signal. However, if the first gate electrode G1 of the HEMTs is coupled to the fifth gate electrode G5 of the fifth switching transistor SW5 and the sixth gate electrode G6 of the sixth switching transistor SW6, the first control signal and the third control signal may be a same control signal. The HEMTs, the fifth switching transistor SW5, and the sixth switching transistor SW6 may be controlled when the drive circuit 10 outputs the first control signal to the charging protection circuit 20, so that a requirement on the drive circuit 10 may be reduced.

In some embodiments, the HEMTs, the fifth switching transistor SW5, and the sixth switching transistor SW6 share a same substrate, to improve integration of the charging protection circuit 20.

For example, the fifth switching transistor SW5 and the sixth switching transistor SW6 are also HEMTs devices, and the HEMTs, the fifth switching transistor SW5, and the sixth switching transistor SW6 share a same substrate. Alternatively, the fifth switching transistor SW5 and the sixth switching transistor SW6 are MOSFET devices, and the fifth switching transistor SW5 and the sixth switching transistor SW6 may be directly formed on a substrate of the HEMTs device.

Certainly, the HEMTs, the fifth switching transistor SW5, and the sixth switching transistor SW6 may alternatively be discrete structures.

With respect to a structure of the pull-down circuit 23, in some embodiments, as shown in FIG. 12A, the pull-down circuit 23 includes a third resistor R3. The third resistor R3 is separately coupled to the substrate electrode Sub and the fixed signal end (for example, a reference ground end GND).

In some embodiments, a resistance value of the third resistor R3 is at a kS2 to MS2 level.

As shown in FIG. 12A, the pull-up circuit 22 may include a fifth switching transistor SW5. As shown in FIG. 12B, the pull-up circuit 22 may alternatively include a sixth switching transistor SW6. As shown in FIG. 12C, the pull-up circuit 22 may alternatively include a fifth switching transistor SW5 and a sixth switching transistor SW6.

The following describes a structure of the charging protection circuit 20 by using an example in which the pull-up circuit 22 includes the fifth switching transistor SW5 and the sixth switching transistor SW6, and the pull-down circuit 23 includes the third resistor R3.

For example, in Example 4, the first electrode of the fifth switching transistor SW5 is a drain electrode, and the second electrode of the fifth switching transistor SW5 is a source electrode. The first electrode of the sixth switching transistor SW6 is a drain electrode, and the second electrode of the sixth switching transistor SW6 is a source electrode.

As shown in FIG. 12D, in some embodiments, the HEMTs, the fifth switching transistor SW5, the sixth switching transistor SW6, and the third resistor R3 are an integrated structure.

For example, the fifth switching transistor SW5 and the sixth switching transistor SW6 are devices integrated with the HEMTs, and the third resistor R3 is an integrated resistor (for example, an AlGaN/GaN square resistance is about 300 Q/sq).

A method for preparing the charging protection circuit 20 shown in FIG. 12D has the same steps as the method for preparing the charging protection circuit shown in FIG. 7C in Example 1. Differences lie in that a structure of the gate metal layer formed in step 7 is different, a structure of the source-drain metal layer formed in step 10 is different, and a structure of the wiring layer formed in step 13 is also different.

For example, the method for preparing the charging protection circuit 20 includes the following steps.

Step 1: Select a substrate.

Step 2: Form a nucleation layer on the substrate.

Step 3: Form a buffer layer on the nucleation layer.

Step 4: Form a channel layer on the buffer layer.

Step 5: Form a barrier layer on the channel layer.

Step 6: Form a p-type thin film on the barrier layer.

Step 7: Form a gate metal layer on the p-type thin film.

As shown in FIG. 12D, the gate metal layer includes the first gate electrode G1 of the first switching transistor 21, the fifth gate electrode G5 of the fifth switching transistor SW5, and the sixth gate electrode G6 of the sixth switching transistor SW6.

Step 8: Etch the p-type thin film by using the gate metal layer as a mask to form a gate cap layer.

Step 9: Remove an epitaxial layer of some areas through deep trench etching.

Step 10: Form a source-drain metal layer.

As shown in FIG. 12D, the source-drain metal layer includes the first drain electrode D1, the second drain electrode D2, the first electrode and the second electrode of the fifth switching transistor SW5, the first electrode and the second electrode of the sixth switching transistor SW6, and two metal ends of the third resistor R3.

Step 11: Form an isolation area between devices.

Step 12: Form a passivation layer.

Step 13: Form a wiring layer.

As shown in FIG. 12D, the wiring layer includes a first wiring 1 that couples multiple lead-out points of the first drain electrode D1, a second wiring 2 that couples multiple lead-out points of the second drain electrode D2, a third wiring 3 that couples multiple lead-out points of the first gate electrode G1, the fifth gate electrode G5, and the sixth gate electrode G6, and a fourth wiring 4 that couples the substrate electrode Sub and the third resistor R3.

The charging protection circuit 20 prepared by using the foregoing method is shown in FIG. 12D. In the pull-up circuit 22, the fifth gate electrode G5 of the fifth switching transistor SW5 is coupled to the first gate electrode G1, the first electrode of the fifth switching transistor SW5 is coupled to the second drain electrode D2, and the second electrode of the fifth switching transistor SW5 is coupled to the substrate electrode Sub. The sixth gate electrode G6 of the sixth switching transistor SW6 is coupled to the first gate electrode G1, the first electrode of the sixth switching transistor SW6 is coupled to the first drain electrode D1, and the second electrode of the sixth switching transistor SW6 is coupled to the substrate electrode Sub. The third resistor R3 in the pull-down circuit 23 is separately coupled to the substrate electrode Sub and the fixed signal end (for example, the reference ground end GND).

Based on this, in a driving process of the charging protection circuit 20 shown in FIG. 12C, during normal wired charging, the first control signal received by the first gate electrode G1 is a high-level turn-on signal, and the HEMTs, the fifth switching transistor SW5, and the sixth switching transistor SW6 are controlled to be turned on. When the fifth switching transistor SW5 and the sixth switching transistor SW6 are turned on, turn-on impedances of the fifth switching transistor SW5 and the sixth switching transistor SW6 are much less than an impedance of R3. The potential of the substrate electrode Sub follows the potentials of the first drain electrode D1 and the second drain electrode D2, so that the turn-on characteristic of the HEMTs is not affected.

When a surge occurs in wired charging or during wireless charging, the first control signal received by the first gate electrode G1 is a low-level turn-off signal, and the HEMTs, the fifth switching transistor SW5, and the sixth switching transistor SW6 are controlled to be turned off. When the fifth switching transistor SW5 and the sixth switching transistor SW6 are turned off, turn-off impedances of the fifth switching transistor SW5 and the sixth switching transistor SW6 are much greater than an impedance of R3. The potential of the substrate electrode Sub is adjusted to the potential of the fixed signal end, so that a breakdown characteristic and the breakdown voltage characteristic of the HEMTs are not affected.

The charging protection circuit 20 provided in this example is verified by using a circuit simulation tool. A circuit diagram of a simulation circuit is shown in FIG. 12E. A power supply voltage Vsy is 20 V An output voltage Vot1 that is output by the charging protection circuit 20 to a load is raised to 20 V by using an energy-storage capacitor C1 when the HEMTs is turned on. In addition, a gate driving signal Vpulse is used to control turn-on and turn-off of the first switching transistor 21, the fifth switching transistor SW5, and the sixth switching transistor SW6.

FIG. 12F is a waveform of an output voltage Vot1 of the charging protection circuit 20 and a voltage VSub of the substrate electrode Sub when a gate driving signal Vpulse changes from 0 to 5 V When Vpulse = 5 V, a voltage of the first gate electrode G1 is at a high potential compared with a voltage of the second drain electrode D2, a voltage of the fifth gate electrode G5 is at a high potential compared with a voltage of the second electrode of the fifth switching transistor SW5, and a voltage of the sixth gate electrode G6 is at a high potential compared with a voltage of the second electrode of the sixth switching transistor SW6. The HEMTs, the fifth switching transistor SW5, and the sixth switching transistor SW6 are turned on, and the energy-storage capacitor C1 is charged, so that the output voltage Vot1 = Vsy = 20 V In addition, the voltage VSub of the substrate electrode Sub follows the voltage of the first drain electrode D1 and the voltage of the second drain electrode D2, and the voltage of the substrate electrode Sub is close to 20 V, so that a turn-on characteristic of the first switching transistor 21 is not affected.

When Vpulse = 0 V, the voltage of the first gate electrode G1 is at a low potential compared with the voltage of the second drain electrode D2, the voltage of the fifth gate electrode G5 is at a low potential compared with the voltage of the second electrode of the fifth switching transistor SW5, and the voltage of the sixth gate electrode G6 is at a low potential compared with the voltage of the second electrode of the sixth switching transistor SW6. The HEMTs, the fifth switching transistor SW5, and the sixth switching transistor SW6 are turned off. In this case, an auxiliary resistor Rload enables the energy-storage capacitor C1 to discharge, and the output voltage Vot1 gradually changes to 0 V In addition, the voltage VSub of the substrate electrode Sub is jointly controlled by the fifth switching transistor SW5 and the sixth switching transistor SW6, and is close to Vot1 = 0 V, so that when the HEMTs is turned off, VSub - VD2 is close to 0 V, and breakdown voltage of the HEMTs is not affected.

Similarly, during wireless charging, when the HEMTs is turned off, VSub - VD1 is close to 0 V, so that breakdown voltage of the HEMTs is not affected.

Based on this, in the charging protection circuit 20 in this example, when the HEMTs is turned on, the pull-down circuit 23 enables the substrate electrode Sub to be approximately open-circuited to the fixed signal end, and pull-up circuit 22 enables the first drain electrode D1 and/or the second drain electrode D2 to be approximately short-circuited to the substrate electrode Sub, to adjust the potential of the substrate electrode Sub to be equal to or approximately equal to the potential of the second drain electrode D2. This can avoid a phenomenon that a turn-on resistance is degraded due to back-gate effect caused by charge storage of the substrate electrode Sub. The pull-down circuit 23 is coupled to the reference ground end GND. When the HEMTs is turned off, the pull-up circuit 22 enables the first drain electrode D1 and/or the second drain electrode D2 to be approximately open-circuited to the substrate electrode Sub, and the pull-down circuit 23 enables the substrate electrode Sub to be approximately short-circuited to the fixed signal end, to adjust the potential of the substrate electrode Sub to be approximately equal to the potential of the reference ground end GND, so that it is ensured that the breakdown characteristic of the HEMTs is not affected at all.

In addition, a bi-directional HEMTs device prepared by using GaN, Ga₂O₃, or GaAs is used as a switching transistor. Compared with a bi-directional MOSFET device, a turn-on impedance of the bi-directional HEMTs device may theoretically be reduced by one order of magnitude with a same breakdown voltage. In an actual low-voltage application (30 V), the turn-on impedance may also be optimized by more than one time. If a 2 mm × 2 mm wafer level chip scale package (wafer level chip scale package, WLCSP) is used for packaging, the turn-on impedance of the HEMTs device may reach 5 ohms. In addition, the HEMTs device has no parasitic diode, has a simpler structure, and has no parasitic NPN-type triode structure. When the HEMTs device is turned off, the breakdown voltage characteristic may be met without pulling the potential of the substrate electrode Sub down to the potential of the reference ground end GND.

In addition, the pull-up circuit 22 and the pull-down circuit 23 may be integrated onto the HEMTs device, so that integration of the charging protection circuit 20 may be improved.

### Example 5

A difference between Example 5 and Example 4 lies in that a structure of the pull-down circuit 23 is different.

As shown in FIG. 13A, the charging protection circuit 20 includes a high electron mobility transistor HEMTs, a pull-up circuit 22, and a pull-down circuit 23.

A structure of the high electron mobility transistor HEMTs may be the same as that in Example 4. Refer to related descriptions in Example 4, and details are not described herein again.

As shown in FIG. 13A, the same as that in Example 4, the pull-up circuit 22 may include a fifth switching transistor SW5. As shown in FIG. 13B, the pull-up circuit 22 may alternatively include a sixth switching transistor SW6. As shown in FIG. 13C, the pull-up circuit 22 may alternatively include a fifth switching transistor SW5 and a sixth switching transistor SW6.

As shown in FIG. 13A to FIG. 13C, the pull-down circuit 23 includes a seventh switching transistor SW7. A seventh gate electrode G7 of the seventh switching transistor SW7 is configured to control turn-on or turn-off of the seventh switching transistor SW7, a first electrode of the seventh switching transistor SW7 is coupled to a substrate electrode VSub, and a second electrode of the seventh switching transistor SW7 is coupled to a fixed signal end.

The following describes a structure of the charging protection circuit 20 by using an example in which the pull-up circuit 22 includes the fifth switching transistor SW5 and the sixth switching transistor SW6, and the pull-down circuit 23 includes the seventh switching transistor SW7.

For example, in Example 5, a first electrode of the fifth switching transistor SW5 is a drain electrode, and a second electrode of the fifth switching transistor SW5 is a source electrode. A first electrode of the sixth switching transistor SW6 is a drain electrode, and a second electrode of the sixth switching transistor SW6 is a source electrode. The first electrode of the seventh switching transistor SW7 is a source electrode, and the second electrode of the seventh switching transistor SW7 is a drain electrode.

In some embodiments, as shown in FIG. 13D, the seventh gate electrode G7 of the seventh switching transistor SW7 receives a fourth control signal output by a drive circuit 10, and controls turn-on or turn-off of the seventh switching transistor SW7 based on a magnitude of the fourth control signal. A phase of the fourth control signal and a phase of a first control signal are a high level signal and a low level signal of each other.

For example, the drive circuit 10 further includes an inverter. After being adjusted by the inverter, a signal output by a PWM is output as a fourth control signal (with a phase opposite to that of the first control signal). The seventh gate electrode G7 of the seventh switching transistor SW7 is coupled to the inverter.

In some embodiments, the fifth switching transistor SW5, the sixth switching transistor SW6, and the seventh switching transistor SW7 may be MOSFET devices or HEMTs devices.

In some embodiments, the fifth switching transistor SW5, the sixth switching transistor SW6, the seventh switching transistor SW7, and the HEMTs are transistors of a same type (for example, are all N-type switching transistors).

In other words, if the fifth switching transistor SW5, the sixth switching transistor SW6, and the HEMTs are turned on, the seventh switching transistor SW7 is turned off. If the fifth switching transistor SW5, the sixth switching transistor SW6, and the HEMTs are turned off, the seventh switching transistor SW7 is turned on.

In some embodiments, the HEMTs, the fifth switching transistor SW5, the sixth switching transistor SW6, and the seventh switching transistor SW7 are discrete structures.

As shown in FIG. 13E, in some embodiments, the HEMTs, the fifth switching transistor SW5, the sixth switching transistor SW6, and the seventh switching transistor SW7 are an integrated structure.

For example, the fifth switching transistor SW5, the sixth switching transistor SW6, and the seventh switching transistor SW7 are devices integrated with the HEMTs.

A method for preparing the charging protection circuit 20 shown in FIG. 13E has the same steps as the method for preparing the charging protection circuit shown in FIG. 7C in Example 1. Differences lie in that a structure of the gate metal layer formed in step 7 is different, a structure of the source-drain metal layer formed in step 10 is different, and a structure of the wiring layer formed in step 13 is also different.

For example, the method for preparing the charging protection circuit 20 includes the following steps.

Step 1: Select a substrate.

Step 2: Form a nucleation layer on the substrate.

Step 3: Form a buffer layer on the nucleation layer.

Step 4: Form a channel layer on the buffer layer.

Step 5: Form a barrier layer on the channel layer.

Step 6: Form a p-type thin film on the barrier layer.

Step 7: Form a gate metal layer on the p-type thin film.

As shown in FIG. 13E, the gate metal layer includes a first gate electrode G1 of the first switching transistor 21, a fifth gate electrode G5 of the fifth switching transistor SW5, a sixth gate electrode G6 of the sixth switching transistor SW6, and the seventh gate electrode G7 of the seventh switching transistor SW7.

Step 8: Etch the p-type thin film by using the gate metal layer as a mask to form a gate cap layer.

Step 9: Remove an epitaxial layer of some areas through deep trench etching.

Step 10: Form a source-drain metal layer.

As shown in FIG. 13E, the source-drain metal layer includes a first drain electrode D1, a second drain electrode D2, the first electrode and the second electrode of the fifth switching transistor SW5, the first electrode and the second electrode of the sixth switching transistor SW6, and the first electrode and the second electrode of the seventh switching transistor SW7.

Step 11: Form an isolation area between devices.

Step 12: Form a passivation layer.

Step 13: Form a wiring layer.

As shown in FIG. 13E, the wiring layer includes a first wiring 1 that couples multiple lead-out points of the first drain electrode D1, a second wiring 2 that couples multiple lead-out points of the second drain electrode D2, a third wiring 3 that couples multiple lead-out points of the first gate electrode G1, the fifth gate electrode G5, and the sixth gate electrode G6, and a fourth wiring 4 that couples a substrate electrode Sub and the first electrode of the seventh switching transistor SW7.

The charging protection circuit 20 prepared by using the foregoing method is shown in FIG. 13E. In the pull-up circuit 22, the fifth gate electrode G5 of the fifth switching transistor SW5 is coupled to the first gate electrode G1, the first electrode of the fifth switching transistor SW5 is coupled to the second drain electrode D2, and the second electrode of the fifth switching transistor SW5 is coupled to the substrate electrode Sub. The sixth gate electrode G6 of the sixth switching transistor SW6 is coupled to the first gate electrode G1, the first electrode of the sixth switching transistor SW6 is coupled to the first drain electrode D1, and the second electrode of the sixth switching transistor SW6 is coupled to the substrate electrode Sub. In the pull-down circuit 23, the seventh gate electrode G7 of the seventh switching transistor SW7 is configured to receive the fourth control signal, the first electrode of the seventh switching transistor SW7 is coupled to the substrate electrode VSub, and the second electrode of the seventh switching transistor SW7 is coupled to the fixed signal end.

Based on this, in a driving process of the charging protection circuit 20 shown in FIG. 13C, as shown in FIG. 13F, during normal wired charging, the first control signal received by the first gate electrode G1 is a high-level turn-on signal, and the HEMTs, the fifth switching transistor SW5, and the sixth switching transistor SW6 are controlled to be turned on. The fourth control signal received by the seventh gate electrode G7 of the seventh switching transistor SW7 is a low-level turn-off signal, and the seventh switching transistor SW7 is controlled to be turned off. When the fifth switching transistor SW5 and the sixth switching transistor SW6 are turned on and the seventh switching transistor SW7 is turned off, turn-on impedances of the fifth switching transistor SW5 and the sixth switching transistor SW6 are much less than a turn-off impedance of the seventh switching transistor SW7. A potential of the substrate electrode Sub follows potentials of the first drain electrode D1 and the second drain electrode D2, so that a turn-on characteristic of the HEMTs is not affected.

When a surge occurs in wired charging or during wireless charging, the first control signal received by the first gate electrode G1 is a low-level turn-off signal, and the HEMTs, the fifth switching transistor SW5, and the sixth switching transistor SW6 are controlled to be turned off. The fourth control signal received by the seventh gate electrode G7 of the seventh switching transistor SW7 is a high-level turn-on signal, and the seventh switching transistor SW7 is controlled to be turned on. When the fifth switching transistor SW5 and the sixth switching transistor SW6 are turned off and the seventh switching transistor SW7 is turned on, turn-off impedances of the fifth switching transistor SW5 and the sixth switching transistor SW6 are much greater than a turn-on impedance of the seventh switching transistor SW7. The potential of the substrate electrode Sub is adjusted to be approximately a potential of the fixed signal end, so that a breakdown characteristic and a breakdown voltage characteristic of the HEMTs are not affected.

In this example, the pull-down circuit 23 in the charging protection circuit 20 includes the seventh switching transistor SW7. When the pull-up circuit 22 is turned on, the pull-down circuit 23 is cut off. A path from the first drain electrode D1 and the second drain electrode D2 of the HEMTs to the fixed voltage end is completely pinched off. A leakage current during turn-on of the HEMTs may be further reduced, and a loss from the substrate electrode Sub to the fixed voltage end during turn-on of the HEMTs is reduced.

### Example 6

A difference between Example 5 and Example 4 lies in that a structure of the pull-down circuit 23 is different, and a structure of the pull-up circuit 22 is not completely the same.

As shown in FIG. 14A, the charging protection circuit 20 includes a high electron mobility transistor HEMTs, a pull-up circuit 22, and a pull-down circuit 23.

A structure of the HEMTs may be the same as that in Example 4. Refer to related descriptions in Example 4, and details are not described herein again.

As shown in FIG. 13A, the pull-up circuit 22 includes a fifth switching transistor SW5. The pull-down circuit 23 includes an eighth switching transistor SW8.

A fifth gate electrode G5 of the fifth switching transistor SW5 is configured to control turn-on or turn-off of the fifth switching transistor SW5, a first electrode of the fifth switching transistor SW5 is coupled to a second drain electrode D2, and a second electrode of the fifth switching transistor SW5 is coupled to a substrate electrode Sub.

An eighth gate electrode G8 of the eighth switching transistor SW8 is configured to control turn-on or turn-off of the eighth switching transistor SW8. The eighth gate electrode G8 of the eighth switching transistor SW8 is coupled to the fifth gate electrode G5 of the fifth switching transistor SW5, a first electrode of the eighth switching transistor SW8 is coupled to the substrate electrode Sub, and a second electrode of the eighth switching transistor SW8 is coupled to a fixed signal end.

The eighth switching transistor SW8 and the fifth switching transistor SW5 are an N-type switching transistor and a P-type switching transistor of each other, and the eighth switching transistor SW8 and the HEMTs are switching transistors of a same type (for example, both are N-type switching transistors).

In FIG. 14A, only an example in which the eighth switching transistor SW8 and the HEMTs are N-type switching transistors, and the fifth switching transistor SW5 is a P-type switching transistor is used for illustration.

For example, in Example 6, the fifth switching transistor SW5 is a P-type switching transistor, the first electrode of the fifth switching transistor SW5 is a source electrode, and the second electrode of the fifth switching transistor SW5 is a drain electrode. The eighth switching transistor SW8 is an N-type switching transistor, the first electrode of the eighth switching transistor SW8 is a drain electrode, and the second electrode of the eighth switching transistor SW8 is a source electrode.

In some embodiments, as shown in FIG. 14B, the fifth gate electrode G5 of the fifth switching transistor SW5 and the eighth gate electrode G8 of the eighth switching transistor SW8 receive a third control signal output by a drive circuit 10, and control turn-on or turn-off of the fifth switching transistor SW5 and the eighth switching transistor SW8 based on a magnitude of the third control signal. A phase of the third control signal and a phase of a first control signal are a high level signal and a low level signal of each other.

In other words, if the eighth switching transistor SW8 and the HEMTs are turned on, the fifth switching transistor SW5 is turned off. If the eighth switching transistor SW8 and the HEMTs are turned off, the fifth switching transistor SW5 is turned on.

For example, the drive circuit 10 further includes an inverter. After being adjusted by the inverter, a signal output by a PWM is output as a third control signal (with a phase opposite to that of a first control signal). Both the fifth gate electrode G5 of the fifth switching transistor SW5 and the eighth gate electrode G8 of the eighth switching transistor SW8 are coupled to the inverter.

In some embodiments, the fifth switching transistor SW5 and the eighth switching transistor SW8 are MOSFET devices.

In some embodiments, the HEMTs, the fifth switching transistor SW5, and the eighth switching transistor SW8 are discrete structures.

In some embodiments, the HEMTs, the fifth switching transistor SW5, and the eighth switching transistor SW8 are an integrated structure.

For example, the fifth switching transistor SW5 and the eighth switching transistor SW8 are MOSFET devices formed on a substrate of the HEMTs.

Based on this, in a driving process of the charging protection circuit 20 shown in FIG. 14A, as shown in FIG. 14C, during normal wired charging, the first control signal received by a first gate electrode G1 is a high-level turn-on signal, and the HEMTs is controlled to be turned on. The fifth switching transistor SW5 is a P-type switching transistor. After the fifth gate electrode G5 receives a low-level third control signal with a phase opposite to that of the first control signal, the fifth switching transistor SW5 is turned on under control of the low-level signal. The eighth switching transistor SW8 is an N-type switching transistor. After the eighth gate electrode G8 receives the low-level third control signal with a phase opposite to that of the first control signal, the eighth switching transistor SW8 is turned off under control of the low-level third control signal. When the fifth switching transistor SW5 is turned on and the eighth switching transistor SW8 is turned off, a turn-on impedance of the fifth switching transistor SW5 is much less than a turn-off impedance of the eighth switching transistor SW8. A potential of the substrate electrode Sub follows potentials of a first drain electrode D 1 and a second drain electrode D2, so that a turn-on characteristic of the HEMTs is not affected.

When a surge occurs in wired charging or during wireless charging, the first control signal received by the first gate electrode G1 is a low-level turn-off signal, and the HEMTs is controlled to be turned off. After the fifth gate electrode G5 of the fifth switching transistor SW5 receives a high-level third control signal with a phase opposite to that of the first control signal, the fifth switching transistor SW5 is turned off under control of the high-level signal. After the eighth gate electrode G8 of the eighth switching transistor SW8 receives the high-level third control signal with a phase opposite to that of the first control signal, the eighth switching transistor SW8 is turned on under control of the high-level third control signal. When the fifth switching transistor SW5 is turned off and the eighth switching transistor SW8 is turned on, a turn-off impedance of the fifth switching transistor SW5 is much greater than a turn-on impedance of the eighth switching transistor SW8. A potential of the substrate electrode Sub is adjusted to be approximately a potential of the fixed signal end, so that a breakdown characteristic and a breakdown voltage characteristic of the HEMTs are not affected.

In this example, in the pull-up circuit 22 and the pull-down circuit 23 in the charging protection circuit 20, a MOSFET device may be used as a switching transistor to form a CMOS structure, and the pull-up circuit 22 and the pull-down circuit 23 are disposed separately from the HEMTs. During preparation of the HEMTs, isolation between the HEMTs and the fifth switching transistor SW5 and the eighth switching transistor SW8 does not need to be considered, so that a preparation process of the HEMTs may be simplified.

In addition, the pull-down circuit 23 in the charging protection circuit 20 is coupled to the fixed signal end, and when the pull-up circuit 22 is conducted, the pull-down circuit 23 is cut off. A path from the first drain electrode D1 and the second drain electrode D2 of the HEMTs to the fixed voltage end is completely pinched off. A leakage current during turn-on of the HEMTs may be further reduced, and a loss from the substrate electrode Sub to the fixed voltage end during turn-on of the HEMTs is reduced.

Based on this, embodiments of this application provide the foregoing multiple charging protection circuits 20. No matter which charging protection circuit 20 is used, the HEMTs is turned on during normal wired charging. The pull-up circuit 22 in the charging protection circuit 20 enables the potential of the substrate electrode Sub of the HEMTs to be close to potentials (a high potential) of the first drain electrode D1 and the second drain electrode D2, to avoid a decrease in a channel carrier concentration caused by back-gate effect and an increase in a HEMTs turn-on resistance, so that it is ensured that the turn-on characteristic of the HEMTs is not affected. When a surge occurs, the HEMTs is turned off, and the potential of the substrate electrode Sub of the HEMTs is pulled to the potential of the second drain electrode D2 or grounded (a low potential) by using the pull-down circuit 23 in the charging protection circuit 20. This avoids an insufficient breakdown voltage capability of the HEMTs caused by a forward bias between the substrate electrode Sub and the second drain electrode D2 (or understood as an insufficient breakdown voltage due to an excessively high potential of the substrate electrode Sub), and over-voltage protection is performed on the load such as a battery. During wireless charging, the HEMTs is turned off, and the potential of the substrate electrode Sub of the HEMTs is pulled to the potential of the first drain electrode D1 or grounded (a low potential) by using the pull-down circuit 23 in the charging protection circuit 20. This avoids an insufficient breakdown voltage capability of the HEMTs caused by a forward bias between the substrate electrode Sub and the first drain electrode D1, and prevents a wireless signal current from flowing back to a wired power supply end.

In other words, the charging protection circuit 20 provided in embodiments of this application dynamically manages the potential of the substrate electrode Sub of the HEMTs, so as to well avoid degradation of the impedance and the breakdown voltage of the HEMTs in a switching process of the HEMTs.

Based on this, an embodiment of this application further provides a chip. The chip includes the charging protection circuit 20.

To be specific, the chip provided in this embodiment of this application includes a transistor having a bi-directional switching function and components for implementing functions of the pull-up circuit and the pull-down circuit.

In some embodiments, the chip provided in this embodiment of this application may be understood as a bare chip (bare die) directly disposed in an electronic device.

For example, as shown in FIG. 7B-1 and FIG. 7B-2, FIG. 8D-1 and FIG. 8D-2, FIG. 9B, FIG. 9E-1 and FIG. 9E-2, FIG. 10E, FIG. 12D, and FIG. 13E, the pull-up circuit and the pull-down circuit in the charging protection circuit 20 are integrated with the HEMTs, or the bi-directional circuit and the HEMTs are integrated. The charging protection circuit 20 may be directly disposed in the electronic device as a bare die.

In some other embodiments, the chip provided in this embodiment of this application may be disposed in an electronic device after being packaged.

Based on this, an embodiment of this application further provides a package structure in which any one of the foregoing charging protection circuits 20 is packaged. The package structure includes the foregoing chip and a package housing, and the chip is packaged in the package housing.

A packaging technique used for the package structure is not limited in this embodiment of this application. For example, packaging may be completed by using a process such as a plastic packaging process or a WLCSP process.

It may be understood that a structure and a material of the package housing vary depending on different packaging techniques. This is not limited in this embodiment of this application.

For example, as shown in FIG. 15A, structures of multiple charging protection circuits 20 are shown above. No matter which charging protection circuit 20 is used, a WLCSP may be used to implement device miniaturization packaging. An insulation packaging layer covers a front surface (a surface on which a first drain electrode, a second drain electrode, and a first gate electrode are located) of the charging protection circuit 20 and a back surface (a substrate) of the charging protection circuit 20, to form the package housing of the package structure. The insulation packaging layer that covers the front surface of the charging protection circuit 20 exposes the first drain electrode, the second drain electrode, and the first gate electrode. Solder balls are provided at corresponding positions of the first drain electrode, the second drain electrode, and the first gate electrode, and the solder balls implement transfer with an external signal.

The insulation packaging layer that covers the back surface of the charging protection circuit 20 is sometimes referred to as a back coating.

A height of a WLCSP device is about 0.5 mm (the back coating is about 0.025 µm, a thickness of a semiconductor layer including structural features such as a switching transistor is about 0.3 mm, and a height of the solder balls is about 0.2 mm). A thickness of the WLCSP device is only half of a height of a plastic-packaged device. In addition, a heat dissipation effect of the WLCSP device is better than that of the plastic-packaged device of the same size. For example, a thermal resistance of a WLCSP device of 2 mm × 2 mm and 25 balls is about 30 °C/W, which is only half of a thermal resistance of a plastic-packaged device of the same size.

In addition, as shown in FIG. 15B, the pull-up circuit 22, the pull-down circuit 23, and the bi-directional circuit 24 are only used for a function application, and have very small circuit sizes. Therefore, the pull-up circuit 22, the pull-down circuit 23, and the bi-directional circuit 24 may be directly integrated in a 2 mm × 2 mm WLCSP, where the WLCSP may be compatible with pins of a conventional HEMTs device, and a structure is simple.

It should be noted that in some embodiments, the pull-up circuit 22 and the pull-down circuit 23 are integrated with the HEMTs device, or the bi-directional circuit 24 is integrated with the HEMTs device. The obtained charging protection circuit 20 forms an integrated chip, and may be directly applied after being packaged, or may be directly applied as a bare die.

In some other embodiments, as shown in FIG. 15C, the pull-up circuit 22 and/or the pull-down circuit 23 are/is disposed separately from the HEMTs device. The HEMTs device and circuits that are in the pull-up circuit 22 and the pull-down circuit 23 and that are integrated with the HEMTs device form a chip (which may be packaged or may not be packaged). Circuits that are in the pull-up circuit 22 and the pull-down circuit 23 and that are disposed separately from the HEMTs device are used as an external structure, which is further packaged with the chip, so that the package structure provided in this embodiment of this application is formed.

Certainly, the pull-up circuit 22 and/or the pull-down circuit 23 may alternatively not be packaged with the HEMTs device, and only the HEMTs device and a circuit integrated with the HEMTs device are packaged. Circuits that are in the pull-up circuit 22 and the pull-down circuit 23 and that are disposed separately from the HEMTs device are used as an external structure, which is disposed in an electronic device with the package structure.

In some other embodiments, the bi-directional circuit 24 is disposed separately from the HEMTs device, and the HEMTs device forms a chip (which may be packaged or may not be packaged). The bi-directional circuit 24 is used as an external structure, which is further packaged with the chip, so that the package structure provided in this embodiment of this application is formed.

Certainly, the bi-directional circuit 24 may alternatively not be packaged with the HEMTs device, and only the HEMTs device is packaged. The bi-directional circuit 24 is used as an external structure, and is disposed in an electronic device with the package structure. It should be noted that, FIG. 15B shows that multiple first drain electrodes D1 lead-out solder balls and multiple second drain electrodes D2 lead-out solder balls, which does not indicate that the WLCSP device includes multiple HEMTs, but indicates multiple lead-out points of the first drain electrode D1 and the second drain electrode D2 of the HEMTs, so as to simplify cabling and improve welding stability. The WLCSP device may alternatively include only one first drain electrode D1 lead-out solder ball and one second drain electrode D2 lead-out solder ball. This is not limited in this embodiment of this application.

Certainly, WLCSP packaging is merely an example, and is for limitation. The package structure provided in this embodiment of this application may alternatively be another type of package structure.

Because the charging protection circuit 20 provided in this embodiment of this application has relatively high integration, a volume of the package structure obtained after the charging protection circuit 20 is packaged is also relatively small.

After the foregoing package structure is applied to the electronic device provided in this embodiment of this application, the foregoing package structure may be disposed on a printed circuit board (printed circuit board, PCB), and is coupled to pins on the printed circuit board by using the solder balls. The drive circuit 10 may be disposed on the printed circuit board, and is coupled to the pins on the printed circuit board by using the solder balls, so as to implement signal interworking between the package structure and the drive circuit 10.

As shown in FIG. 16, after the package structure is applied to the electronic device, the package structure receives a power supply voltage at a wired power supply end and/or a wireless power supply end of the electronic device, and transmits, under control of a drive signal output by the drive circuit 10, the power supply voltage to a load coupled to the package structure. Alternatively, a signal of the load is transmitted to the wired power supply end or the wireless power supply end under control of the drive signal output by the drive circuit 10.

The foregoing description is merely a specific implementation of this application, but is not intended to limit the protection scope of this application. Any variation or replacement within the technical scope disclosed in this application shall fall within the protection scope of this application. Therefore, the protection scope of this application shall be subject to the protection scope of the claims.

## Claims

1. A charging protection circuit, comprising:
a first switching transistor, comprising a first drain electrode, a second drain electrode, a first gate electrode, and a substrate electrode, wherein the first drain electrode is configured to receive a signal from the second drain electrode, the second drain electrode is configured to receive a signal from the first drain electrode, and the first gate electrode is configured to control the first switching transistor to be turned on or turned off; and
a pull-up circuit, coupled to the first gate electrode and the substrate electrode, and configured to: when the first switching transistor is turned on, adjust a potential of the substrate electrode to a threshold, wherein the threshold is any potential between a half potential of the first drain electrode and a potential of the first gate electrode.

2. The charging protection circuit according to claim 1, wherein the charging protection circuit further comprises a pull-down circuit;
the pull-down circuit is coupled to the substrate electrode and a fixed signal end, and is configured to: when the first switching transistor is turned off, adjust the potential of the substrate electrode to a potential of the fixed signal end or a potential between the first gate electrode and the fixed signal end; and
the potential of the fixed signal end is less than or equal to a lower potential of the first drain electrode and the second drain electrode during turn-off of the first switching transistor.

3. The charging protection circuit according to claim 1 or 2, wherein the pull-up circuit comprises a first resistor; and
a first end of the first resistor is coupled to the first gate electrode, and a second end of the first resistor is coupled to the substrate electrode.

4. The charging protection circuit according to claim 1 or 2, wherein the pull-up circuit comprises a clamping diode; and
a first end of the clamping diode is coupled to the first gate electrode, and a second end of the clamping diode is coupled to the substrate electrode.

5. The charging protection circuit according to claim 4, wherein the first end of the clamping diode is an anode, and the second end of the clamping diode is a cathode; and
the clamping diode is a PN diode, a Schottky barrier diode, or an equivalent diode formed by short-circuiting a source electrode and a gate electrode in a transistor.

6. The charging protection circuit according to claim 4, wherein the first end of the clamping diode is a cathode, and the second end of the clamping diode is an anode; and
the clamping diode is a Zener diode.

7. The charging protection circuit according to claim 4, wherein the pull-up circuit comprises multiple clamping diodes connected in series.

8. The charging protection circuit according to any one of claims 1 to 7, wherein the pull-up circuit further comprises a second switching transistor; and
a second gate electrode of the second switching transistor is coupled to the first gate electrode, a first electrode of the second switching transistor is coupled to the second end of the first resistor or the second end of the clamping diode, and a second electrode of the second switching transistor is coupled to the substrate electrode.

9. The charging protection circuit according to any one of claims 2 to 7, wherein the pull-down circuit comprises a second resistor; and
a first end of the second resistor is coupled to the substrate electrode, and a second end of the second resistor is coupled to the fixed signal end.

10. The charging protection circuit according to claim 8, wherein the first switching transistor is a high electron mobility transistor or a metal oxide semiconductor transistor; and
the second switching transistor is a high electron mobility transistor or a metal oxide semiconductor transistor.

11. The charging protection circuit according to claim 8, wherein the first switching transistor and the second switching transistor share the same substrate electrode, and the first resistor is integrated onto the substrate electrode.

12. A method for driving a charging protection circuit, wherein the charging protection circuit comprises a first switching transistor and a pull-up circuit, the first switching transistor comprises a first drain electrode, a second drain electrode, a first gate electrode, and a substrate electrode, and the pull-up circuit is coupled to the first gate electrode and the substrate electrode; and
the method for driving the charging protection circuit comprises:
turning on the first switching transistor under control of the first gate electrode, and receiving, by the first drain electrode, a signal from the second drain electrode, or receiving, by the second drain electrode, a signal from the first drain electrode; and
after the first switching transistor is turned on, adjusting, by the pull-up circuit, a potential of the substrate electrode to a threshold, wherein the threshold is any potential between a half potential of the first drain electrode and a potential of the first gate electrode.

13. The method for driving the charging protection circuit according to claim 12, wherein the charging protection circuit further comprises a pull-down circuit, and the pull-down circuit is coupled to the substrate electrode and a fixed signal end; and
the method for driving the charging protection circuit further comprises:
turning off the first switching transistor under control of the first gate electrode, and after the first switching transistor is turned off, adjusting, by the pull-down circuit, the potential of the substrate electrode to a potential of the fixed signal end or a potential between the first gate electrode and the fixed signal end, wherein
the potential of the fixed signal end is less than or equal to a lower potential of the first drain electrode and the second drain electrode during turn-off of the first switching transistor.

14. A charging protection circuit, comprising:
a first switching transistor, comprising a first drain electrode, a second drain electrode, a first gate electrode, and a substrate electrode, wherein the first drain electrode is configured to receive a signal from the second drain electrode, the second drain electrode is configured to receive a signal from the first drain electrode, and the first gate electrode is configured to control the first switching transistor to be turned on or turned off; and
a bi-directional circuit, coupled to the first drain electrode, the second drain electrode, and the substrate electrode, and configured to: when the first switching transistor is turned on, adjust a potential of the substrate electrode to a potential between the first drain electrode and the second drain electrode; and when the first switching transistor is turned off, adjust the potential of the substrate electrode to a lower potential of the first drain electrode and the second drain electrode.

15. The charging protection circuit according to claim 14, wherein the bi-directional circuit comprises a third switching transistor and a fourth switching transistor;
a third gate electrode of the third switching transistor is configured to control turn-on or turn-off of the third switching transistor, a first electrode of the third switching transistor is coupled to the first drain electrode, and a second electrode of the third switching transistor is coupled to the substrate electrode; and
a fourth gate electrode of the fourth switching transistor is configured to control turn-on or turn-off of the fourth switching transistor, a first electrode of the fourth switching transistor is coupled to the second drain electrode, and a second electrode of the fourth switching transistor is coupled to the substrate electrode.

16. The charging protection circuit according to claim 15, wherein both the third gate electrode and the fourth gate electrode are coupled to the first gate electrode.

17. The charging protection circuit according to claim 15 or 16, wherein the first switching transistor, the third switching transistor, and the fourth switching transistor each are a high electron mobility transistor, and the first switching transistor, the third switching transistor, and the fourth switching transistor share a same substrate.

18. A method for driving a charging protection circuit, wherein the charging protection circuit comprises a first switching transistor and a bi-directional circuit, wherein the first switching transistor comprises a first drain electrode, a second drain electrode, a first gate electrode, and a substrate electrode, and the bi-directional circuit is coupled to the first drain electrode, the second drain electrode, and the substrate electrode; and
the method for driving the charging protection circuit comprises:
turning on the first switching transistor under control of the first gate electrode, and receiving, by the first drain electrode, a signal from the second drain electrode, or receiving, by the second drain electrode, a signal from the first drain electrode; and after the first switching transistor is turned on, adjusting, by the bi-directional circuit, a potential of the substrate electrode to a potential between the first drain electrode and the second drain electrode; and
turning off the first switching transistor under control of the first gate electrode, and after the first switching transistor is turned off, adjusting, by the bi-directional circuit, the potential of the substrate electrode to a lower potential of the first drain electrode and the second drain electrode.

19. A charging protection circuit, comprising:
a high electron mobility transistor, comprising a first drain electrode, a second drain electrode, a first gate electrode, and a substrate electrode, wherein the first drain electrode is configured to receive a signal from the second drain electrode, the second drain electrode is configured to receive a signal from the first drain electrode, and the first gate electrode is configured to control the high electron mobility transistor to be turned on or turned off;
a pull-up circuit, comprising a fifth switching transistor, wherein a fifth gate electrode of the fifth switching transistor is configured to control turn-on or turn-off of the fifth switching transistor, a first electrode of the fifth switching transistor is coupled to the second drain electrode, and a second electrode of the fifth switching transistor is coupled to the substrate electrode; and
a pull-down circuit, coupled to a fixed signal end and the substrate electrode, and configured to pull down a potential of the substrate electrode to a potential of the fixed signal end when the high electron mobility transistor is turned off, wherein the potential of the fixed signal end is less than or equal to a lower potential of the first drain electrode and the second drain electrode, wherein
the high electron mobility transistor and the fifth switching transistor share a same substrate.

20. The charging protection circuit according to claim 19, wherein the pull-up circuit further comprises a sixth switching transistor; and
both a sixth gate electrode of the sixth switching transistor and the fifth gate electrode of the fifth switching transistor are coupled to the first gate electrode, a first electrode of the sixth switching transistor is coupled to the first drain electrode, and a second electrode of the sixth switching transistor is coupled to the substrate electrode.

21. The charging protection circuit according to claim 19 or 20, wherein the pull-down circuit comprises a third resistor, and the third resistor is separately coupled to the substrate electrode and the fixed signal end.

22. The charging protection circuit according to claim 19 or 20, wherein the pull-down circuit comprises a seventh switching transistor; and
a seventh gate electrode of the seventh switching transistor is configured to control turn-on or turn-off of the seventh switching transistor, a first electrode of the seventh switching transistor is coupled to the substrate electrode, and a second electrode of the seventh switching transistor is coupled to the fixed signal end.

23. The charging protection circuit according to claim 19, wherein the pull-down circuit comprises an eighth switching transistor;
an eighth gate electrode of the eighth switching transistor is configured to control turn-on or turn-off of the eighth switching transistor, a first electrode of the eighth switching transistor is coupled to the substrate electrode, and a second electrode of the eighth switching transistor is coupled to the fixed signal end; and
the eighth switching transistor and the fifth switching transistor are an N-type switching transistor and a P-type switching transistor of each other.

24. A chip, comprising the charging protection circuit according to any one of claims 1 to 11, any one of claims 14 to 17, or any one of claims 19 to 23.

25. A package structure, comprising the chip according to claim 24 and a package housing, wherein the chip is packaged in the package housing.

26. An electronic device, comprising the package structure according to claim 25, a printed circuit board, and a load, wherein
the package structure is disposed on the printed circuit board and is coupled to the printed circuit board; and the package structure is further coupled to the load.
